# EUROPÄISCHE PATENTSCHRIFT

(11) **EP 2 627 729 B1**
(45) Veröffentlichungstag und Bekanntmachung des Hinweises auf die Patenterteilung: **24.10.2018**
(21) Anmeldenummer: 11761007.1
(22) Anmeldetag: 15.09.2011
(51) Int. Cl.: C09K 11/06, H05B 33/10

(54) **MATERIALIEN FÜR ORGANISCHE ELEKTROLUMINESZENZVORRICHTUNGEN**
MATERIALS FOR ORGANIC ELECTROLUMINESCENCE DEVICES
MATÉRIAUX POUR DISPOSITIFS ÉLECTROLUMINESCENTS ORGANIQUES

(30) Priorität: 14.10.2010 DE 102010048498
(43) Veröffentlichungstag der Anmeldung: 21.08.2013
(73) Patentinhaber: Merck Patent GmbH, 64293 Darmstadt (DE)
(72) Erfinder: LUDEMANN, Aurélie, 60322 Frankfurt am Main (DE); ANÉMIAN, Rémi, Manouk, Seoul 657-169 (KR); HEUN, Susanne, 65812 Bad Soden (DE); RAPP, Almut, 64289 Darmstadt (DE)
(86) Internationale Anmeldenummer: PCT/EP2011/004644
(87) Internationale Veröffentlichungsnummer: WO 2012/048778

(56) Entgegenhaltungen:
- WO-A1-2005/040302
- US-B2- 7 659 540
- Xiong Gong: "Electrophosphorescence from a polymer guest-host system with an iridium complex as guest: förster energy transfer and charge trapping", Adv. Funct. Mater. 13, No.6, 1. Januar 2003 (2003-01-01), Seiten 439-444, XP55012421, Gefunden im Internet: URL:http://onlinelibrary.wiley.com/store/1 0.1002/adfm.200304334/asset/439_ftp.pdf?v= 1&t=gv3rga3w&s=356d8a50003bf540ce6fda8966a e5509bf9860ea [gefunden am 2011-11-23]

## Beschreibung

Die vorliegende Erfindung betrifft eine Mischung umfassend
a) ein Polymer, das mindestens eine L=X Struktureinheit enthält,
b) eine Triplett-Emitter-Verbindung und
c) eine Carbazolverbindung.
Die Erfindung ist ferner auf organische Elektrolumineszenzvorrichtungen gerichtet, welche die erfindungsgemäße Mischung enthalten.

Der Aufbau organischer Elektrolumineszenzvorrichtungen (OLEDs), bei denen organische Halbleiter als funktionelle Materialien eingesetzt werden, ist beispielsweise in der US 4539507, der US 5151629, der EP 0676461 und der WO 98/27136 beschrieben. Eine Entwicklung im Bereich der organischen Elektrolumineszenzvorrichtungen sind phosphoreszierende OLEDs. Diese weisen aufgrund der höheren erreichbaren Effizienz im Vergleich zu fluoreszierenden OLEDs deutliche Vorteile auf.

Allerdings gibt es bei phosphoreszierenden OLEDs noch Verbesserungsbedarf. Dies gilt insbesondere für die Effizienz und die Lebensdauer der Vorrichtungen.

Gemäß dem Stand der Technik werden elektronenleitende Materialien, unter anderem Ketone (z.B. gemäß der WO 04/093207) oder Triazinderivate (z.B. gemäß der DE 102008036982) als Matrixmaterialien für phosphoreszierende Emitter verwendet. Insbesondere mit Ketonen werden niedrige Betriebsspannungen und lange Lebensdauern erzielt, was diese Verbindungsklasse zu einem sehr interessanten Matrixmaterial macht. Allerdings besteht bei Verwendung dieser Matrixmaterialien ebenso wie bei anderen Matrixmaterialien noch Verbesserungsbedarf, insbesondere in Bezug auf die Effizienz und die Lebensdauer der Vorrichtungen.

Aus dem Stand der Technik sind weiterhin organische Elektrolumineszenzvorrichtungen bekannt, welche einen phosphoreszierenden Emitter dotiert in eine Mischung aus zwei Matrixmaterialien enthalten.

In der US 2007/0252516 werden phosphoreszierende organische Elektrolumineszenzvorrichtungen offenbart, welche eine Mischung aus einem loch- und einem elektronenleitenden Matrixmaterial aufweisen. Für diese OLEDs wird eine verbesserte Effizienz offenbart. Ein Einfluss auf die Lebensdauer ist nicht erkennbar.

In der US 2007/0099026 werden weiß emittierende organische Elektrolumineszenzvorrichtungen offenbart, wobei die grün bzw. rot emittierende Schicht einen phosphoreszierenden Emitter und eine Mischung aus einem loch- und einem elektronenleitenden Matrixmaterial aufweist. Als lochleitende Materialien werden unter anderem Triarylamin- und Carbazolderivate offenbart. Als elektronenleitende Materialien werden unter anderem Aluminium- und Zinkverbindungen, Oxadiazolverbindungen und Triazin- bzw. Triazolverbindungen ofenbart. Auch für diese OLEDs sind noch weitere Verbesserungen wünschenswert.

Die WO 2008/086851 A1 offenbart Carbazolverbindungen sowie deren Verwendung in organischen Elektrolumineszenzvorrichtungen, insbesondere als Matrixmaterial in phosphoreszierenden Vorrichtungen, wobei ebenfalls Ketonverbindungen anwesend sein können.

X. Gong et al. offenbaren in dem Artikel "Electrophosphorescence from a Polymer Guest-Host System with an Iridium Complex as guest: förster energy transfer and charge trapping", in Adv. Funct. Mater. 2003, 13, No. 6 Zusammensetzungen enthaltend Polyvinylcarbazol, d.h. ein Polymer mit Carbazoleinheiten in der Seitenkette, eine Triplett-Emitterverbindung und eine Oxadiazolverbindung.

Die WO 2005/040302 A1 und die US 7,659,540 B2 offenbaren organische Halbleiter umfassend ein Polymer, Verbindungen mit L=X Struktureinheiten und Triplett-Emitterverbindungen. Die darin genannten Verbindungen weisen eine gute Löslichkeit auf und sind synthetisch gut zugänglich.

Trotzdem besteht weiterhin Verbesserungsbedarf hinsichtlich Löslichkeit für lösungsprozessierbare Systeme sowie hinsichtlich Lebensdauer und Effizienz.

Die der Erfindung zugrunde liegende technische Aufgabe war deshalb die Bereitstellung einer Mischung, welche sich einfach aus Lösung verarbeiten lässt und in einer organischen Elektrolumineszenzvorrichtung zu einer sehr hohen Lebensdauer und guten Effizienz führt.

Die Aufgabe wird erfindungsgemäß gelöst durch eine Mischung umfassend
a) ein Polymer, das mindestens eine L=X Struktureinheit enthält,
b) eine Triplett-Emitter-Verbindung und
c) eine Carbazolverbindung,
wobei die Triplett-Emitter-Verbindung eine Verbindung der Formel (22) ist, 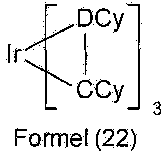 wobei für die verwendeten Symbole und Indices gilt:
- L: ist bei jedem Auftreten gleich oder verschieden C(R¹)₂, PR¹, AsR¹, SbR¹, BiR¹, P(R¹)₃, As(R¹)₃, Sb(R¹)₃, Bi(R¹)₃, S(R¹)₂, Se(R¹)₂, Te(R¹)₂, (R¹)₂S(=O), (R¹)₂Se(=O) oder (R¹)₂Te(=0);
- X: ist bei jedem Auftreten gleich oder verschieden O, S, Se oder NR²;
- R¹: ist bei jedem Auftreten gleich oder verschieden H, D, F, CN, N(R²)₂, eine geradkettige, verzweigte oder cyclische Alkyl-, Alkoxy- oder Thioalkoxygruppe mit 1 bis 40 C-Atomen, die mit R³ substituiert oder auch unsubstituiert sein kann, wobei eine oder mehrere nicht benachbarte CH₂-Gruppen durch -R⁴C=CR⁴-, -C=C-, Si(R⁴)₂, Ge(R⁴)₂, Sn(R⁴)₂, C=O, C=S, C=Se, C=NR⁴, -O-, -S-, -NR⁴ oder -CONR⁴- ersetzt sein können und wobei ein oder mehrere H-Atome durch F, Cl, Br, I, CN oder NO₂ ersetzt sein können, oder ein aromatisches oder heteroaromatisches Ringsystem mit 1 bis 60 C-Atomen, das mit einem oder mehreren Resten R³ substituiert sein kann, wobei zwei oder mehrere Substituenten R¹ auch zusammen mit den Atomen, an die sie gebunden sind, miteinander ein mono-oder polycyclisches, aliphatisches oder aromatisches Ringsystem bilden können; wobei mindestens eine Gruppe R¹ eine Bindung zu einer weiteren Struktureinheit des Polymers aufweist;
- R²: ist bei jedem Auftreten gleich oder verschieden eine geradkettige, verzweigte oder cyclische Alkyl- oder Alkoxygruppe mit 1 bis 22 C-Atomen, in der auch ein oder mehrere nicht benachbarte C-Atome durch -R⁴C=CR⁴-, -C≡C-, Si(R⁴)₂, Ge(R⁴)₂, Sn(R⁴)₂, -NR⁴-, -O-, -S-, -CO-O-, -O-CO-O- ersetzt sein können, wobei auch ein oder mehrere H-Atome durch Fluor ersetzt sein können, eine Aryl-, Heteroaryl oder Aryloxygruppe mit 1 bis 40 C-Atomen, welche auch durch einen oder mehrere Reste R³ substituiert sein kann, oder OH oder N(R³)₂;
- R³: ist bei jedem Auftreten gleich oder verschieden R⁴ oder CN, B(R⁴)₂ oder Si(R⁴)₃;
- R⁴: ist bei jedem Auftreten gleich oder verschieden H, D oder ein aliphatischer oder aromatischer Kohlenwasserstoffrest mit 1 bis 20 C-Atomen;
- DCy: ist gleich oder verschieden bei jedem Auftreten eine cyclische Gruppe, die mindestens ein Donoratom, vorzugsweise Stickstoff, Kohlenstoff in Form eines Carbens oder Phosphor, enthält, über welches die cyclische Gruppe an das Metall gebunden ist, und die wiederum einen oder mehrere Substituenten R³ tragen kann; die Gruppen DCy und CCy sind über eine kovalente Bindung miteinander verbunden; und
- CCy: ist gleich oder verschieden bei jedem Auftreten eine cyclische Gruppe, die ein Kohlenstoffatom enthält, über welches die cyclische Gruppe an das Metall gebunden ist und die wiederum einen oder mehrere Substituenten R¹ tragen kann.

In einer Ausführungsform der erfindungsgemäßen Mischung ist die Struktureinheit L=X des Polymers bevorzugt eine Struktureinheit der Formel (1) 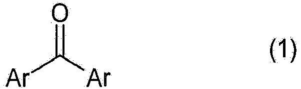 wobei für die verwendeten Symbole gilt:
- Ar: ist bei jedem Auftreten gleich oder verschieden ein aromatisches oder heteroaromatisches Ringsystem mit 5 bis 60 aromatischen Ringatomen, welches jeweils mit einer oder mehreren Gruppen R⁵ substituiert sein kann;
- R⁵: ist bei jedem Auftreten gleich oder verschieden H, D, F, Cl, Br, I, CHO, C(=O)Ar¹, P(=O)(Ar¹)₂, S(=O)Ar¹ S(=O)₂Ar¹, CR⁶=CR⁶Ar¹, CN, NO₂, Si(R⁶)₃, B(OR⁶)₂, B(R⁶)₂, B(N(R⁶)₂)₂, OSO₂R⁶, eine geradkettige Alkyl-, Alkoxy- oder Thioalkoxygruppe mit 1 bis 40 C-Atomen oder eine geradkettige Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R⁶ substituiert sein kann, wobei eine oder mehrere nicht benachbarte CH₂-Gruppen durch R⁶C=CR⁶, C≡C, Si(R⁶)₂, Ge(R⁶)₂, Sn(R⁶)₂, C=O, C=S, C=Se, C=NR⁶, P(=O)(R⁶), SO, SO₂, NR⁶, O, S oder CONR⁶ ersetzt sein können und wobei ein oder mehrere H-Atome durch F, Cl Br, I, CN oder NO₂ ersetzt sein können, oder ein aromatisches oder heteroaromatisches Ringsystem mit 5 bis 60 aromatischen Ringatomen, das jeweils durch einen oder mehrere Reste R⁶ substituiert sein kann, oder eine Aryloxy- oder Heteroaryloxygruppe mit 5 bis 60 aromatischen Ringatomen, die durch einen oder mehrere Reste R⁶ substituiert sein kann, oder eine Kombination dieser Systeme; dabei können zwei oder mehrere benachbarte Substituenten R⁵ auch miteinander ein mono- oder polycyclisches, aliphatisches oder aromatisches Ringsystem bilden;
- Ar¹: ist bei jedem Auftreten gleich oder verschieden ein aromatisches oder heteroaromatisches Ringsystem mit 5 bis 40 aromatischen Ringatomen, das mit einem oder mehreren Resten R⁵ substituiert sein kann; und
- R⁶: ist bei jedem Auftreten gleich oder verschieden H, D, CN oder ein aliphatischer, aromatischer oder heteroaromatischer Kohlenwasserstoffrest mit 1 bis 20 C-Atomen, in dem auch H-Atome durch F ersetzt sein können; dabei können zwei oder mehrere benachbarte Substituenten R⁶ auch miteinander ein mono- oder polycyclisches, aliphatisches oder aromatisches Ringsystem bilden;
wobei mindestens ein Rest R⁵ eine kovalente Bindung zu einer weiteren Struktureinheit des Polymers ist.

In der vorliegenden Erfindung sind unter dem Begriff "Polymer" sowohl polymere Verbindungen, oligomere Verbindungen, sowie Dendrimere zu verstehen. Die erfindungsgemäßen polymeren Verbindungen weisen vorzugsweise 10 bis 100000, besonders bevorzugt 20 bis 50000 und insbesondere 50 bis 20000 Wiederholungseinheiten (Struktureinheiten) auf. Die erfindungsgemäßen oligomeren Verbindungen weisen vorzugsweise 2 bis 9 Wiederholungseinheiten auf. Der Verzweigungs-Faktor der Polymere liegt dabei zwischen 0 (lineares Polymer, ohne Verzweigungsstellen) und 1 (vollständig verzweigtes Dendrimer). "Dendrimer" soll hier allgemein so verstanden werden, wie dies z.B. von M. Fischer und F. Vögtle (Angew. Chem., Int. Ed. 1999, 38, 885) beschrieben ist.

Die gewichtsmittlere Molekülmasse M_{w} des Polymers liegt vorzugsweise im Bereich von 10000 bis 2000000 g/mol, besonders bevorzugt im Bereich von 20000 bis 1000000 g/mol und insbesondere im Bereich von 50000 bis 500000 g/mol. Die Bestimmung von M_{w} erfolgt über Gelpermeationschromatographie mit Polystyrol als internen Standard.

Eine Arylgruppe im Sinne der vorliegenden Erfindung enthält 6 bis 60 C-Atome; eine Heteroarylgruppe im Sinne der vorliegenden Erfindung enthält 2 bis 60 C-Atome und mindestens ein Heteroatom, mit der Maßgabe, dass die Summe aus C-Atomen und Heteroatomen mindestens 5 ergibt. Die Heteroatome sind vorzugsweise ausgewählt aus N, O und/oder S. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte Aryl- oder Heteroarylgruppe, beispielsweise Naphthalin, Anthracen, Phenanthren, Chinolin, Isochinolin, etc., verstanden.

Ein aromatisches Ringsystem im Sinne der vorliegenden Erfindung enthält 6 bis 60 C-Atome im Ringsystem. Ein heteroaromatisches Ringsystem im Sinne der vorliegenden Erfindung enthält 2 bis 60 C-Atome und mindestens ein Heteroatom im Ringsystem, mit der Maßgabe, dass die Summe aus C-Atomen und Heteroatomen mindestens 5 ergibt. Die Heteroatome sind vorzugsweise ausgewählt aus N, O und/oder S. Unter einem aromatischen oder heteroaromatischen Ringsystem im Sinne der vorliegenden Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit (vorzugsweise weniger als 10 % der von H verschiedenen Atome), wie z.B. ein sp³-hybridisiertes C-, N- oder O-Atom, unterbrochen sein können. So sollen beispielsweise auch Systeme, wie 9,9'-Spirobifluoren, 9,9-Diarylfluoren, Triarylamin, Diarylether und Stilben, als aromatische Ringsysteme im Sinne der vorliegenden Erfindung verstanden werden, und ebenso Systeme, in denen zwei oder mehrere Arylgruppen beispielsweise durch eine lineare oder cyclische Alkylgruppe oder durch eine Silylgruppe unterbrochen sind. Das aromatische Ringsystem enthält vorzugsweise keine Metallatome.

Unter einem aromatischen oder heteroaromatischen Ringsystem mit 5 bis 60 aromatischen Ringatomen, welches noch jeweils mit den oben genannten Resten R substituiert sein kann und welches über beliebige Positionen am Aromaten bzw. Heteroaromaten verknüpft sein kann, werden insbesondere Gruppen verstanden, die abgeleitet sind von Benzol, Naphthalin, Anthracen, Phenanthren, Pyren, Chrysen, Perylen, Fluoranthen, Naphthacen, Pentacen, Benzpyren, Biphenyl, Biphenylen, Terphenyl, Terphenylen, Fluoren, Spirobifluoren, Dihydrophenanthren, Dihydropyren, Tetrahydropyren, cis- oder trans-Indenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Im Rahmen der vorliegenden Erfindung werden unter einer C₁- bis C₄₀-Alkylgruppe, in der auch einzelne H-Atome oder CH₂-Gruppen durch die oben genannten Gruppen substituiert sein können, vorzugsweise die Reste Methyl, Ethyl, n-Propyl, i-Propyl, n-Butyl, i-Butyl, s-Butyl, t-Butyl, 2-Methylbutyl, n-Pentyl, s-Pentyl, Cyclopentyl, n-Hexyl, Cyclohexyl, n-Heptyl, Cycloheptyl, n-Octyl, Cyclooctyl, 2-Ethylhexyl, Trifluormethyl, Pentafluorethyl, 2,2,2-Trifluorethyl, Ethenyl, Propenyl, Butenyl, Pentenyl, Cyclopentenyl, Hexenyl, Cyclohexenyl, Heptenyl, Cycloheptenyl, Octenyl, Cyclooctenyl, Ethinyl, Propinyl, Butinyl, Pentinyl, Hexinyl und Octinyl verstanden. Unter einer C₁- bis C₄₀-Alkoxygruppe werden vorzugsweise Methoxy, Trifluormethoxy, Ethoxy, n-Propoxy, i-Propoxy, n-Butoxy, i-Butoxy, s-Butoxy, t-Butoxy und 2-Methylbutoxy verstanden.

Geeignete Struktureinheiten gemäß Formel (1) sind insbesondere die in der WO 04/093207 und in der DE 102008033943 offenbarten Verbindungen. Diese sind via Zitat Bestandteil der vorliegenden Erfindung.

Aus der Definition der Struktureinheit gemäß Formel (1) geht hervor, dass diese nicht nur eine Carbonylgruppe enthalten muss, sondern auch mehrere dieser Gruppen enthalten kann.

Bevorzugt ist die Gruppe Ar in der Struktureinheit gemäß Formel (1) ein aromatisches Ringsystem mit 6 bis 40 aromatischen Ringatomen oder ein heteroaromatisches Ringsystem mit 2 bis 40 C-Atome und mindestens einem Heteroatom im Ringsystem, mit der Maßgabe, dass die Summe aus C-Atomen und Heteroatomen mindestens 5 ergibt. Wie oben definiert, muss das aromatische Ringsystem nicht notwendigerweise nur aromatische Gruppen aufweisen, sondern es können auch zwei Arylgruppen durch eine nicht-aromatische Gruppe, beispielsweise durch eine weitere Carbonylgruppe unterbrochen sein.

In einer weiteren bevorzugten Ausführungsform der Erfindung weist die Gruppe Ar der Struktureinheit der Formel (1) nicht mehr als zwei kondensierte Ringe auf. Sie ist also bevorzugt nur aus Phenyl- und/oder Naphthylgruppen, besonders bevorzugt nur aus Phenylgruppen, aufgebaut, enthält aber keine größeren kondensierten Aromaten, wie beispielsweise Anthracen.

Bevorzugte Gruppen Ar, die an die Carbonylgruppe der Struktureinheit der Formel (1) gebunden sind, sind Phenyl, 2-, 3- oder 4-Tolyl, 3- oder 4-o-Xylyl, 2- oder 4-m-Xylyl, 2-p-Xylyl, o-, m- oder p-tert-Butylphenyl, o-, m- oder p-Fluorphenyl, Benzophenon, 1-, 2- oder 3-Phenylmethanon, 2-, 3- oder 4-Biphenyl, 2-, 3- oder 4-o-Terphenyl, 2-, 3- oder 4-m-Terphenyl, 2-, 3- oder 4-p-Terphenyl, 2'-p-Terphenyl, 2'-, 4'- oder 5'-m-Terphenyl, 3'- oder 4'-o-Terphenyl, p-, m,p-, o,p-, m,m-, o,m- oder o,o-Quaterphenyl, Quinquephenyl, Sexiphenyl, 1-, 2-, 3- oder 4-Fluorenyl, 2-, 3- oder 4-Spiro-9,9'-bifluorenyl, 1-, 2-, 3- oder 4-(9,10-Dihydro)phenanthrenyl, 1- oder 2-Naphthyl, 2-, 3-, 4-, 5-, 6-, 7- oder 8-Chinolinyl, 1-, 3-, 4-, 5-, 6-, 7- oder 8-iso-Chinolinyl, 1- oder 2-(4-Methylnaphthyl), 1- oder 2-(4-Phenylnaphthyl), 1- oder 2-(4-naphthyl-naphthyl), 1-, 2- oder 3-(4-naphthyl-phenyl), 2-, 3- oder 4-Pyridyl, 2-, 4- oder 5-Pyrimidinyl, 2- oder 3-Pyrazinyl, 3- oder 4-Pyridanzinyl, 2-(1,3,5-Triazin)yl-, 2-, 3- oder 4-(Phenylpyridyl), 3-, 4-, 5- oder 6-(2,2'-Bipyridyl), 2-, 4-, 5- oder 6-(3,3'-Bipyridyl), 2- oder 3-(4,4'-Bipyridyl) und Kombinationen eines oder mehrerer dieser Reste.

Die Gruppen Ar können, wie oben beschrieben, durch einen oder mehrere Reste R⁵ substituiert sein. Diese Reste R⁵ der Struktureinheit der Formel (1) sind bevorzugt gleich oder verschieden bei jedem Auftreten ausgewählt aus der Gruppe bestehend aus H, F, C(=O)Ar¹, P(=O)(Ar¹)₂, S(=O)Ar¹, S(=O)₂Ar¹, einer geradkettigen Alkylgruppe mit 1 bis 4 C-Atomen oder einer verzweigten oder cyclischen Alkylgruppe mit 3 bis 5 C-Atomen, die jeweils mit einem oder mehreren Resten R⁶ substituiert sein kann, wobei ein oder mehrere H-Atome durch F ersetzt sein können, oder einem aromatischen Ringsystem mit 6 bis 24 aromatischen Ringatomen, das durch einen oder mehrere Reste R⁶ substituiert sein kann, oder eine Kombination dieser Systeme; dabei können zwei oder mehrere benachbarte Substituenten R⁵ auch miteinander ein mono- oder polycyclisches, aliphatisches oder aromatisches Ringsystem bilden.

Insbesondere zur Erzeugung von Schichten aus Lösung sind auch geradkettige, verzweigte oder cyclische Alkylgruppen mit bis zu 10 C-Atomen als Substituenten R⁵ bevorzugt. Die Reste R⁵ sind besonders bevorzugt gleich oder verschieden bei jedem Auftreten ausgewählt aus der Gruppe bestehend aus H, C(=O)Ar¹ oder einem aromatischen Ringsystem mit 6 bis 24 aromatischen Ringatomen, das durch einen oder mehrere Reste R⁶ substituiert sein kann, bevorzugt aber unsubstituiert ist.

In nochmals einer bevorzugten Ausführungsform der vorliegenden Erfindung ist die Gruppe Ar der Struktureinheit der Formel (1) gleich oder verschieden bei jedem Auftreten ein aromatisches Ringsystem mit 6 bis 24 aromatischen Ringatomen, das mit einem oder mehreren Resten R⁵ substituiert sein kann. Besonders bevorzugt ist Ar¹ gleich oder verschieden bei jedem Auftreten ein aromatisches Ringsystem mit 6 bis 12 aromatischen Ringatomen.

Besonders bevorzugt sind Benzophenon-Derivate, die jeweils an den 3,5,3',5'-Positionen durch ein aromatisches oder heteroaromatisches Ringsystem mit 5 bis 30 aromatischen Ringatomen substituiert sind, welche wiederum durch einen oder mehrere Reste R⁵ gemäß der obigen Definition substituiert sein kann. Weiterhin bevorzugt sind Ketone, welche mit mindestens einer Spirobifluorengruppe und/oder Fluorengruppe substituiert sind.

Bevorzugte aromatische Keton-Struktureinheiten der Formel (1) sind daher die Verbindungen der folgenden Formeln (2) bis (5): 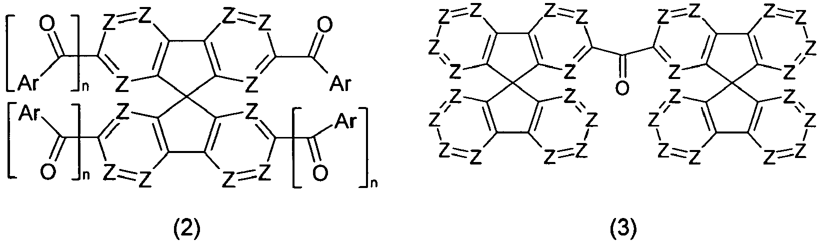 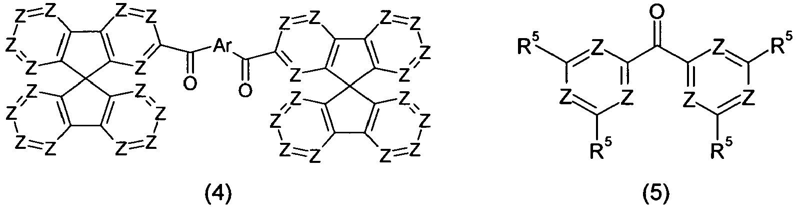 wobei Ar und R⁵ dieselbe Bedeutung haben, wie oben in Bezug auf die Struktureinheit der Formel (1) beschrieben, und weiterhin gilt:
Z ist gleich oder verschieden bei jedem Auftreten CR⁵ oder N; und
n ist gleich oder verschieden bei jedem Auftreten 0 oder 1.

Bevorzugt steht Ar in der oben genannten Formel (2) und (4) für ein aromatisches oder heteroaromatisches Ringsystem mit 1 bis 30 aromatischen Ringatomen, welches mit einem oder mehreren Resten R⁵ substituiert sein kann. Besonders bevorzugt sind die oben genannten Gruppen Ar.

Beispiele für geeignete Struktureinheiten gemäß Formel (1) sind die im Folgenden abgebildeten Strukturen (1-1) bis (1-63), wobei mindestens ein H-Atom, vorzugsweise zwei H-Atome, eine Bindung zu einer weiteren, gleichen oder unterschiedlichen Struktureinheit bedeutet.

| | |
|---|---|
| 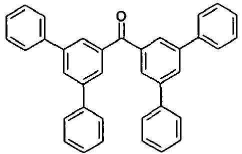 | 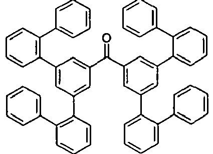 |
| (1-1) | (1-2) |
| 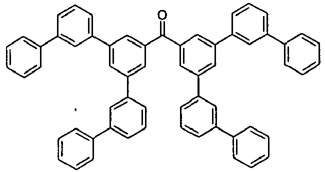 | 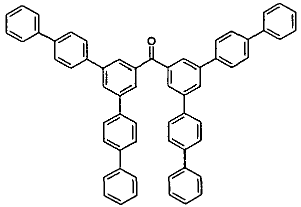 |
| (1-3) | (1-4) |
| 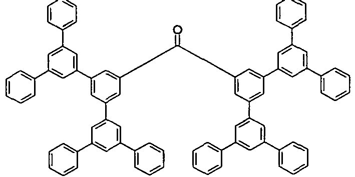 | 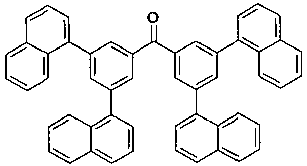 |
| (1-5) | (1-6) |
| 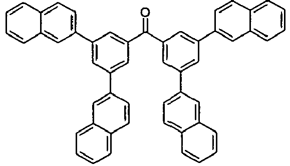 | 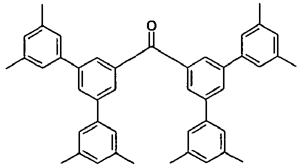 |
| (1-7) | (1-8) |
| 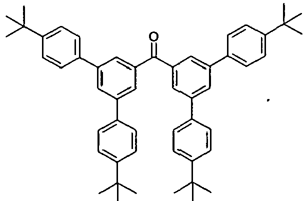 | 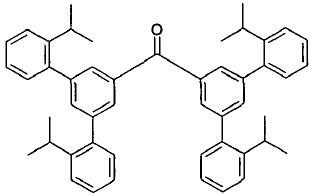 |
| (1-9) | (1-10) |
| 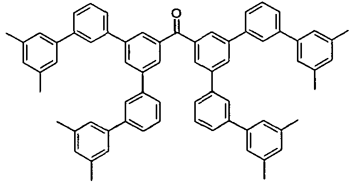 | 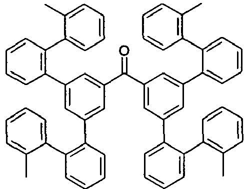 |
| (1-11) | (1-12) |
| 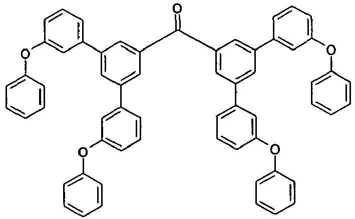 | 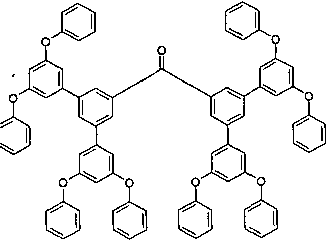 |
| (1-13) | (1-14) |
| 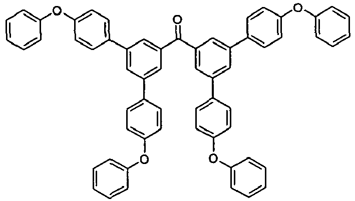 | 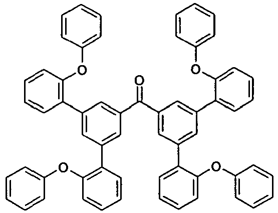 |
| (1-15) | (1-16) |
| 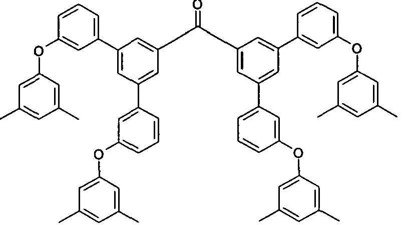 | 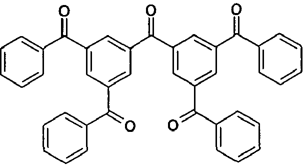 |
| (1-17) | (1-18) |
| 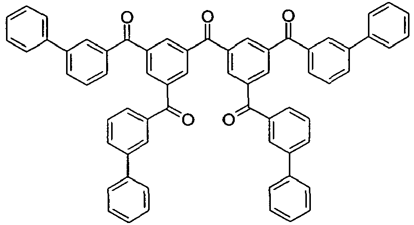 | 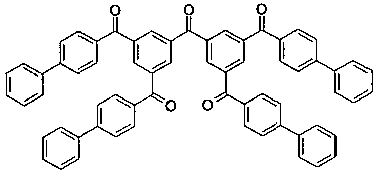 |
| (1-19) | (1-20) |
| 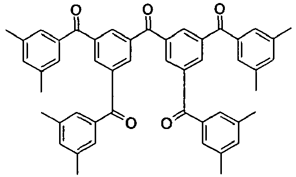 | 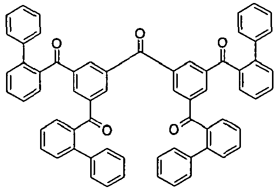 |
| (1-21) | (1-22) |
| 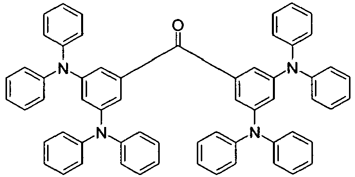 | 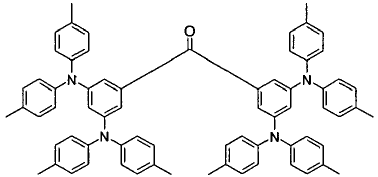 |
| (1-23) | (1-24) |
| 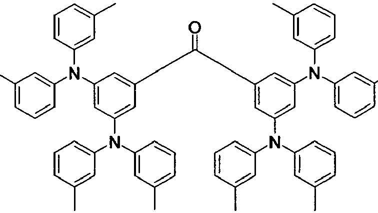 | 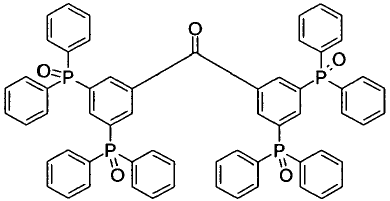 |
| (1-25) | (1-26) |
| 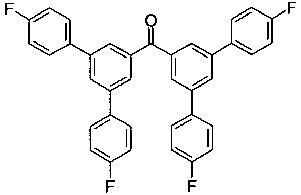 | 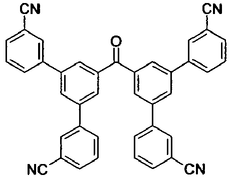 |
| (1-27) | (1-28) |
| 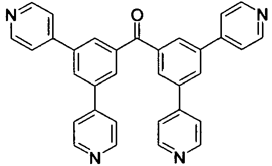 | 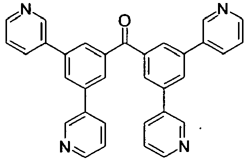 |
| (1-29) | (1-30) |
| 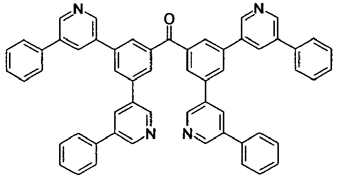 | 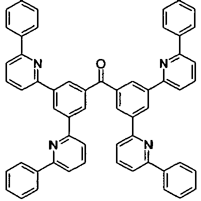 |
| (1-31) | (1-32) |
| 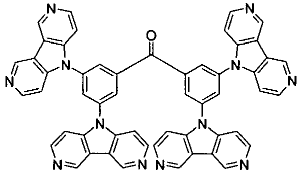 | 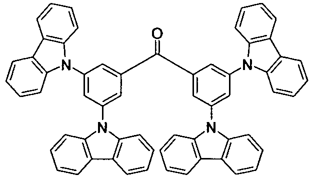 |
| (1-33) | (1-34) |
| 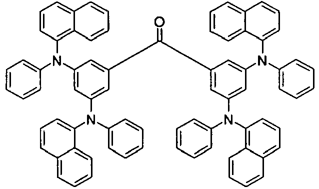 | 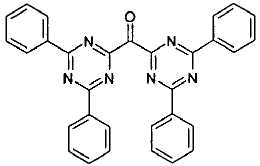 |
| (1-35) | (1-36) |
| 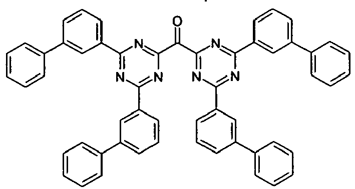 | 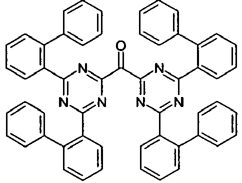 |
| 1-37 | 1-38 |
| 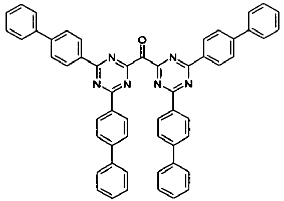 | 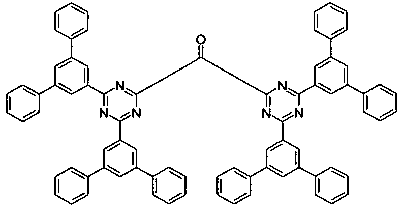 |
| (1-39) | (1-40) |
| 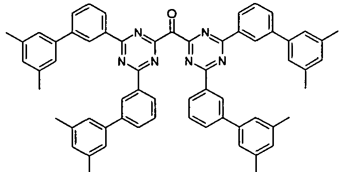 | 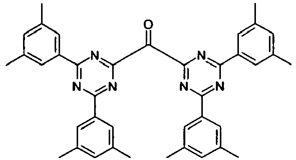 |
| (1-41) | (1-42) |
| 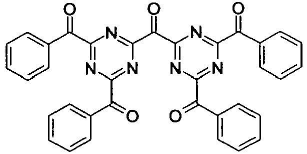 | 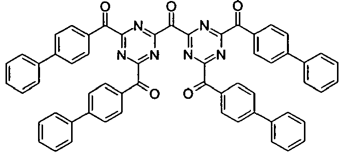 |
| (1-43) | (1-44) |
| 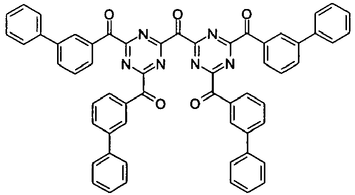 | 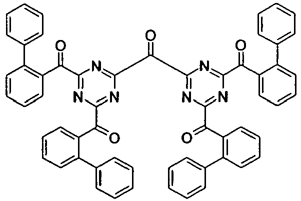 |
| (1-45) | (1-46) |
| 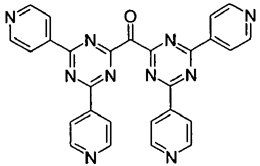 | 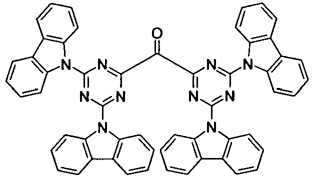 |
| (1-47) | (1-48) |
| 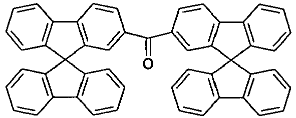 | 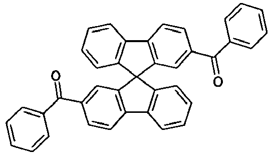 |
| 1-49 | (1-50) |
| 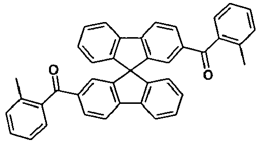 | 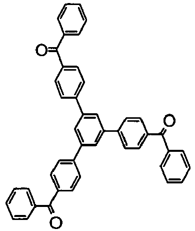 |
| (1-51) | (1-52) |
| 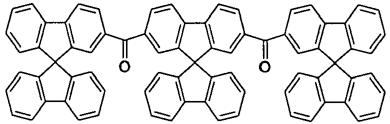 | 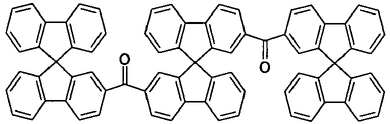 |
| (1-53) | (1-54) |
| 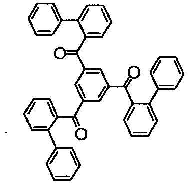 | 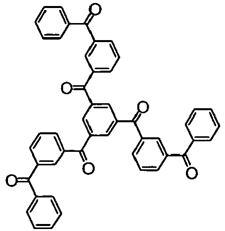 |
| (1-55) | (1-56) |
| 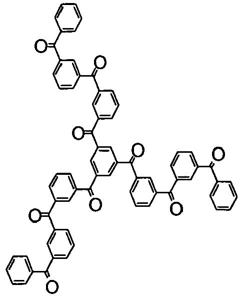 | 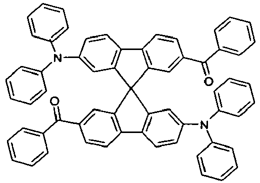 |
| (1-57) | (1-58 |
| 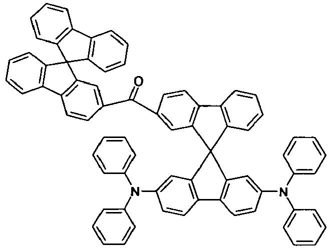 | 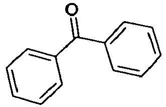 |
| (1-59) | (1-60) |
| 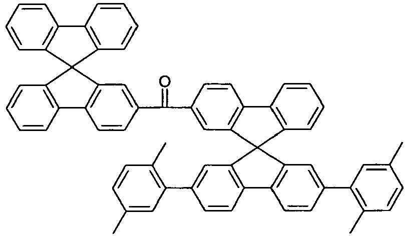 | 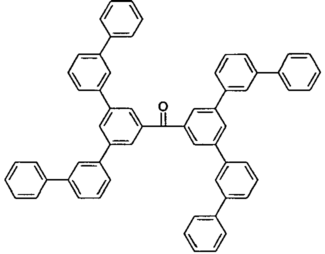 |
| (1-61) | (1-62) |
| 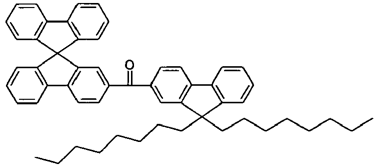 | |
| (1-63) | |

In jeder der oben genannten Beispielstrukturen sind mindestens eine, vorzugsweise zwei Bindungen zu einer weiteren Struktureinheit des Polymers vorhanden, d.h., mindestens ein H-Atom, vorzugsweise zwei H-Atome, stellen eine Bindung zu einer weiteren Struktureinheit dar.

In einer weiteren erfindungsgemäßen Ausführungsform beträgt der Anteil der Einheiten der Formel (1) im Polymer bis 100 mol%, vorzugsweise bis 95 mol%, besonders bevorzugt bis 80 mol% und insbesondere bis 50 mol%. Ebenfalls in einer bevorzugten Ausführungsform beträgt der Anteil der Einheiten der Formel (1) im Polymer mindestens 0,01 mol%, vorzugsweise mindestens 1 mol%, besonders bevorzugt mindestens 5 mol% und insbesondere mindestens 10 mol%.

In einer weiteren Ausführungsform der vorliegenden Erfindung ist es bevorzugt, dass das Polymer weitere von der Formel (1) verschiedene Struktureinheiten enthält. Diese können sich entweder in der Hauptkette (Backbone) oder in einer Seitenkette des Polymers befinden. Die weiteren Struktureinheiten können beispielsweise aus den folgenden Klassen stammen:
- Gruppe 1:: Einheiten, welche die Lochinjektions- und/oder Lochtransporteigenschaften der Polymere beeinflussen;
- Gruppe 2:: Einheiten, welche die Elektroneninjektions- und/oder Elektronentransporteigenschaften der Polymere beeinflussen;
- Gruppe 3:: Einheiten, die Kombinationen von Einzeleinheiten der Gruppe 1 und Gruppe 2 aufweisen;
- Gruppe 4:: Einheiten, welche die Emissionscharakteristik insoweit verändern, dass Elektrophosphoreszenz statt Elektrofluoreszenz erhalten werden kann;
- Gruppe 5:: Einheiten, welche den Übergang vom so genannten Singulett- zum Triplettzustand verbessern;
- Gruppe 6:: Einheiten, welche die Emissionsfarbe der resultierenden Polymere beeinflussen;
- Gruppe 7:: Einheiten, welche typischerweise als Backbone verwendet werden;
- Gruppe 8:: Einheiten, welche die filmmorphologischen und/oder die rheologischen Eigenschaften der resultierenden Polymere beeinflussen.

Bevorzugte Polymere sind solche, bei denen mindestens eine Struktureinheit Ladungstransporteigenschaften aufweist, d.h. die Einheiten aus der Gruppe 1 und/oder 2 enthalten.

Struktureinheiten aus der Gruppe 1, die Lochinjektions- und/oder Lochtransporteigenschaften aufweisen, sind beispielsweise Triarylamin-, Benzidin-, Tetraaryl-para-phenylendiamin-, Triarylphosphin-, Phenothiazin-, Phenoxazin-, Dihydrophenazin-, Thianthren-, Dibenzo-para-dioxin-, Phenoxathiin-, Carbazol-, Azulen-, Thiophen-, Pyrrol- und Furanderivate und weitere O-, S-, Se- oder N-haltige Heterocyclen mit hoch liegendem HOMO (HOMO = höchstes besetztes Molekülorbital). Vorzugsweise führen diese Arylamine und Heterocyclen zu einem HOMO im Polymer von mehr als -5,8 eV (gegen Vakuumlevel), besonders bevorzugt von mehr als -5,5 eV.

Struktureinheiten aus der Gruppe 2, die Elektroneninjektions- und/oder Elektronentransporteigenschaften aufweisen, sind beispielsweise Pyridin-, Pyrimidin-, Pyridazin-, Pyrazin-, Oxadiazol-, Chinolin-, Chinoxalin-, Anthracen-, Benzanthracen-, Pyren-, Perylen-, Benzimidazol-, Triazin-, Keton-, Phosphinoxid- und Phenazinderivate, aber auch Triarylborane und weitere O-, S- oder N-haltige Heterocyclen mit niedrig liegendem LUMO (LUMO = niedrigstes unbesetztes Molekülorbital). Vorzugsweise führen diese Einheiten im Polymer zu einem LUMO von weniger als -1,9 eV (gegen Vakuumlevel), besonders bevorzugt von weniger als -2,5 eV.

Es kann bevorzugt sein, wenn in den Polymeren Einheiten aus der Gruppe 3 enthalten sind, in denen Strukturen, welche die Lochmobilität und welche die Elektronenmobilität beeinflussen, vorzugsweise erhöhen (also Einheiten aus Gruppe 1 und 2), direkt aneinander gebunden sind oder Strukturen enthalten sind, die sowohl die Lochmobilität als auch die Elektronenmobilität erhöhen. Einige dieser Einheiten können als Emitter dienen und verschieben die Emissionsfarbe ins Grüne, Gelbe oder Rote. Ihre Verwendung eignet sich also beispielsweise für die Erzeugung anderer Emissionsfarben aus ursprünglich blau emittierenden Polymeren.

Struktureinheiten aus der Gruppe 4 sind solche, welche auch bei Raumtemperatur mit hoher Effizienz aus dem Triplettzustand Licht emittieren können, also Elektrophosphoreszenz statt Elektrofluoreszenz zeigen, was häufig eine Steigerung der Energieeffizienz bewirkt. Hierfür eignen sich zunächst Verbindungen, welche Schweratome mit einer Ordnungszahl von mehr als 36 enthalten. Bevorzugt sind Verbindungen, welche d- oder f-Übergangsmetalle enthalten, die die o.g. Bedingung erfüllen. Besonders bevorzugt sind hier entsprechende Struktureinheiten, welche Elemente der Gruppe 8 bis 10 (Ru, Os, Rh, Ir, Pd, Pt) enthalten. Als Struktureinheiten für die erfindungsgemäßen Polymere kommen hier z.B. verschiedene Komplexe in Frage, wie sie z.B. in der WO 02/068435 A1, der WO 02/081488 A1, der EP 1239526 A2 und der WO 2004/026886 A2 offenbart werden. Entsprechende Monomere werden in der WO 02/068435 A1 und in der WO 2005/042548 A1 offenbart.

Struktureinheiten aus der Gruppe 5 sind solche, welche den Übergang vom Singulett- zum Triplettzustand verbessern und welche, unterstützend zu den Strukturelementen der Gruppe 4 eingesetzt, die Phosphoreszenzeigenschaften dieser Strukturelemente verbessern. Hierfür kommen insbesondere Carbazol- und überbrückte Carbazoldimereinheiten in Frage, wie sie z.B. in der WO 2004/070772 A2 und der WO 2004/113468 A1 offenbart werden. Weiterhin kommen hierfür Ketone, Phosphinoxide, Sulfoxide, Sulfone, Silan-Derivate und ähnliche Verbindungen in Frage, wie sie z.B. in der WO 2005/040302 A1 offenbart werden.

Struktureinheiten aus der Gruppe 6 sind neben den oben genannten solche, die mindestens noch eine weitere aromatische oder eine andere konjugierte Struktur aufweisen, welche nicht unter die o.g. Gruppen fallen, d.h. die die Ladungsträgermobilitäten nur wenig beeinflussen, die keine metallorganischen Komplexe sind oder die keinen Einfluss auf den Singulett-Triplett-Übergang haben. Derartige Strukturelemente können die Emissionsfarbe der resultierenden Polymere beeinflussen. Je nach Einheit können sie daher auch als Emitter eingesetzt werden. Bevorzugt sind dabei aromatische Strukturen mit 6 bis 40 C-Atomen oder auch Tolan-, Stilben- oder Bisstyrylarylenderivate, die jeweils mit einem oder mehreren Resten R substituiert sein können. Besonders bevorzugt ist dabei der Einbau von 1,4-Phenylen-, 1,4-Naphthylen-, 1,4- oder 9,10-Anthrylen-, 1,6-, 2,7- oder 4,9-Pyrenylen-, 3,9- oder 3,10-Perylenylen-, 4,4'-Biphenylylen-, 4,4"-Terphenylylen, 4,4'-Bi-1,1'-naphthylylen-, 4,4'-Tolanylen-, 4,4'-Stilbenylen-, 4,4"-Bisstyrylarylen-, Benzothiadiazol- und entsprechenden Sauerstoffderivaten, Chinoxalin-, Phenothiazin-, Phenoxazin-, Dihydrophenazin-, Bis(thiophenyl)arylen-, Oligo(thiophenylen)-, Phenazin-, Rubren-, Pentacen- oder Perylenderivaten, die vorzugsweise substituiert sind, oder vorzugsweise konjugierte Push-Pull-Systeme (Systeme, die mit Donor- und Akzeptorsubstituenten substituiert sind) oder Systeme wie Squarine oder Chinacridone, die vorzugsweise substituiert sind.

Struktureinheiten aus der Gruppe 7 sind Einheiten, die aromatische Strukturen mit 6 bis 40 C-Atomen beinhalten, welche typischerweise als Polymergrundgerüst (Backbone) verwendet werden. Dies sind beispielsweise 4,5-Dihydropyrenderivate, 4,5,9,10-Tetrahydropyrenderivate, Fluorenderivate, 9,9'-Spirobifluorenderivate, Phenanthrenderivate, 9,10-Dihydrophenanthrenderivate, 5,7-Dihydrodibenzooxepinderivate und cis- und trans-Indenofluorenderivate.

Struktureinheiten aus der Gruppe 8 sind solche, die die filmmorphologischen Eigenschaften und/oder die rheologischen Eigenschaften der Polymere beeinflussen, wie z.B. Siloxane, lange Alkylketten oder fluorierte Gruppen, aber auch besonders steife oder flexible Einheiten, wie z.B. flüssigkristallbildende Einheiten oder vernetzbare Gruppen.

Bevorzugt sind Polymere, die gleichzeitig neben den Struktureinheiten der Formel (1) zusätzlich noch eine oder mehrere Einheiten ausgewählt aus den Gruppen 1 bis 8 enthalten, die von den erfindungsgemäßen Struktureinheiten (Wiederholungseinheiten) der Formel (1) verschieden sind. Es kann ebenfalls bevorzugt sein, wenn gleichzeitig mehr als eine Wiederholungseinheit aus einer Gruppe vorliegt.

Bevorzugt sind dabei Polymere, die neben mindestens einer Struktureinheit der Formel (1) noch Einheiten aus der Gruppe 7 enthalten, besonders bevorzugt mindestens 50 mol% dieser Einheiten, bezogen auf die Gesamtzahl der Struktureinheiten im Polymer.

Ebenfalls bevorzugt ist es, wenn die Polymere Einheiten enthalten, die den Ladungstransport und/oder die Ladungsinjektion verbessern, also Einheiten aus der Gruppe 1 und/oder 2; besonders bevorzugt ist ein Anteil von 0,5 bis 30 mol% dieser Einheiten; insbesondere bevorzugt ist ein Anteil von 1 bis 10 mol% dieser Einheiten.

Besonders bevorzugt ist es weiterhin, wenn die Polymere Struktureinheiten aus der Gruppe 7 und Einheiten aus der Gruppe 1 und/oder 2 enthalten, insbesondere mindestens 50 mol% Einheiten aus der Gruppe 7 und 0,5 bis 30 mol% Einheiten aus der Gruppe 1 und/oder 2.

Besonders bevorzugte Struktureinheiten in dem erfindungsgemäßen Polymer, welche sich zudem von den Struktureinheiten der Formel (1) unterscheiden, sind substituierte oder unsubstituierte cis- oder trans-Indenofluorene sowie substituierte oder unsubstituierte IndenofluorenDerivate, wie z.B. Indenocarbazole, oder Struktureinheiten umfassend zwei aromatische Gruppen, die über eine C₁₋₁₀-Alkylengruppe, C₂₋₁₀-Alkenylengruppe, C₂₋₁₀-Alkinylengruppe und Si₁₋₁₀-Silylengruppe, wobei eine oder mehrere CH₂-Einheiten durch NR, O oder S und eine oder mehrere SiH₂-Einheiten durch O ersetzt sein können, miteinander verbunden sind. Vorzugsweise liegt der Anteil dieser Struktureinheiten im Bereich von 20 bis 70 mol%, besonders bevorzugt im Bereich von 40 bis 60 mol% und insbesondere mit 50 mol%, bezogen auf die Gesamtzahl der Struktureinheiten im Polymer.

Die Indenofluoren-Struktureinheit entspricht dabei vorzugsweise der folgenden Formel (I): 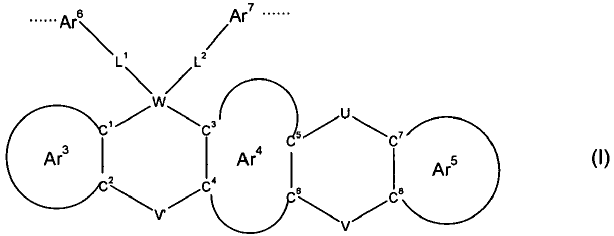 wobei die verwendeten Symbole und Indices die folgenden Bedeutungen haben:
die gestrichelten Linien stellen unabhängig voneinander eine Bindung zu einer weiteren Struktureinheit des Polymers dar;
L¹ und L² stellen unabhängig voneinander eine kovalente Einfachbindung oder eine Einheit dar, die aus der Gruppe ausgewählt ist, die aus einer C_{1- 10}-Alkylengruppe, C₂₋₁₀-Alkenylengruppe, C₂₋₁₀-Alkinylengruppe und Si₁₋₁₀-Silylengruppe besteht, wobei eine oder mehrere CH₂-Einheiten durch NR, O oder S und eine oder mehrere SiH₂-Einheiten durch O ersetzt sein können;
W stellt eine tetravalente Einheit dar, die aus der Gruppe ausgewählt ist, die aus C, Si, Ge und einem Strukturelement der folgenden Formeln (II) und (III) besteht: 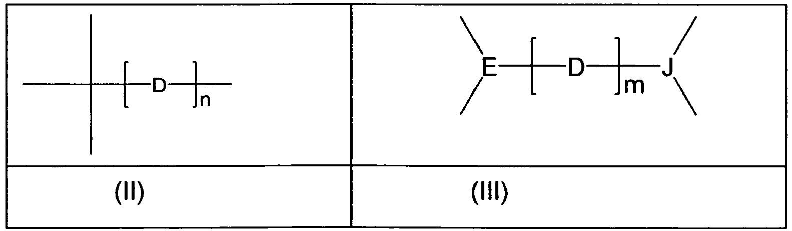 wobei D gleich oder verschieden bei jedem Auftreten eine Einheit ist, die aus der Gruppe ausgewählt ist, die aus CR₂, O, S und NR besteht;
E und J jeweils unabhängig voneinander Einheiten sind, die aus der Gruppe ausgewählt sind, die aus CR und N besteht;
   - n: 1, 2 oder 3 ist;
   - m: 0, 1 oder 2 ist; wobei
   - R: ein Rest ist, der aus der Gruppe ausgewählt ist, die aus H, D, F und C₁₋₆-Alkyl besteht;
   mit der Maßgabe, dass nur ein Vertreter aus E, D und J verschieden von CR¹ oder CR²₂ ist;
wobei für den Fall, dass W eine tetravalente Einheit der Formel (II) oder (III) ist, C¹ und C³ an verschiedene Atome der Einheit W binden;
U, V und V' stellen unabhängig voneinander eine kovalente Einfachbindung oder eine bivalente Einheit dar, die aus der Gruppe ausgewählt ist, die aus CR¹R², C=O, NR¹, O, SiR¹R², P=O, S und GeR¹R² besteht;
wobei R¹ und R² in der Formel (I) unabhängig voneinander aus der Gruppe ausgewählt sind, die aus H, D, F, einer C₁₋₄₀-Alkylgruppe, einer C₂₋₄₀-Alkenylgruppe, einer C₂₋₄₀-Alkinylgruppe, einer optional substituierten C₆₋₄₀-Arylgruppe und einer optional substituierten 5- bis 25-gliedrigen Heteroarylgruppe besteht;
C¹ bis C⁸ stellen jeweils ein C-Atom dar;
Ar⁶ und Ar⁷ stellen jeweils unabhängig voneinander ein 5- bis 25-gliedriges optional substituiertes aromatisches oder heteroaromatisches Ringsystem dar;
Ar³, Ar⁴ und Ar⁵ stellen unabhängig voneinander eine optional substituierte C₆₋₄₀-Arylgruppe oder eine optional substituierte 5- bis 25-gliedrige Heteroarylgruppe dar, wobei die C-Atome C¹ und C² Bestandteil von Ar³, die C-Atome C³ bis C⁶ Bestandteil von Ar⁴ und die C-Atome C⁷ und C⁸ Bestandteil von Ar⁵ sind.

In einer weiteren Ausführungsform der vorliegenden Erfindung ist es bevorzugt, dass L¹ und L² eine kovalente Einfachbindung darstellen.

In einer noch weiteren Ausführungsform der vorliegenden Erfindung ist es bevorzugt, dass W aus der Gruppe ausgewählt ist, die aus C, Si und Ge besteht. Besonders bevorzugt ist W ein Kohlenstoffatom.

In einer noch weiteren Ausführungsform der vorliegenden Erfindung ist es bevorzugt, dass in Verbindungen der Formel (I) ein Vertreter aus U und V eine kovalente Einfachbindung und der andere Vertreter eine, wie oben beschriebene, Einheit CR¹R² darstellt.

In einer noch weiteren Ausführungsform der vorliegenden Erfindung ist es bevorzugt, dass Ar⁶ und Ar⁷ ein 6- bis 14-gliedriges optional substituiertes aromatisches Ringsystem darstellt. Durch den Begriff "6- bis 14-gliedriges optional substituiertes aromatisches Ringsystem" sollen erfindungsgemäß alle Verbindungen erfasst werden, die unter die atomanzahlmäßige Schnittmenge des als "5- bis 25-gliedrigen optional substituierten aromatischen Ringsystem" definierten Begriffs fallen. Vorzugsweise sind diese Ringsysteme Phenyl, Naphtyl, Anthracyl und Phenanthryl, besonders bevorzugt Phenyl und Naphtyl und insbesondere Phenyl. In einer noch weiteren Ausführungsform der vorliegenden Erfindung ist es bevorzugt, dass ein, zwei oder alle drei Vertreter aus Ar³, Ar⁴ und Ar⁵ unabhängig voneinander eine optional substituierte C₆₋₁₄-Arylgruppe sind. Durch den Begriff "C₆₋₁₄-Arylgruppe" sollen erfindungsgemäß alle Verbindungen erfasst werden, die unter die atomanzahlmäßige Schnittmenge des als "C₆₋₄₀-Arylgruppe" definierten Begriffs fallen. Vorzugsweise sind diese Ringsysteme Phenyl, Naphtyl, Anthracyl und Phenanthryl, besonders bevorzugt Phenyl und Naphtyl und insbesondere Phenyl.

Alle nicht bevorzugten und bevorzugten Bestandteile der oben genannten Ausführungsformen können erfindungsgemäß beliebig miteinander kombiniert werden. Diese Kombinationen sind ebenso Bestandteil der vorliegenden Erfindung.

Eine weitere bevorzugte erfindungsgemäße Ausführungsform ist ein Polymer, das mindestens eine Struktureinheit der folgenden Formeln (IVa), (IVb) und/oder (IVc) enthält: 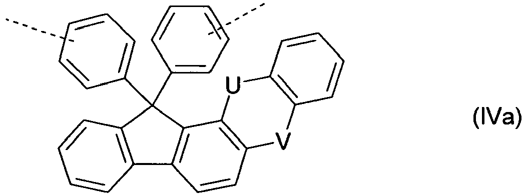 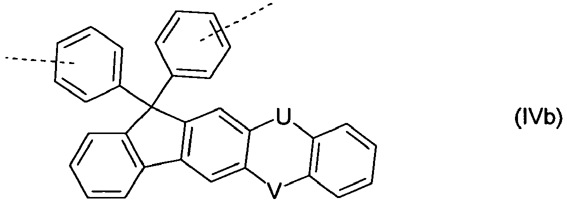 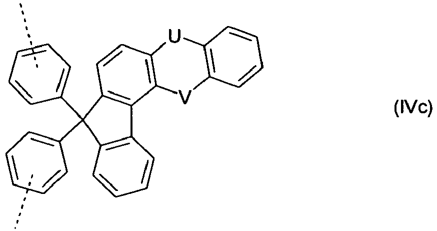 wobei die gestrichelten Linien, U und V die gleichen Bedeutungen haben wie in den oben genannten Ausführungsformen und bevorzugten Ausführungsformen zur Formel (I) definiert. Die Bindungen, die durch die gestrichelten Linien gekennzeichnet sind, stellen Bindungen in ortho-, meta- oder para-Stellung an den entsprechenden Phenylringen dar. Bevorzugt sind die meta- und para-Stellung. Bevorzugt ist auch, dass ein Vertreter aus U und V eine kovalente Einfachbindung darstellt und der andere Vertreter CR¹R² ist.

Eine weitere besonders bevorzugte Ausführungsform ist somit ein Polymer, das mindestens eine Struktureinheit der folgenden Formeln (Va) und/oder (Vb) enthält: 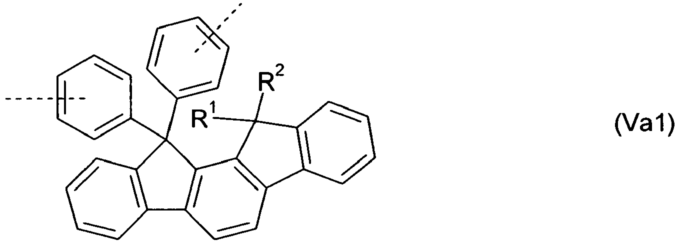 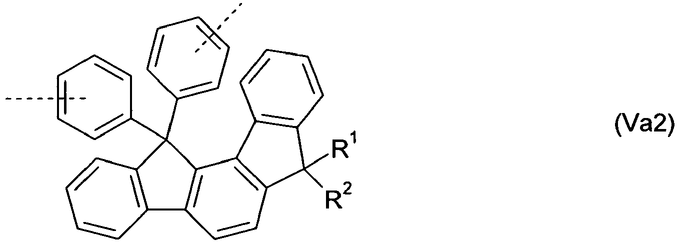 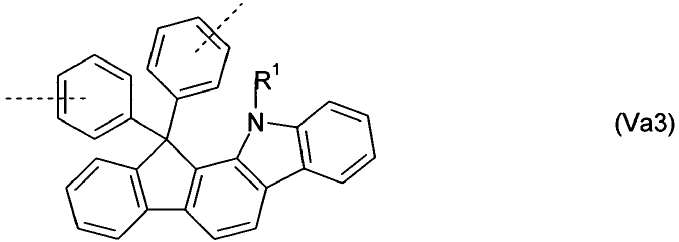 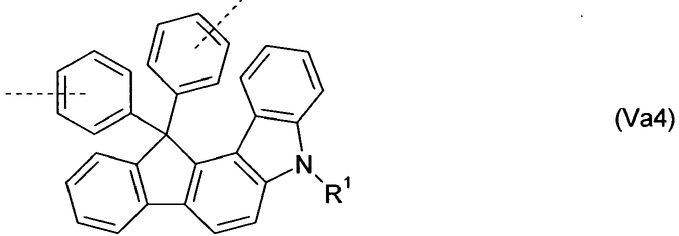 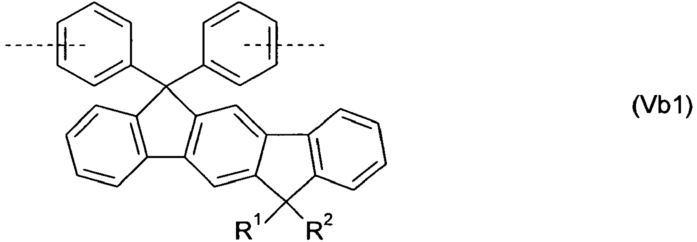 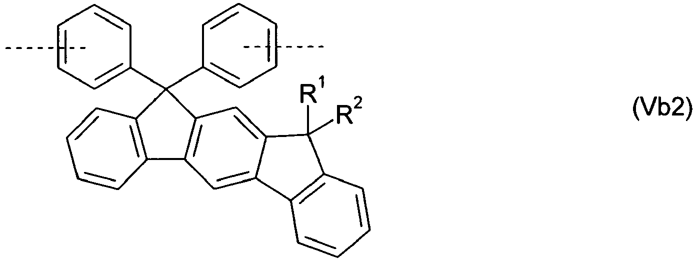 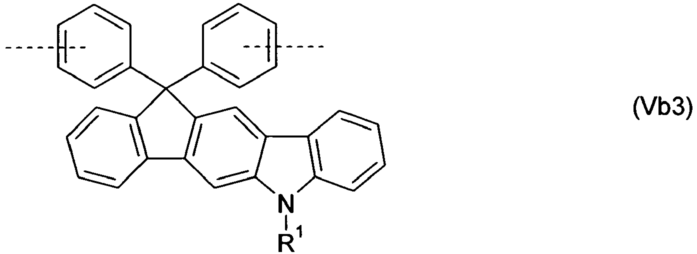 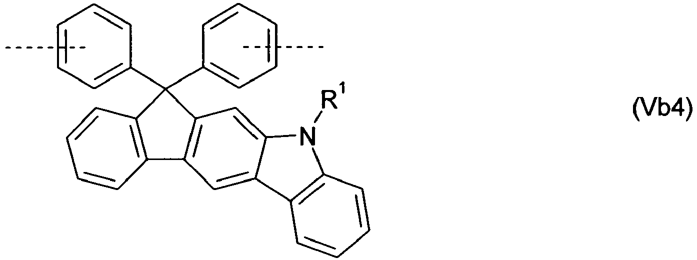 wobei die gestrichelten Linien die gleiche Bedeutung haben wie in den vorstehenden Ausführungsformen, und R¹ und R² die gleichen Bedeutungen haben wie R¹ und R² in Bezug auf Formel (I).

Besonders bevorzugt als Comonomer-Struktureinheit ist die folgende Indenofluoren-Struktureinheit:

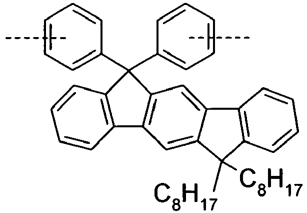

Unter den Struktureinheiten, welche zwei aromatische Gruppen aufweisen, die über eine lineare C₁-C₁₀-Alkylengruppe miteinander verbunden sind, ist die folgende Struktureinheit besonders bevorzugt:

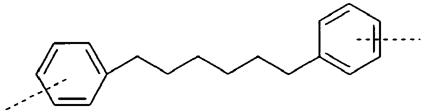

Unter den Struktureinheiten, welche zwei aromatische Gruppen aufweisen, die über eine lineare C₁-C₁₀-Alkylengruppe miteinander verbunden sind, wobei ein oder mehrere CH₂-Gruppen durch O ersetzt sind, ist die folgende Struktureinheit besonders bevorzugt:

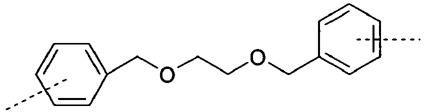

Unter den Struktureinheiten, welche zwei aromatische Gruppen aufweisen, die über eine lineare Si₁-Si₁₀-Silylengruppe miteinander verbunden sind, ist die folgende Struktureinheit besonders bevorzugt:

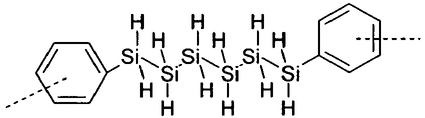

Die erfindungsgemäßen Polymere werden in der Regel durch Polymerisation von einer oder mehreren Monomersorten hergestellt, von denen mindestens eine Monomersorte im Polymer Struktureinheiten der Formel (1) bildet. Geeignete Polymerisationsreaktionen sind dem Fachmann bekannt und in der Literatur beschrieben. Besonders geeignete und bevorzugte Polymerisationsreaktionen, die zu C-C- bzw. C-N-Verknüpfungen führen, sind folgende:
(A) SUZUKI-Polymerisation;
(B) YAMAMOTO-Polymerisation;
(C) STILLE-Polymerisation;
(D) HECK-Polymerisation;
(E) NEGISHI-Polymerisation;
(F) SONOGASHIRA-Polymerisation;
(G) HIYAMA-Polymerisation; und
(H) HARTWIG-BUCHWALD-Polymerisation.

Wie die Polymerisation nach diesen Methoden durchgeführt werden kann und wie die Polymere dann vom Reaktionsmedium abgetrennt und aufgereinigt werden können, ist dem Fachmann bekannt und in der Literatur, beispielsweise in der WO 03/048225 A2, der WO 2004/037887 A2 und der WO 2004/037887 A2 im Detail beschrieben.

Die Methoden für die C-C-Verknüpfungen sind vorzugsweise ausgewählt aus der Gruppe umfassend SUZUKI-Kupplung, YAMAMOTO-Kupplung und STILLE-Kupplung. Die Methode für eine C-N-Verknüpfung ist vorzugsweise eine Kupplung gemäß HARTWIG-BUCHWALD.

Dendrimere können gemäß dem Fachmann bekannten Verfahren oder in Analogie dazu hergestellt werden. Geeignete Verfahren sind in der Literatur beschrieben, wie z.B. in Frechet, Jean M. J.; Hawker, Craig J., "Hyperbranched polyphenylene and hyperbranched polyesters: new soluble, three-dimensional, reactive polymers", Reactive & Functional Polymers (1995), 26(1-3), 127-36; Janssen, H. M.; Meijer, E. W., "The synthesis and characterization of dendritic molecules", Materials Science and Technology (1999), 20 (Synthesis of Polymers), 403-458; Tomalia, Donald A., "Dendrimer molecules", Scientific American (1995), 272(5), 62-6, WO 02/067343 A1 und WO 2005/026144 A1.

Die Synthese der oben beschriebenen Einheiten aus der Gruppe 1 bis 8 sowie der weiteren emittierenden Einheiten ist dem Fachmann bekannt und in der Literatur, z.B. in der WO 2005/014689 A2, der WO 2005/030827 A1 und der WO 2005/030828 A1, beschrieben. Diese Dokumente und die darin zitierte Literatur sind via Zitat Bestandteil der vorliegenden Anmeldung.

In einer Ausführungsform der erfindungsgemäßen Mischung ist die Carbazolverbindung vorzugsweise eine Verbindung der Formel (6) 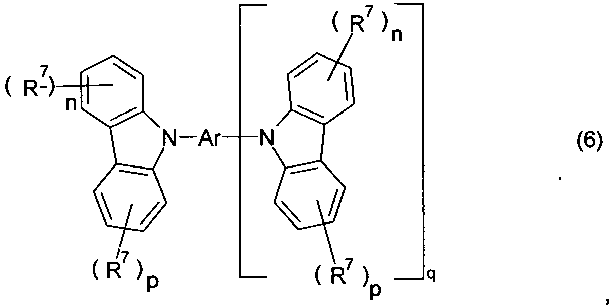 wobei für die verwendeten Symbole und Indices gilt:
- Ar: ist bei jedem Auftreten ein aromatisches oder heteroaromatisches Ringsystem mit 5 bis 60 aromatischen Ringatomen, welches mit einem oder mehreren Resten R⁷ substituiert sein kann;
- R⁷: ist bei jedem Auftreten gleich oder verschieden H, D, F, Cl, Br, I, N(Ar²)₂, CN, NO₂, Si(R⁸)₃, B(OR⁸)₂, C(=O)Ar², P(=O)(Ar²)₂, S(=O)Ar², S(=O)₂Ar², -CR⁸=CR⁸(Ar²), OSO₂R⁸, eine geradkettige Alkyl-, Alkoxy- oder Thioalkoxygruppe mit 1 bis 40 C-Atomen oder eine verzweigte oder cyclische Alkyl-, Alkoxy- oder Thioalkoxygruppe mit 3 bis 40 C-Atomen, die jeweils mit einem oder mehreren Resten R⁸ substituiert sein kann, wobei eine oder mehrere nicht benachbarte CH₂-Gruppen durch R⁸C=CR⁸, C≡C, Si(R⁸)₂, Ge(R⁸)₂, Sn(R⁸)₂, C=O, C=S, C=Se, C=NR⁸, P(=O)(R⁸), SO, SO₂, NR⁸, O, S oder CONR⁸ ersetzt sein können und wobei ein oder mehrere H-Atome durch F, Cl, Br, I, CN oder NO₂ ersetzt sein können, oder ein aromatisches oder heteroaromatisches Ringsystem mit 5 bis 60 aromatischen Ringatomen, das jeweils mit einem oder mehreren Resten R⁸ substituiert sein kann, oder eine Aryloxy- oder Heteroaryloxygruppe mit 5 bis 60 aromatischen Ringatomen, die mit einem oder mehreren Resten R⁸ substituiert sein kann, oder eine Kombination dieser Systeme; dabei können zwei oder mehrere Substituenten R auch miteinander ein mono- oder polycyclisches, aliphatisches oder aromatisches Ringsystem bilden;
- R⁷: ist bei jedem Auftreten gleich oder verschieden R, eine Gruppe Ar² oder F;
- Ar²: ist bei jedem Auftreten gleich oder verschieden ein aromatisches oder heteroaromatisches Ringsystem mit 5 bis 60 aromatischen Ringatomen, welches mit einem oder mehreren Resten R⁸ substituiert sein kann;
- R⁸: ist bei jedem Auftreten gleich oder verschieden H, D oder ein aliphatischer, aromatischer und/oder heteroaromatischer Kohlenwasserstoffrest mit 1 bis 20 C-Atomen; oder ein aromatisches oder heteroaromatisches Ringsystem mit 5 bis 60 aromatischen Ringatomen, welches mit einem oder mehreren Resten R substituiert sein kann; dabei können zwei oder mehrere Substituenten R⁸ auch miteinander ein mono- oder polycyclisches, aliphatisches, aromatisches oder heteroaromatisches Ringsystem bilden;
- n: ist bei jedem Auftreten gleich oder verschieden 0, 1, 2, 3 oder 4;
- p: ist bei jedem Auftreten gleich oder verschieden 0, 1, 2, 3 oder 4; und
- q: ist 1, 2, 3, 4 oder 5.

Wenn der Index q gleich 1 ist, bedeutet dies, dass Ar in Verbindungen der Formel (6) eine bivalente Gruppe darstellt. Wenn der Index q größer als 1 ist, bedeutet dies, dass insgesamt drei oder mehr Carbazolgruppen an das aromatische Ringsystem Ar in Verbindungen der Formel (6) gebunden sind. In Verbindungen der Formel (6) ist Ar für q = 2 eine trivalente Gruppe und für q > 2 eine entsprechend höhervalente Gruppe. Bevorzugt ist der Index q = 1 oder 2, besonders bevorzugt ist q = 1.

Bevorzugt weisen die erfindungsgemäß eingesetzten Carbazolverbindungen der Formel (6) eine Glasübergangstemperatur T_{g} von mehr als 120°C auf, besonders bevorzugt von mehr als 140°C.

Die Carbazolverbindung der Formel (6) dient im Sinne der vorliegenden Erfindung vornehmlich als Matrixmaterial und/oder als Lochtransportmaterial. Ein lochtransportierendes Material im Sinne der vorliegenden Anmeldung ist charakterisiert durch ein HOMO von vorzugsweise mehr als -5,4 eV. Ein elektronentransportierendes Material im Sinne der vorliegenden Anmeldung ist charakterisiert durch ein LUMO von vorzugsweise weniger als -2,4 eV. Dabei erfolgt die Bestimmung der HOMO- und LUMO-Lagen und der Energielücke vorzugsweise durch Cyclovoltammetrie.

In einer bevorzugten Ausführungsform der vorliegenden Erfindung sind die Indices n in Verbindungen der Formel (6) bei jedem Auftreten gleich oder verschieden 0 oder 1. Besonders bevorzugt sind die Indices n = 0.

In einer Ausführungsform ist in der Verbindung gemäß Formel (6) der Index p vorzugsweise gleich oder verschieden bei jedem Auftreten 0, 1 oder 2, besonders bevorzugt 0 oder 1. Wenn der Index p gleich 1 ist, ist der Substituent R⁷ bevorzugt in der 5-Position oder in der 7-Position des Carbazols gebunden, besonders bevorzugt in der 5-Position. Wenn der Index p gleich 2 ist, sind die Substituenten R⁷ bevorzugt in der 5- und in der 7-Position des Carbazols gebunden.

Der Übersichtlichkeit halber ist in der folgenden Formel die Nummerierung der Positionen des Carbazols dargestellt:

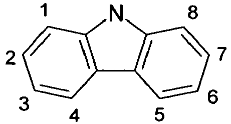

Bevorzugte Gruppen Ar und R⁸ in Formel (6) enthalten nur Phenyl- und/oder Naphthylgruppen oder heteroaromatische Gruppen mit nicht mehr als zwei kondensierten, aromatischen bzw. heteroaromatischen Ringen, jedoch keine größeren kondensierten aromatischen Systeme. Daher sind bevorzugte Gruppen Ar und R⁸ aromatische Ringsysteme, welche aufgebaut sind aus Phenyl- und/oder Naphthylgruppen oder Verknüpfungen dieser Systeme, wie beispielsweise Biphenyl, Fluoren und Spirobifluoren.

Besonders bevorzugte Gruppen Ar sind ausgewählt aus der Gruppe bestehend aus 1,2-Phenylen, 1,3-Phenylen, 1,4-Phenylen, 1,3,5-Benzol, 3,3'-Biphenyl, 4,4'-Biphenyl, 1,3,5-Triphenylbenzol, Triphenylamin, 2,7-Fluorenylen, welches durch einen oder mehrere Reste R⁷ substituiert sein kann, 2,7-Spirobifluorenylen, welches durch einen oder mehrere Reste R⁷ substituiert sein kann, Indenofluorenylen, welches durch einen oder mehrere Reste R⁷ substituiert sein kann, 4,4'''-(1,1':2',1",2",1'''-Quarterphenyl), 4,4'-(2,2'-Dimethylbiphenyl), 4,4'-(1,1'-Binaphthyl), 4,4'-Stilbenyl und Dihydrophenanthrenyl, welches durch einen oder mehrere Reste R⁷ substituiert sein kann.

Besonders bevorzugte Gruppen R⁸ der Carbazolverbindung sind gleich oder verschieden ausgewählt aus der Gruppe bestehend aus Phenyl, 1-Naphthyl, 2-Naphthyl, 2-Carbazolyl, 3-Carbazolyl, 9-Carbazolyl, Triphenylamin, Naphthyldiphenylamin und Dinaphthylphenylamin, welche jeweils durch einen oder mehrere Reste R substituiert sein können. Dabei können die beiden letztgenannten Gruppen über das Naphthalin in 1- oder 2-Position oder über die Phenylgruppe gebunden sein. Eine 2- bzw. 3-Carbazolylgruppe ist dabei vorzugsweise am Stickstoff durch einen aromatischen Rest Ar substituiert.

Bevorzugt sind weiterhin Verbindungen gemäß Formel (6) in denen das Symbol R gleich oder verschieden bei jedem Auftreten für H, D, N(Ar²)₂, eine geradkettige Alkylgruppe mit 1 bis 5 C-Atomen oder verzweigte Alkylgruppe mit 3 bis 5 C-Atomen, wobei jeweils eine oder mehrere nicht benachbarte CH₂-Gruppen durch -R⁸C=CR⁸- oder -O- ersetzt sein können und wobei ein oder mehrere H-Atome durch F ersetzt sein können, oder eine Arylgruppe mit 6 bis 16 C-Atomen oder Heteroarylgruppe mit 2 bis 16 C-Atomen oder eine Spirobifluorengruppe, die jeweils mit einem oder mehreren Resten R⁸ substituiert sein kann, oder eine Kombination aus zwei dieser Systeme steht. Besonders bevorzugte Reste R sind gleich oder verschieden bei jedem Auftreten H, D, Methyl, Ethyl, iso-Propyl, tert-Butyl, wobei jeweils ein oder mehrere H-Atome durch F ersetzt sein können, oder eine Phenyl-, Naphthyl- oder Spirobifluorenylgruppe, die jeweils mit einem oder mehreren Resten R substituiert sein kann, oder eine Kombination aus zwei dieser Systeme. Bei Verbindungen, die aus Lösung verarbeitet werden, sind insbesondere lineare oder verzweigte Alkylketten mit bis zu 10 C-Atomen bevorzugt. Brom, Boronsäure bzw. Boronsäurederivate als Substituenten sind vor allem für die Verwendung dieser Verbindung als Zwischenverbindung zur Herstellung weiterer erfindungsgemäßer Verbindungen, beispielsweise Polymere, Oligomere oder Dendrimere, bevorzugt.

Bevorzugt sind weiterhin Verbindungen gemäß Formel (6) in denen das Symbol R⁷ gleich oder verschieden bei jedem Auftreten entsprechend dem bevorzugten Substituenten R definiert ist oder für Ar² oder F steht.

Beispiele für weitere bevorzugte Verbindungen gemäß Formel (6) sind die im Folgenden abgebildeten Strukturen (6-1) bis (6-91).

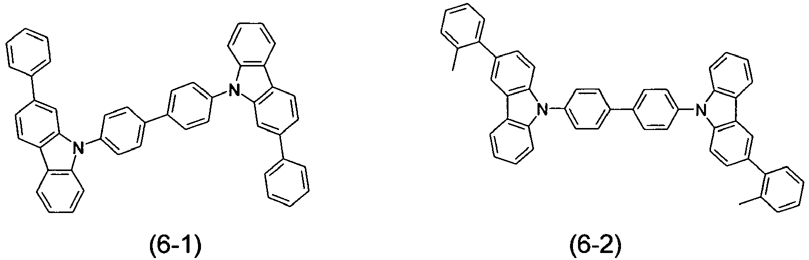

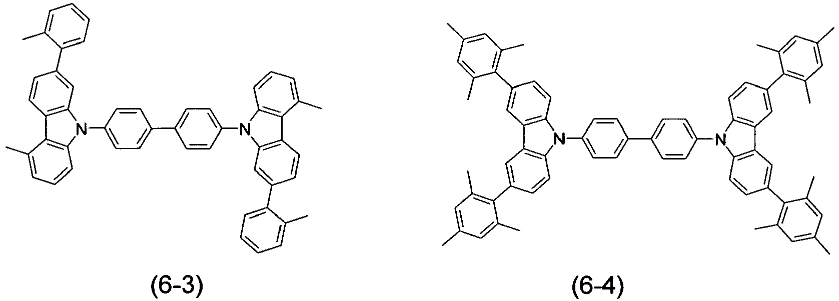

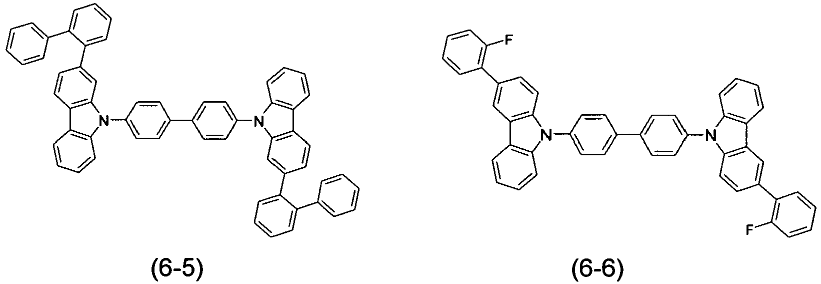

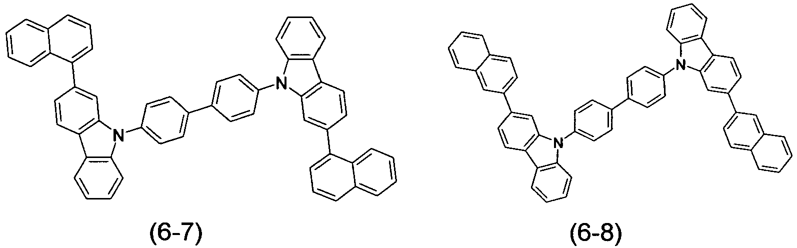

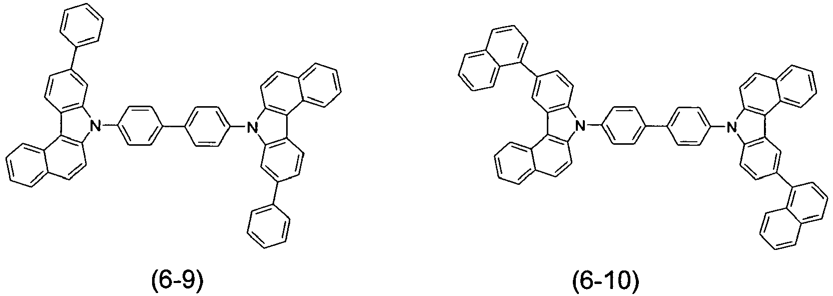

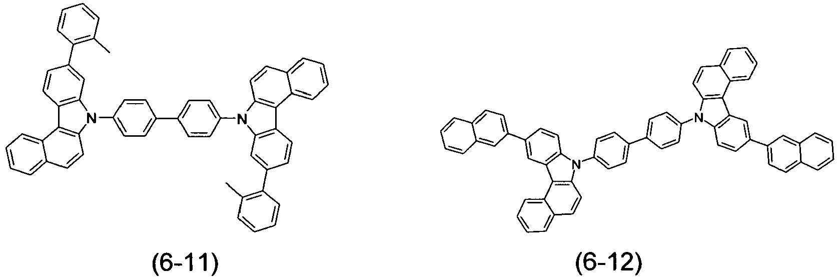

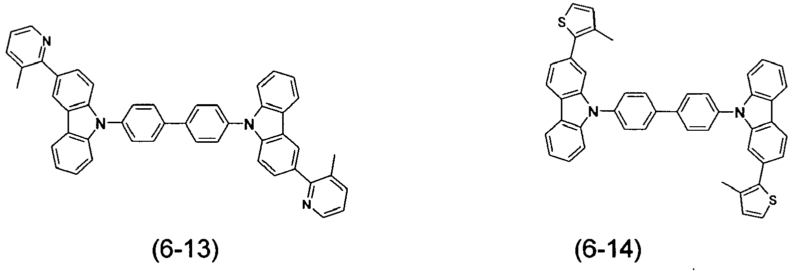

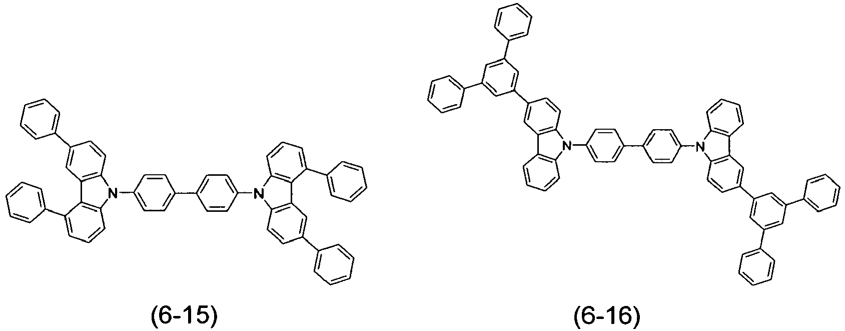

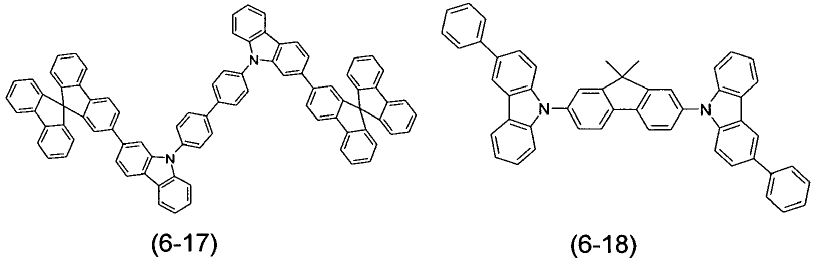

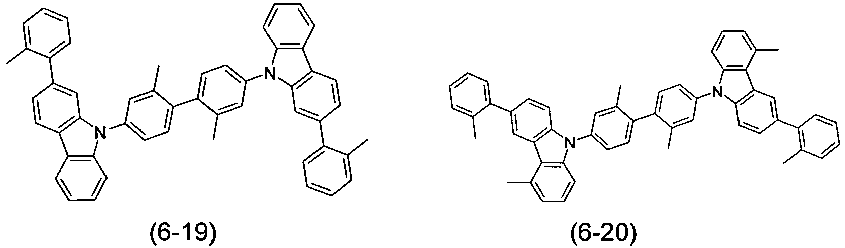

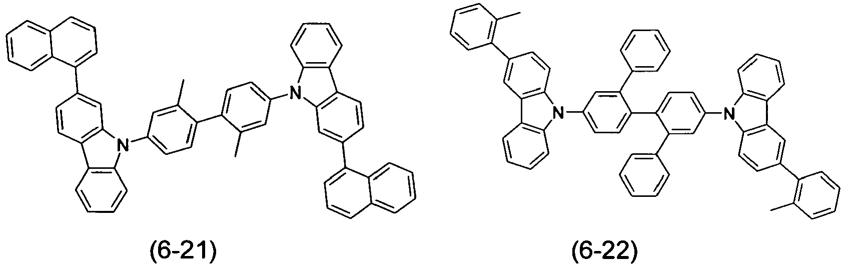

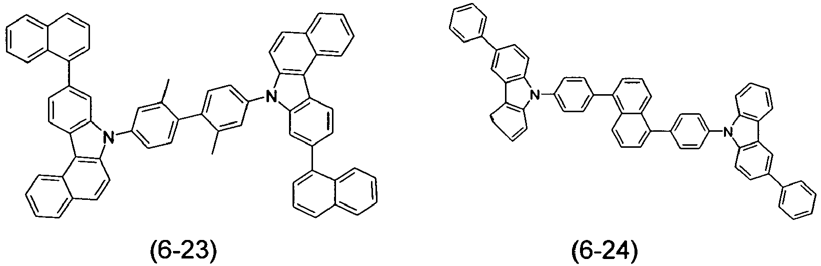

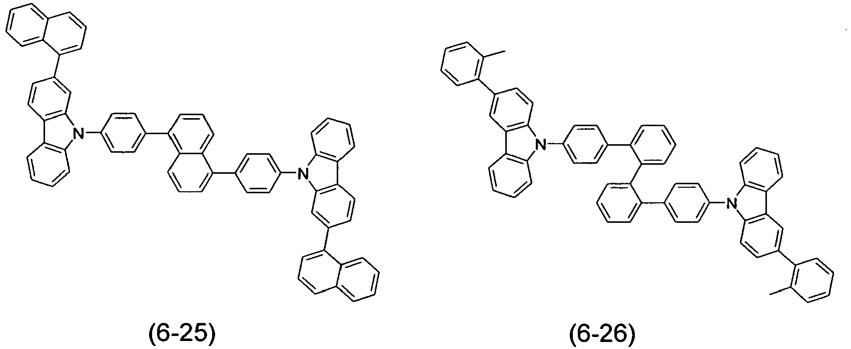

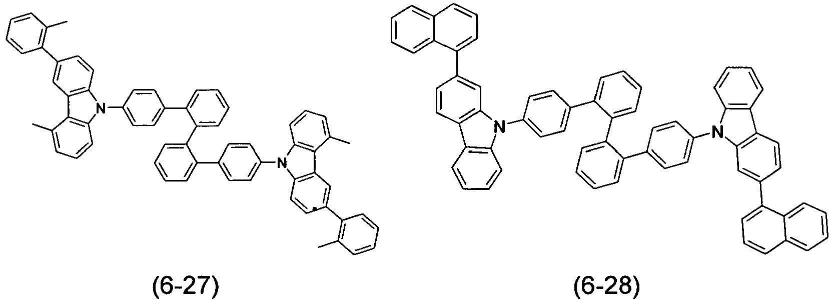

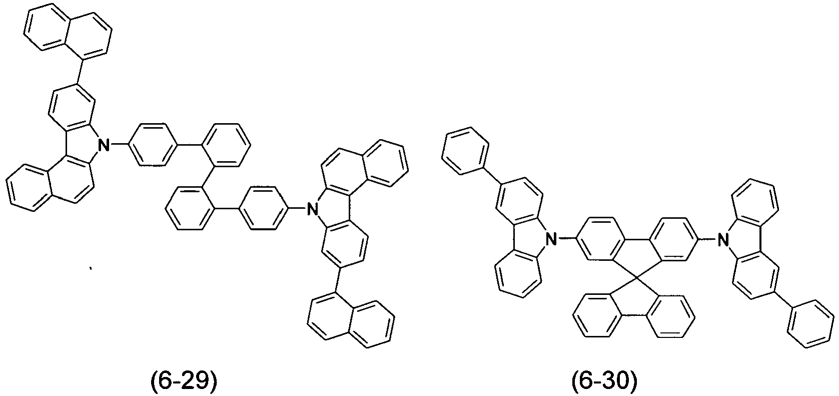

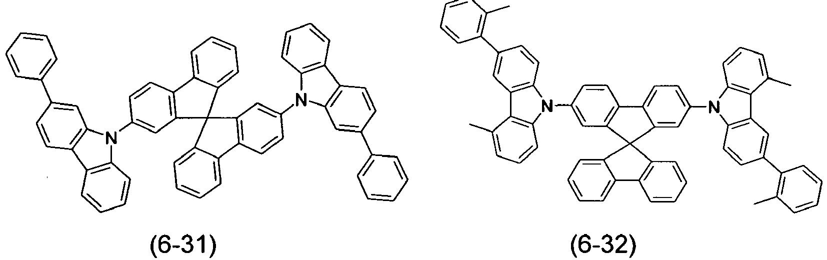

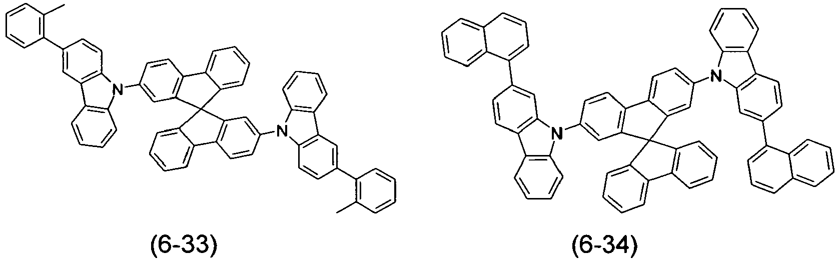

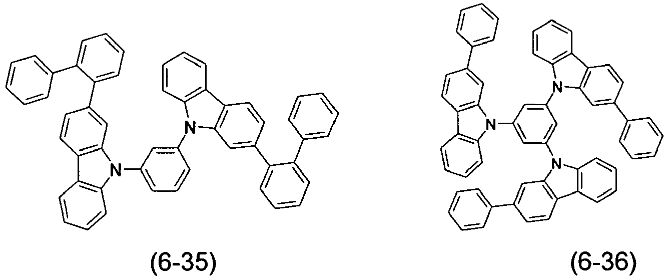

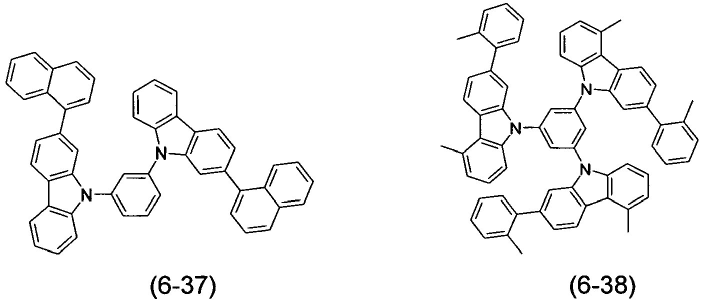

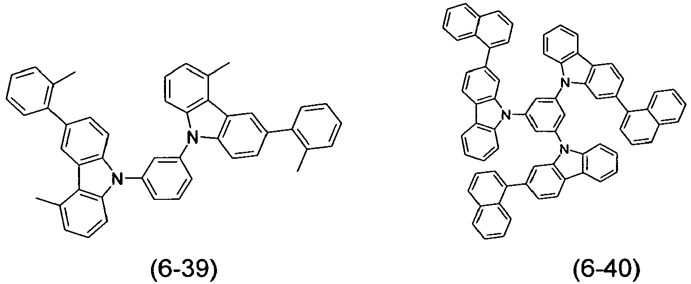

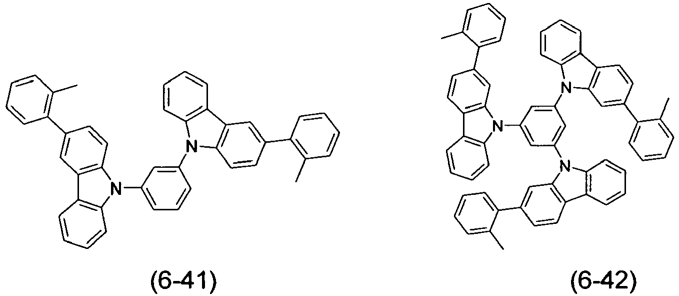

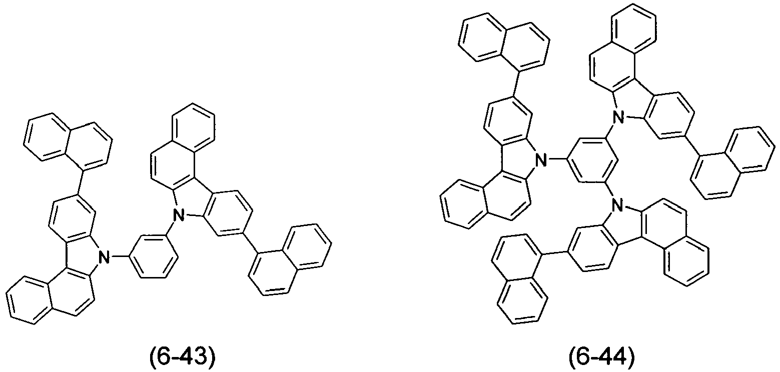

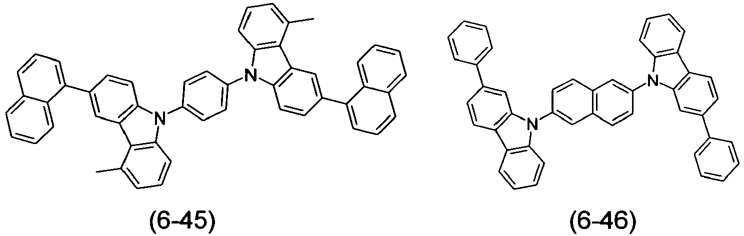

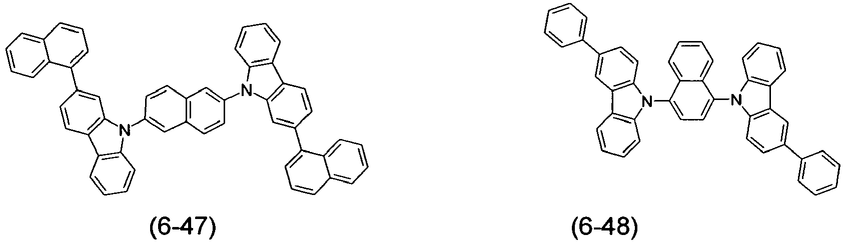

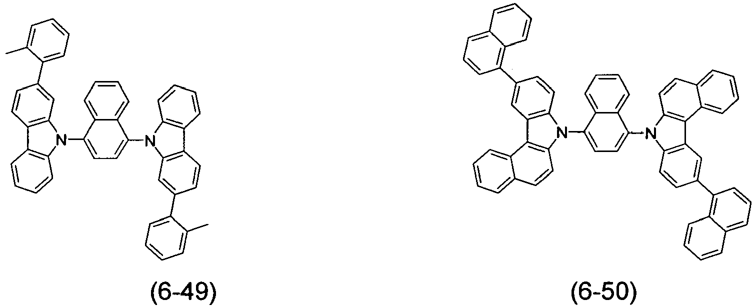

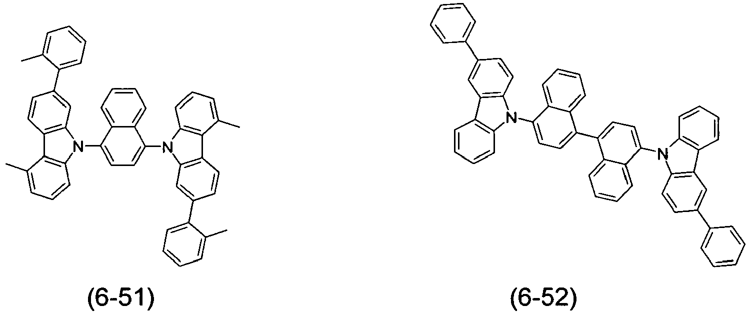

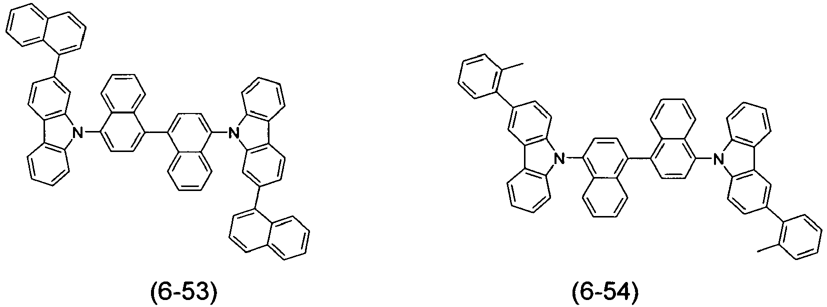

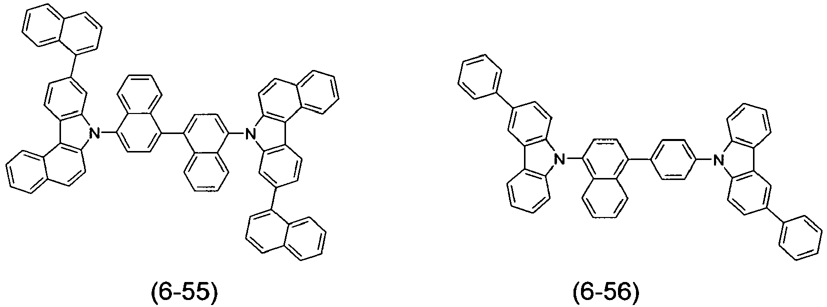

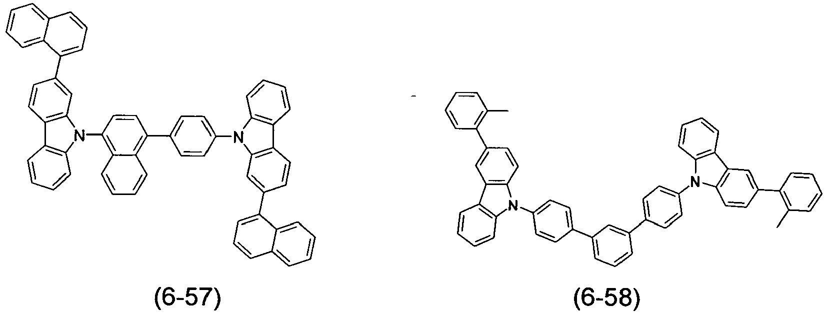

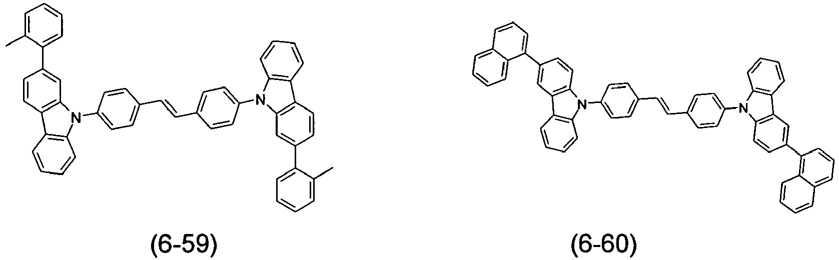

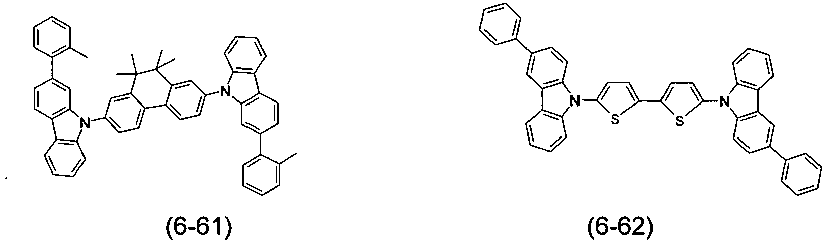

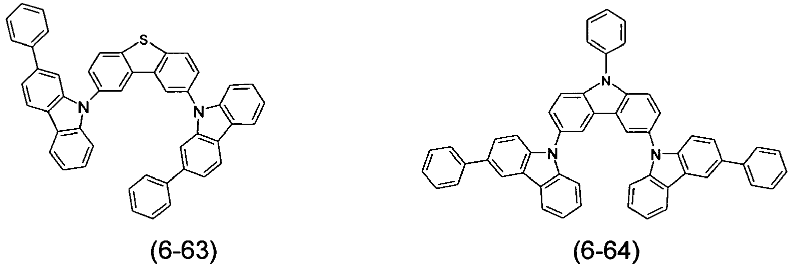

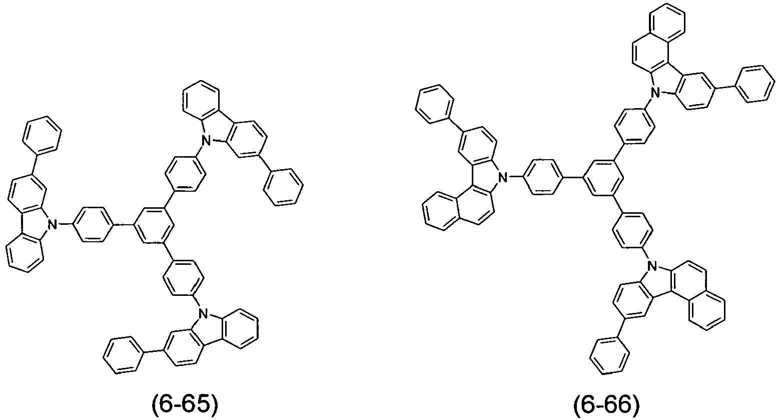

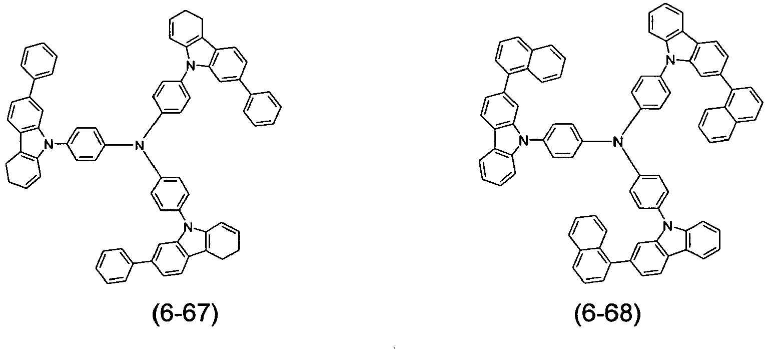

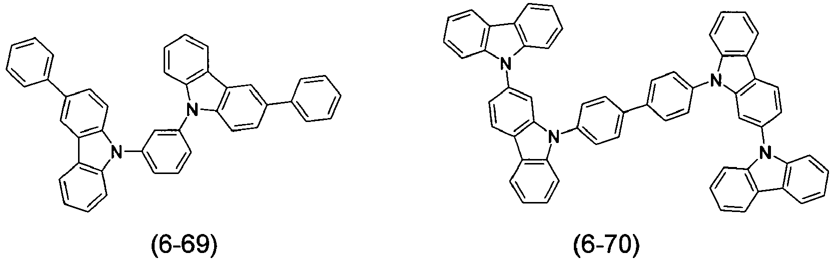

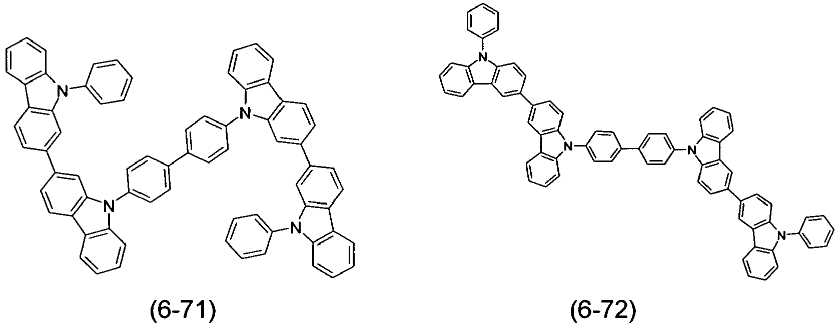

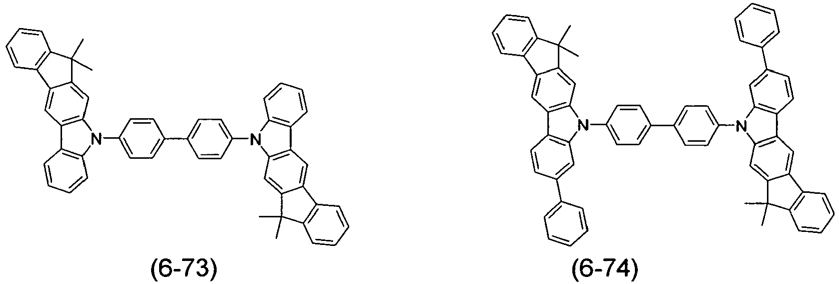

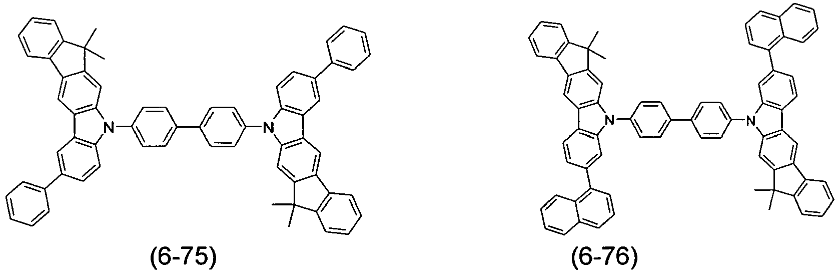

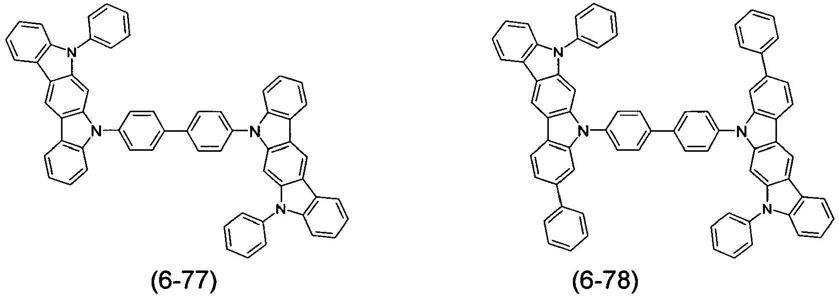

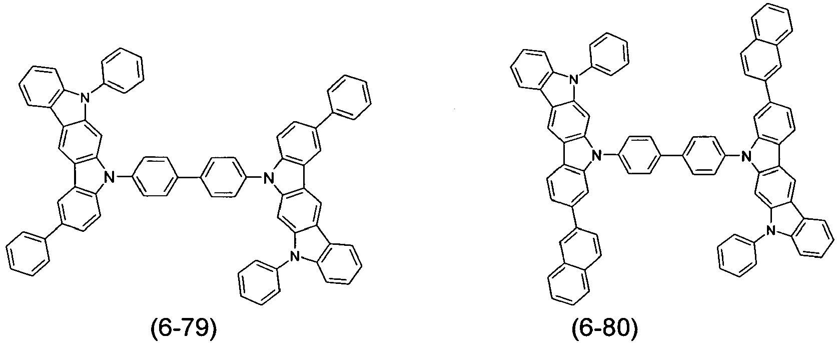

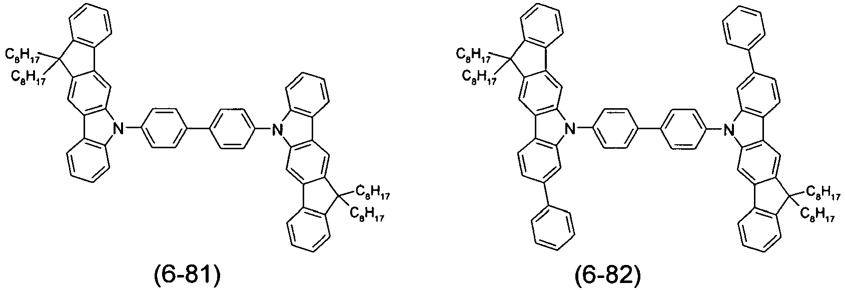

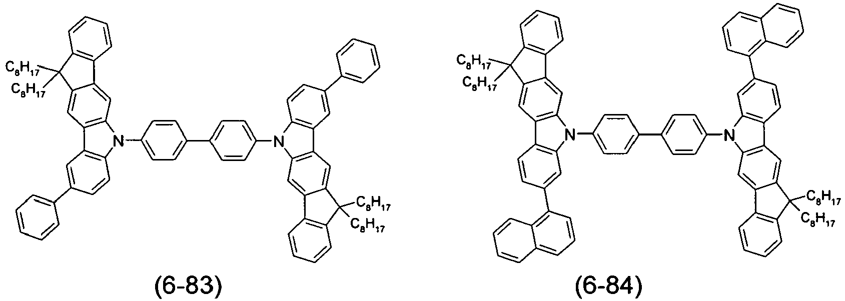

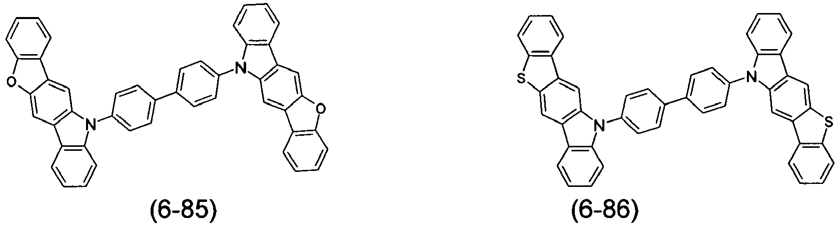

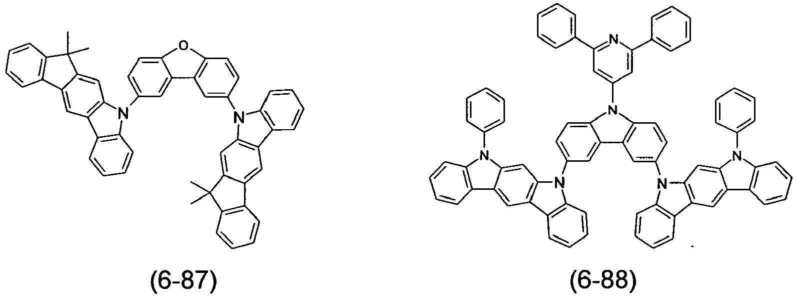

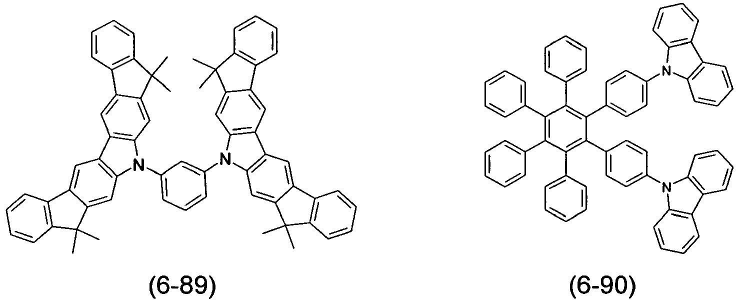

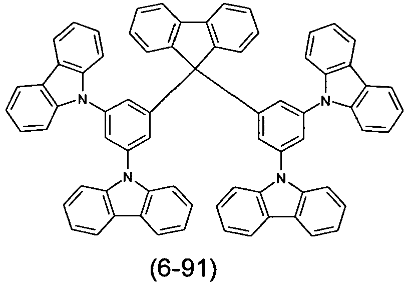

Die erfindungsgemäß eingesetzten Carbazolverbindungen gemäß Formel (6) können nach Standardmethoden der organischen Chemie synthetisiert werden, wie auch in der WO 2008/086851 ausführlich offenbart. Der Inhalt dieser Schrift ist via Zitat Bestandteil der vorliegenden Anmeldung.

So ist bekannt, dass 2-Nitrobiphenylderivate mit einem Trialkylphosphit zu den entsprechenden Carbazolderivaten umgesetzt werden können (M. Tavasli et al., Synthesis 2005, 1619-1624). Diese Reaktion lässt sich zum Aufbau von 2-Aryl-substituierten Carbazolderivaten verwenden, indem zunächst ein entsprechendes Aryl-substituiertes 2-Nitrobiphenylderivat aufgebaut wird, welches anschließend mit Trialkylphosphit umgesetzt wird. Das 2-Aryl-substituierte Carbazolderivat lässt sich mit einem Dibromaromaten in einer Hartwig-Buchwald-Kupplung unter Standardbedingungen zur Verbindung gemäß Formel (6) kuppeln. Die verschiedenen Ausführungsmethoden und Reaktionsbedingungen der Hartwig-Buchwald-Kupplung sind dem Fachmann der organischen Synthese bekannt. Statt eines Dibromaromaten lassen sich auch entsprechende Verbindungen mit anderen Abgangsgruppen, beispielsweise Chlor, Iod, Triflat, Tosylat oder allgemein Sulfonate, verwenden. Durch Verwendung von trisubstituierten Aromaten oder Verbindungen mit nochmals mehr Abgangsgruppen lassen sich entsprechend Verbindungen gemäß Formel (6) synthetisieren, in denen der Index q für 2 oder mehr steht.

Die Synthese von Verbindungen gemäß Formel (6) ist im folgenden Schema 1 abgebildet, wobei der Übersichtlichkeit halber q = 1 gewählt wurde und keine Substituenten R oder R⁷ abgebildet sind:

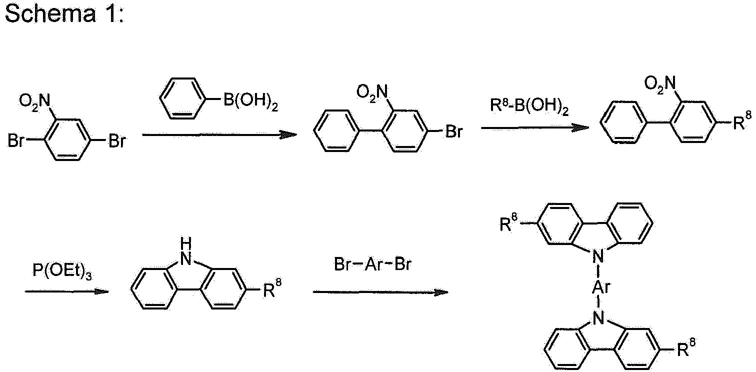

Eine neutrale Verbindung als Referenzmaterial in der vorliegenden Anmeldung ist bevorzugt eine reine Kohlenwasserstoffverbindung, insbesondere eine aromatische Kohlenwasserstoffverbindung.

Bevorzugt ist die neutrale Verbindung eine Verbindung gemäß Formel (7): 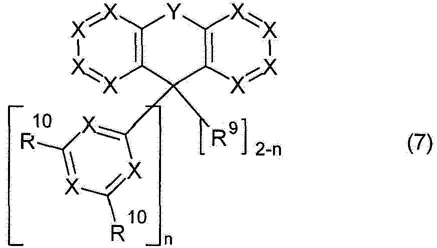 wobei für die verwendeten Symbole und Indices gilt:
- X: ist bei jedem Auftreten gleich oder verschieden CR⁹; oder zwei direkt benachbarte Gruppen X stehen für eine Einheit der folgenden Formel (8), 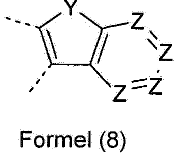 wobei die gestrichelten Bindungen die Verknüpfung der Einheit mit den benachbarten C-Atomen andeutet;
- Y: ist bei jedem Auftreten gleich oder verschieden eine Einfachbindung oder eine Gruppe ausgewählt aus C(R⁹)₂, C(=C(R⁹)₂), Si(R⁹)₂, C(R⁹)₂-C(R⁹)₂ oder CR⁹=CR⁹;
- Z: ist bei jedem Auftreten gleich oder verschieden CR⁹;
- R⁹: ist bei jedem Auftreten gleich oder verschieden H, D, eine geradkettige Alkyl-, Alkenyl- oder Alkinylgruppe mit 1 bis 40 C-Atomen oder eine verzweigte oder cyclische Alkyl-, Alkenyl- oder Alkinylgruppe mit 3 bis 40 C-Atomen, die jeweils mit einem oder mehreren Resten R¹¹ substituiert sein kann, oder ein aromatisches oder heteroaromatisches Ringsystem mit 5 bis 60 aromatischen Ringatomen, das jeweils durch einen oder mehrere Reste R¹⁰ substituiert sein kann, oder eine Kombination dieser Systeme; dabei können zwei oder mehrere benachbarte Substituenten R⁹ auch miteinander ein mono- oder polycyclisches, aliphatisches oder aromatisches Ringsystem bilden;
- R¹⁰: ist bei jedem Auftreten gleich oder verschieden H, D oder ein aromatisches oder heteroaromatisches Ringsystem mit 5 bis 60 aromatischen Ringatomen, welches durch einen oder mehrere Reste R⁹ substituiert sein kann;
- R¹¹: ist bei jedem Auftreten gleich oder verschieden H, D oder ein aliphatischer, aromatischer und/oder heteroaromatischer Kohlenwasserstoffrest mit 1 bis 20 C-Atomen, in dem auch H-Atome durch F ersetzt sein können; dabei können zwei oder mehrere benachbarte Substituenten R¹¹ auch miteinander ein mono- oder polycyclisches, aliphatisches oder aromatisches Ringsystem bilden; und
- n: ist 1 oder 2.

Bevorzugt weisen die neutralen Verbindungen und damit auch die Verbindungen gemäß Formel (7) eine Glasübergangstemperatur T_{g} von größer als 70°C, besonders bevorzugt von größer als 100°C und ganz besonders bevorzugt größer als 110°C, auf.

Wie aus der Formel (7) hervorgeht, bedeutet n = 2, dass in der Verbindung zwei Arylreste, welche in 3,5-Position substituiert sind, in der 9,9-Position des Fluorens bzw. des entsprechenden Derivats gebunden sind, während n = 1 bedeutet, dass ein solcher Arylrest vorhanden ist und weiterhin eine Gruppe R⁹.

In einer Ausführungsform steht vorzugsweise das Symbol X gleich oder verschieden bei jedem Auftreten für CR⁹.

Das Symbol Z in der Einheit gemäß Formel (7) steht vorzugsweise für CR⁹.

Eine bevorzugte Ausführungsform der Verbindungen gemäß Formel (7) sind die Verbindungen gemäß Formel (9), (10) und (11): 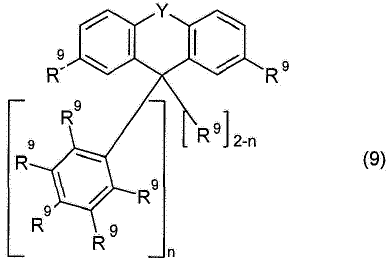 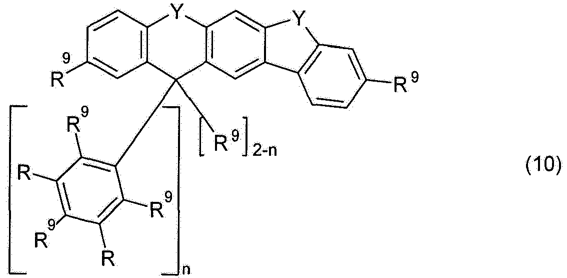 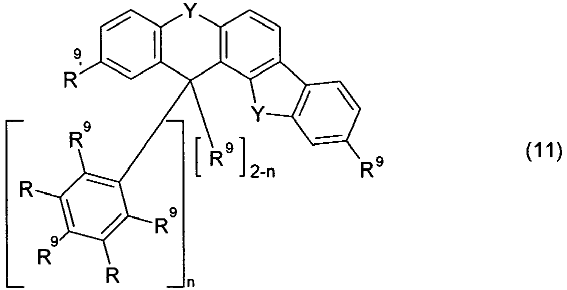 wobei die verwendeten Symbole und Indices die oben aufgeführten Bedeutungen haben.

Bevorzugt sind ferner die Verbindungen gemäß den Formeln (12), (13) und (14): 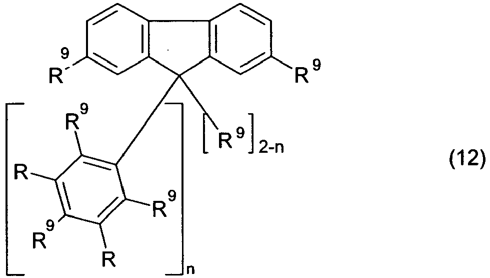 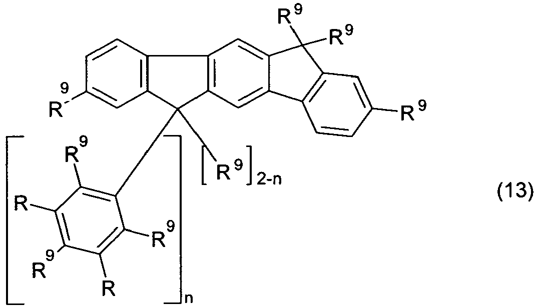 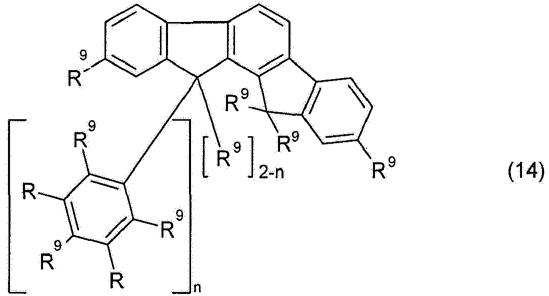 wobei die verwendeten Symbole und Indices die oben genannten Bedeutungen haben.

In einer bevorzugten Ausführungsform ist n = 2.

Eine weitere bevorzugte Ausführungsform der Verbindungen gemäß Formel (7) sind die Verbindungen gemäß Formel (15): 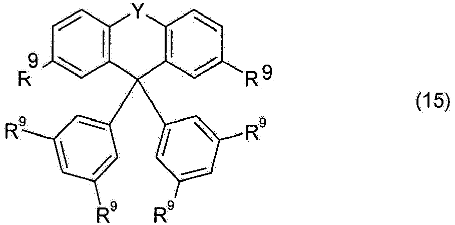 wobei die verwendeten Symbole die oben aufgeführten Bedeutungen haben.

Eine besonders bevorzugte Ausführungsform sind die Verbindungen der folgenden Formeln (16), (17) und (18) 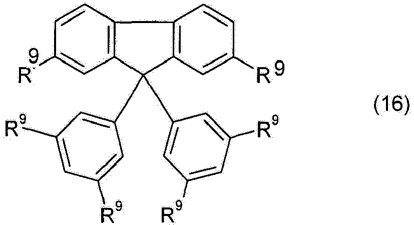 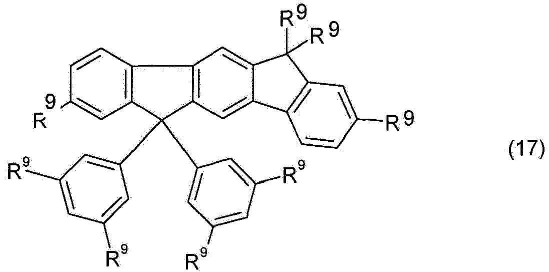 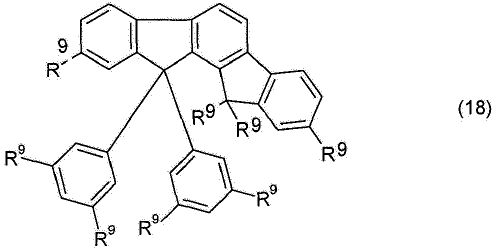 wobei die verwendeten Symbole und Indices die oben genannten Bedeutungen haben.

In einer weiteren Ausführungsform steht das Symbol R⁹ in Verbindungen der oben genannten Formel (7) bis (18) gleich oder verschieden bei jedem Auftreten für ein aromatisches oder hetero-aromatisches Ringsystem mit 5 bis 30 aromatischen Ringatomen, welches durch einen oder mehrere nicht-aromatische Reste R⁹ substituiert sein kann. Weiterhin bevorzugte Substituenten R⁹ sind Halogen, vorzugsweise Br und I, O-Tosylat, O-Triflat, O-SO₂R¹¹, B(OR¹¹)₂ und Sn(R¹¹)₃, besonders bevorzugt Br, da dies wertvolle Intermediate bei der Synthese weiterer erfindungsgemäßer Verbindungen sind.

In einer weiteren bevorzugten Ausführungsform sind alle Symbole R⁹ in Verbindungen der oben genannten Formeln (7) bis (18) gleich gewählt. Diese Bevorzugung lässt sich durch die leichtere synthetische Zugänglichkeit der Verbindungen erklären.

Beispiele für bevorzugte Verbindungen gemäß den Formeln (7) bis (18) sind die im Folgenden abgebildeten Strukturen (7-1) bis (7-32).

| | |
|---|---|
| 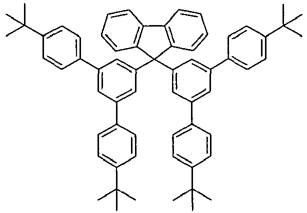 | 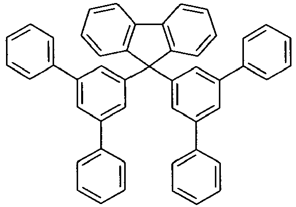 |
| (7-1) | (7-2) |
| 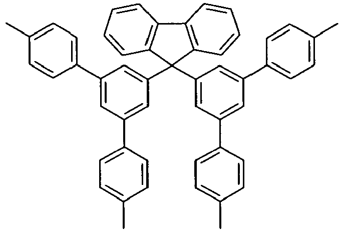 | 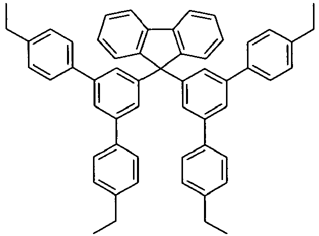 |
| (7-3) | (7-4) |
| 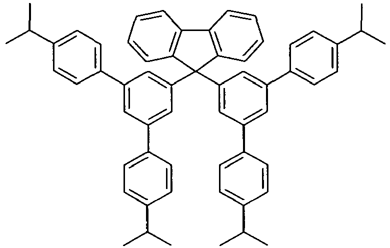 | 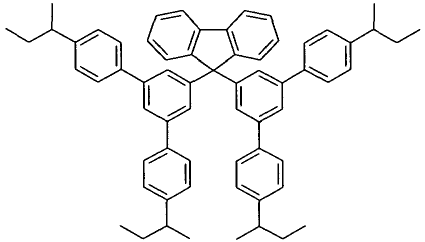 |
| (7-5) | (7-6) |
| 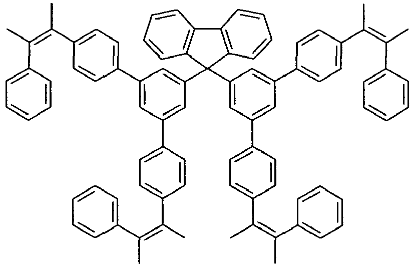 | 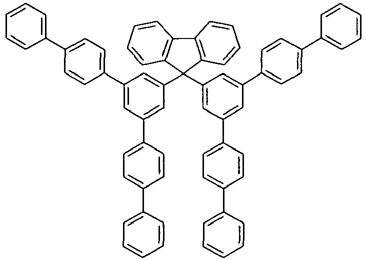 |
| (7-7) | (7-8) |
| 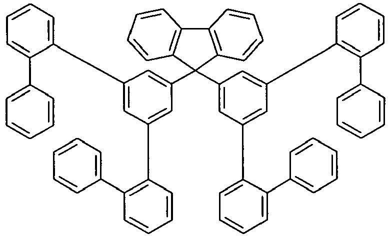 | 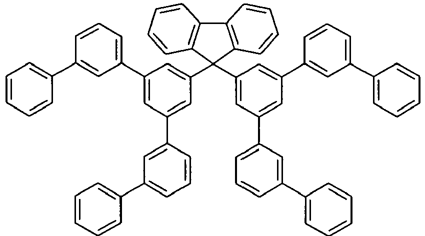 |
| (7-9) | (7-10) |
| 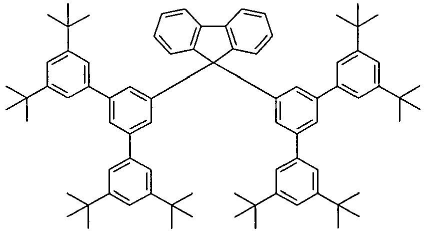 | 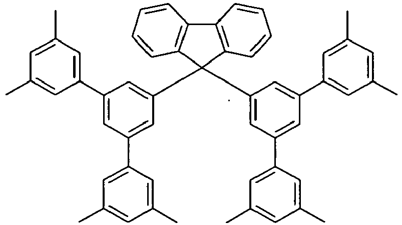 |
| (7-11) | (7-12) |
| 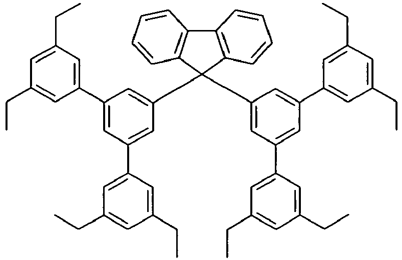 | 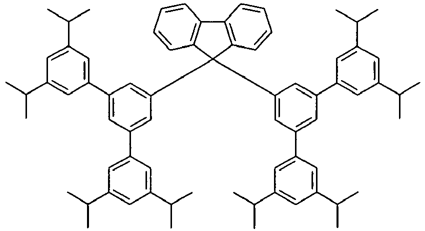 |
| (7-13) | (7-14) |
| 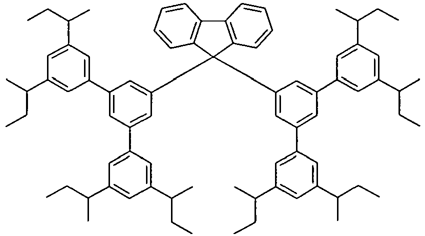 | 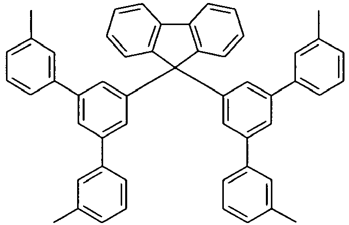 |
| (7-15) | (7-16) |
| 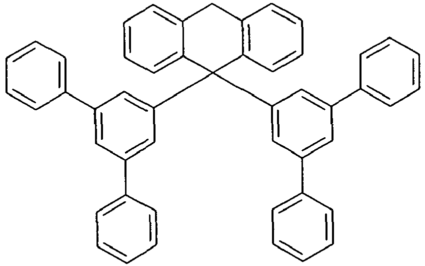 | 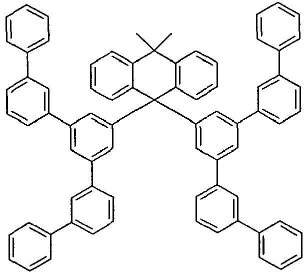 |
| (7-17) | (7-18) |
| 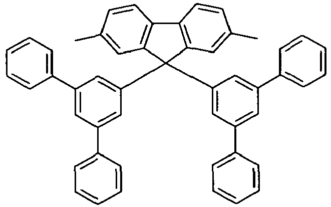 | 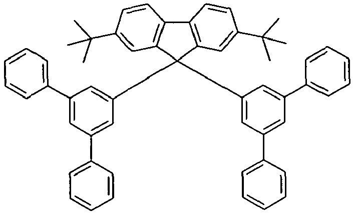 |
| (7-19) | (7-20) |
| 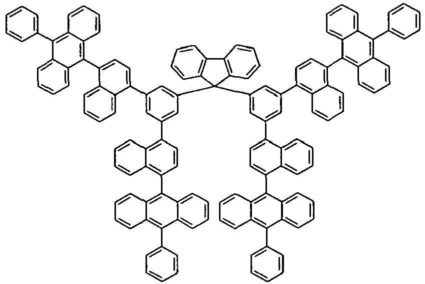 | 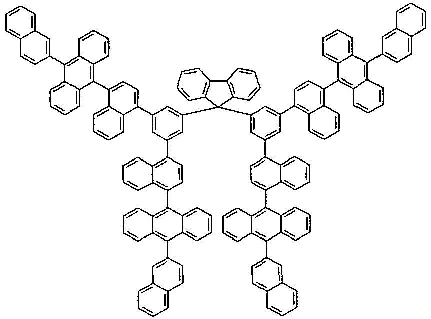 |
| 7-21 | (7-22) |
| 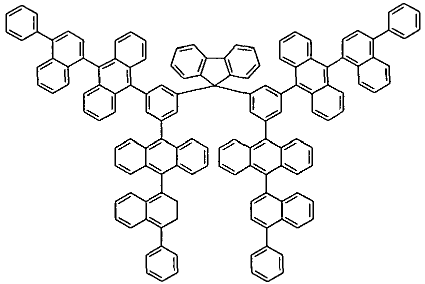 | 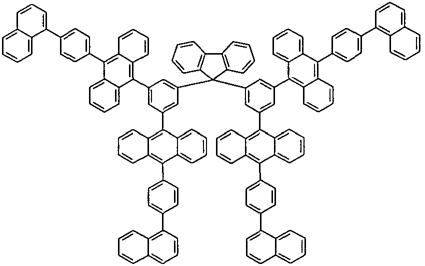 |
| (7-23) | (7-24) |
| 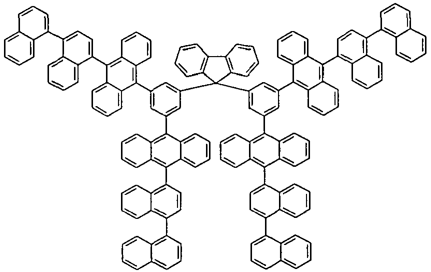 | 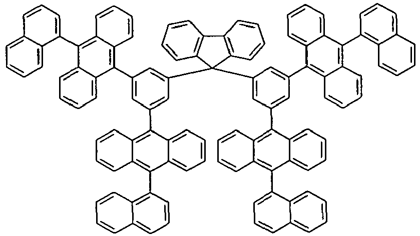 |
| (7-25) | (7-26) |
| 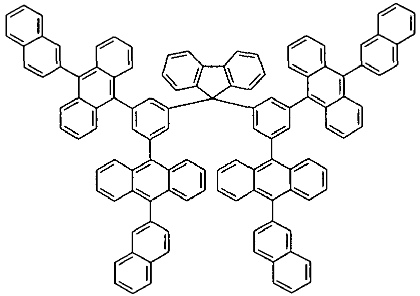 | 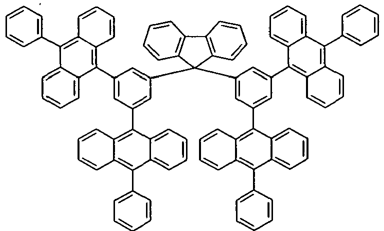 |
| (7-27) | (7-28) |
| 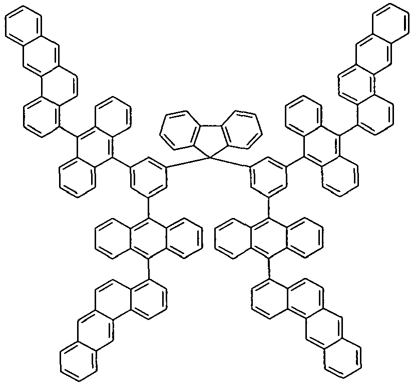 | 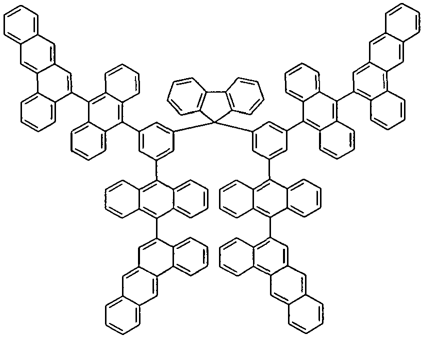 |
| (7-29) | (7-30) |
| 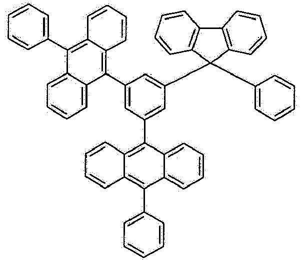 | 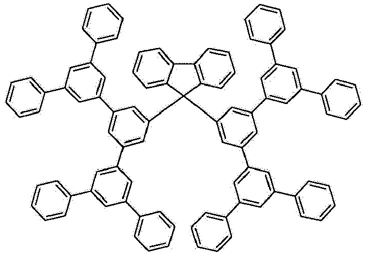 |
| (7-31) | (7-32) |

Gemäß einer weiteren Ausführungsform ist die neutrale Verbindung eine Verbindung gemäß Formel (19): 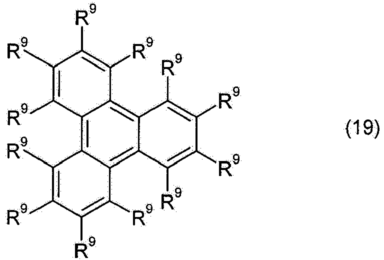 wobei R⁹ die in Bezug auf Formel (7) angegebenen Bedeutungen annehmen kann.

Gemäß noch einer weiteren Ausführungsform ist die neutrale Verbindung eine Verbindung gemäß Formel (20): 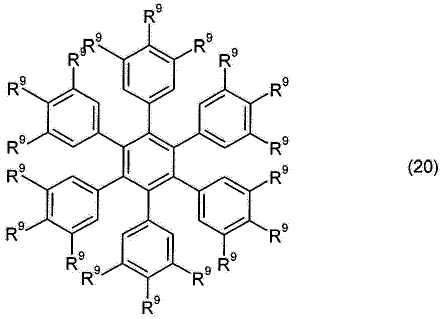 wobei R⁹ die in Bezug auf Formel (7) angegebenen Bedeutungen annehmen kann.

Eine besonders bevorzugte neutrale Verbindung der Formel (20) ist die folgende Struktur:

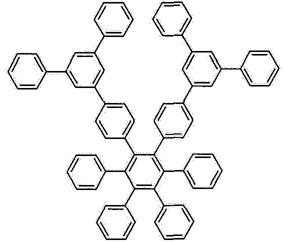

Die Verbindungen gemäß Formel (7) können nach dem Fachmann allgemein bekannten Syntheseschritten dargestellt werden. Als Ausgangsverbindung zu symmetrisch substituierten erfindungsgemäßen Verbindungen kann z.B. 3,3',5,5'-Tetrabrombenzophenon (Eur. J. Org. Chem. 2006, 2523-2529) dienen. Dieses kann z.B. gemäß Schema 2 durch Umsetzung mit einem substituierten oder unsubstituierten 2-Lithiobiphenyl, 2-Lithiodiphenylether, 2-Lithiodiphenylthioether, 2-(2-Lithiophenyl)-2-phenyl-1,3-dioxolan oder 2-Lithiophenyldiphenylamin zu den entsprechenden Triarylmethanolen umgesetzt werden, die dann sauer, z.B. in Gegenwart von Essigsäure und einer Mineralsäure wie Bromwasserstoff, cyclisiert werden. Die für diese Umsetzung benötigten Organolithiumverbindungen können durch Transmetallierung der entsprechenden Arylbromide (2-Brombiphenyl, 2-Bromdiphenylether, 2-Bromdiphenylthioether, 2-(2-Bromphenyl)-2-phenyl-1,3-dioxolan, 2-Bromphenyl-diphenylamin, etc.) mit Alkyllithiumverbindungen, wie *n*-Butyllithium, dargestellt werden. Analog dazu ist es selbstverständlich möglich, die entsprechenden Grignard-Verbindungen einzusetzen.

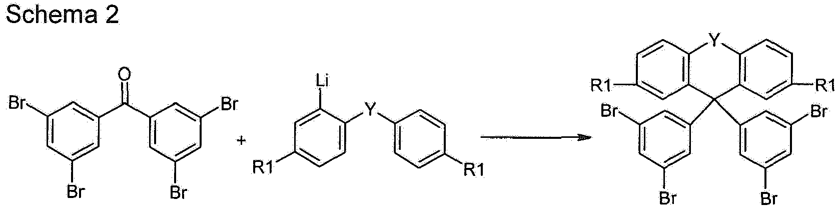

Die so erzeugten Tetrabromide können nach dem Fachmann bekannten Methoden weiter umgewandelt werden. Die palladiumkatalysierte Umsetzung mit Boronsäuren (Suzuki-Kuppung) oder palladiumkatalysierte Umsetzung mit Organozinkverbindungen (Negishi-Kupplung) führt zu erfindungsgemäßen aromatischen oder heteroaromatischen Verbindungen (Schema 3).

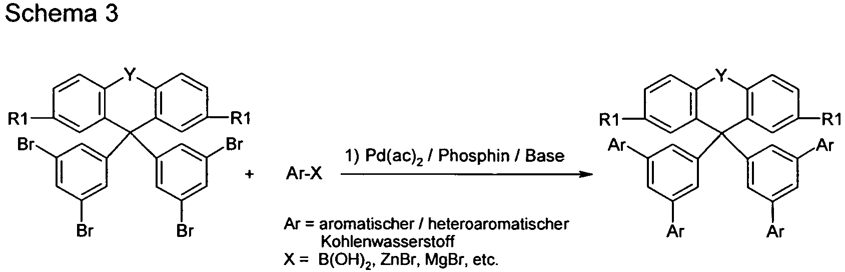

Die Bromfunktion kann durch Transmetallierung mit Organolithiumverbindungen bzw. Grignardverbindungen in eine elektrophile Gruppe überführt werden, die dann mit einer Vielzahl von Elektrophilen, wie z.B. Aryl-Bor-Halogeniden, Aldehyden, Ketonen, Nitrilen, Estern, Halogenestern, Kohlendioxid, Arylphosphinhalogeniden, Halogensulfinsäuren, Halogenarylsulfonsäuren, etc., gekoppelt werden, wobei die so erhaltenen Verbindungen erfindungsgemäße Endprodukte oder aber Intermediate sein können, die weiter umgesetzt werden können.

Unsymmetrisch substituierte erfindungsgemäße Verbindungen können durch die Sequenz gemäß Schema 4 ausgehend von Fluorenon und analogen Arylketonen durch Addition einer Aryl-Metallverbindung, z.B. 1-Lithio-3,5-dibrombenzol, an die Carbonylfunktion, Umwandlung des Bromaromaten nach einer der oben genannten Methoden unter Aufbau der einen Funktionalität und anschließender Einführung der anderen Funktionalität via säurekatalysierter Friedel-Crafts-Arylierung an 1,3-Dibrombenzol und Umwandlung des Bromaromaten nach einer der oben genannten Methoden erhalten werden (s. z.B. Org. Lett. 2001, 3(15), 2285.).

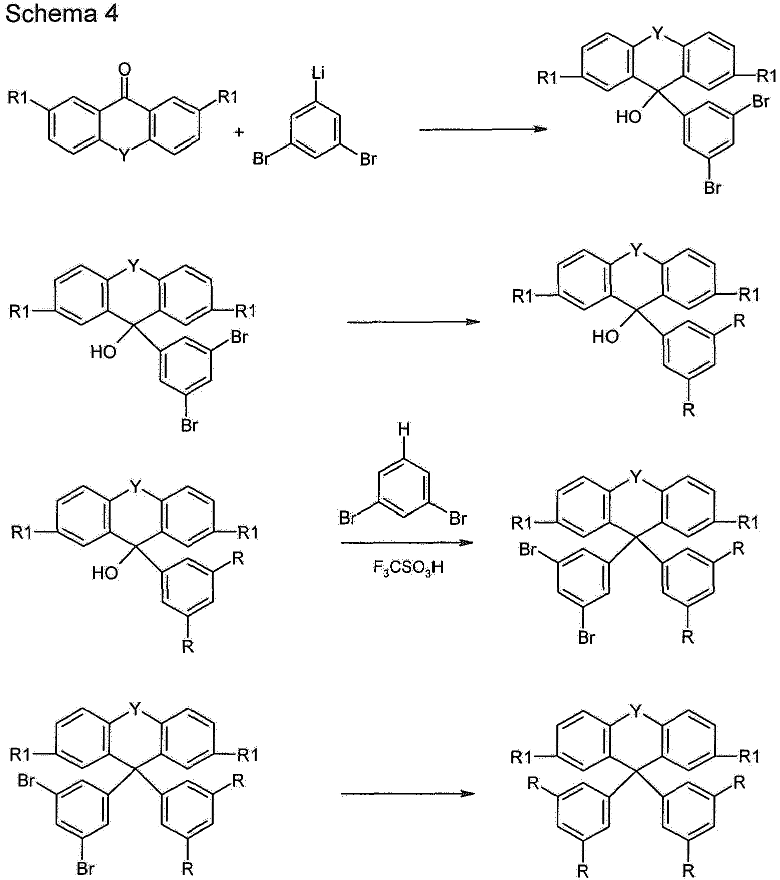

Die entsprechenden Indenofluorenderivate, Indenocarbazolderivate und die weiteren Derivate der Formel (7) lassen sich entsprechend synthetisieren.

Die oben beschriebenen eingesetzten Verbindungen, insbesondere Verbindungen, welche mit reaktiven Abgangsgruppen, wie Brom, Iod, Triflat, Tosylat, Boronsäure oder Boronsäureester, substituiert sind, können als Monomere zur Erzeugung entsprechender Dimere, Trimere, Tetramere, Pentamere, Oligomere, Polymere oder als Kern von Dendrimeren Verwendung finden. Die Oligomerisation bzw. Polymerisation erfolgt dabei vorzugsweise über die Halogenfunktionalität bzw. die Boronsäurefunktionalität.

Wie oben bereits ausgeführt, enthält die erfindungsgemäße Mischung auch eine Triplett-Emitter-Verbindung. Eine Triplett-Emitter-Verbindung (phosphoreszierende Verbindung) im Sinne der vorliegenden Erfindung ist eine Verbindung, welche bei Raumtemperatur Lumineszenz aus einem angeregten Zustand mit höherer Spinmultiplizität zeigt, also einem Spinzustand > 1, insbesondere aus einem angeregten Triplettzustand.

Als Triplett-Emitterverbindung enthalten die erfindungsgemäßen Mischungen eine Verbindung der Formel (22), 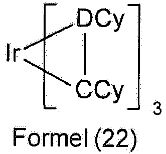 wobei für die verwendeten Symbole gilt:
- DCy: ist gleich oder verschieden bei jedem Auftreten eine cyclische Gruppe, die mindestens ein Donoratom, vorzugsweise Stickstoff, Kohlenstoff in Form eines Carbens oder Phosphor, enthält, über welches die cyclische Gruppe an das Metall gebunden ist, und die wiederum einen oder mehrere Substituenten R¹ (wie oben definiert) tragen kann; die Gruppen DCy und CCy sind über eine kovalente Bindung miteinander verbunden;
- CCy: ist gleich oder verschieden bei jedem Auftreten eine cyclische Gruppe, die ein Kohlenstoffatom enthält, über welches die cyclische Gruppe an das Metall gebunden ist und die wiederum einen oder mehrere Substituenten R³ tragen kann; und
- R¹: hat bei jedem Auftreten gleich oder verschieden die Bedeutung des Restes R¹, wie oben definiert.

Dabei kann durch Bildung von Ringsystemen zwischen mehreren Resten R¹ auch eine Brücke zwischen den Gruppen DCy und CCy vorliegen. Weiterhin kann durch Bildung von Ringsystemen zwischen mehreren Resten R¹ auch eine Brücke zwischen zwei oder drei Liganden CCy-DCy vorliegen, so dass es sich um ein polydentates bzw. polypodales Ligandensystem handelt.

Beispiele der oben beschriebenen Emitter können der WO 00/70655, der WO 01/41512, der WO 02/02714, der WO 02/15645, der EP 1191613, der EP 1191612, der EP 1191614, der WO 04/081017, der WO 05/033244, der WO 05/042550, der WO 05/113563, der WO 06/008069, der WO 06/061182, der WO 06/081973, der DE 102008015526, der DE 102008027005 und der DE 102009007038 entnommen werden. Generell eignen sich alle phosphoreszierenden Komplexe, wie sie gemäß dem Stand der Technik für phosphoreszierende OLEDs oder PLEDs verwendet werden und wie sie dem Fachmann auf dem Gebiet der organischen Elektrolumineszenz bekannt sind, und der Fachmann kann ohne erfinderisches Zutun weitere phosphoreszierende Verbindungen verwenden. Insbesondere ist dem Fachmann bekannt, welche phosphoreszierenden Komplexe mit welcher Emissionsfarbe emittieren.

Beispiele für geeignete phosphoreszierende Verbindungen sind die in der folgenden Tabelle aufgeführten Strukturen (T-1) bis (T-140).

| | | |
|---|---|---|
| 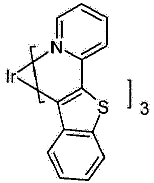 | | 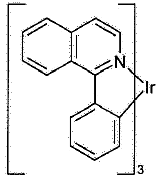 |
| (T-1) | | (T-3) |
| 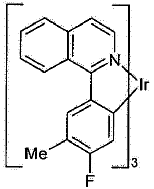 | 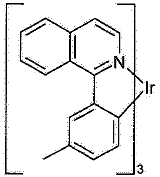 | 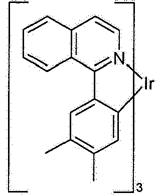 |
| (T-4) | (T-5) | (T-6) |
| 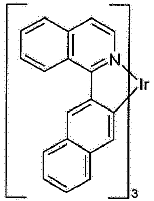 | 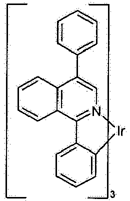 | 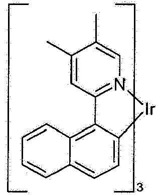 |
| (T-7) | (T-8) | (T-9) |
| 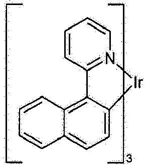 | 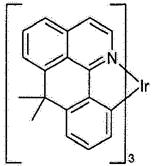 | 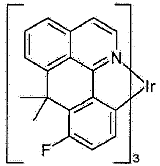 |
| (T-10) | (T-11) | (T-12) |
| 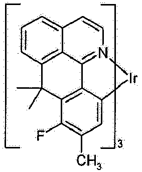 | 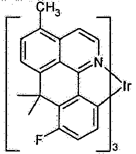 | 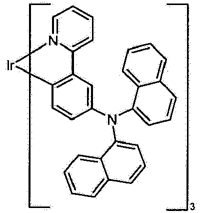 |
| (T-13) | (T-14) | (T-15) |
| 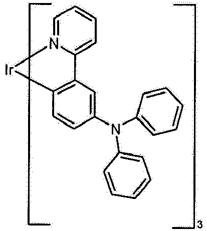 | 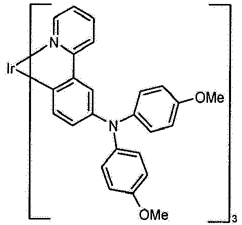 | 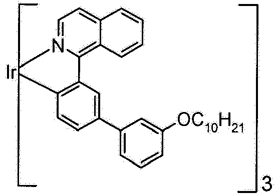 |
| (T-16) | (T-17) | (T-18) |
| 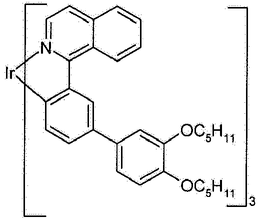 | 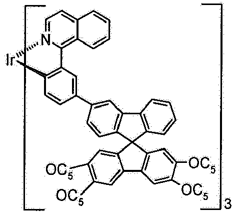 | 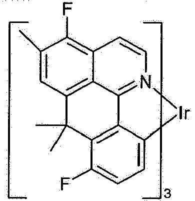 |
| (T-19) | (T-20) | (T-21) |
| 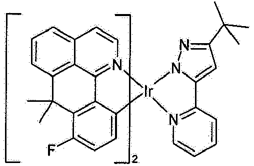 | 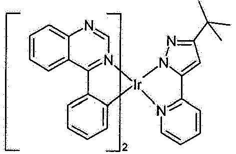 | |
| (T-22) | (T-23) | |
| | | 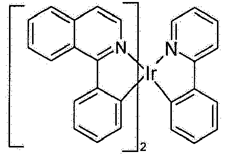 |
| | | (T-27) |
| | 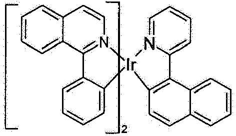 | |
| | (T-29) | |
| 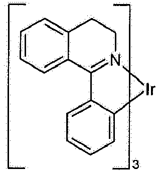 | | 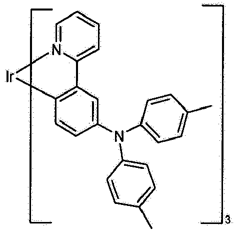 |
| (T-31) | | (T-33) |
| 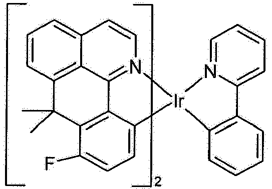 | 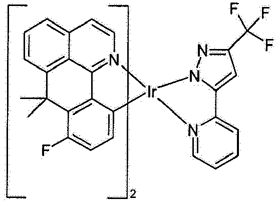 | 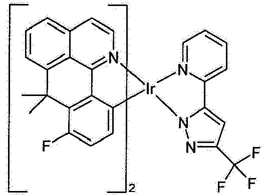 |
| (T-34) | (T-35) | (T-36) |
| 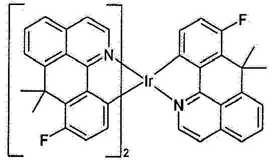 | 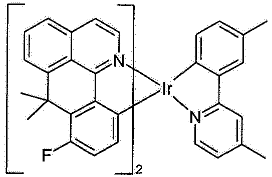 | 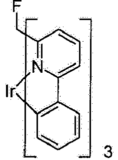 |
| (T-37) | (T-38) | (T-39) |
| 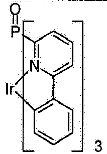 | | 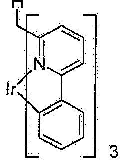 |
| (T-40) | | (T-42) |
| 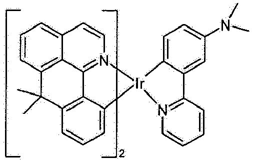 | 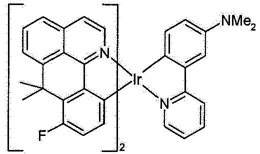 | 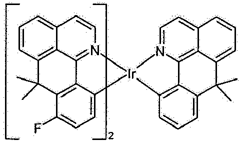 |
| (T-43) | (T-44) | (T-45) |
| 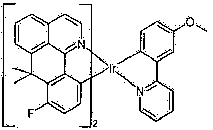 | 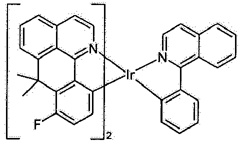 | 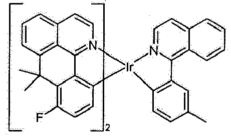 |
| (T-46) | (T-47) | (T-48) |
| | 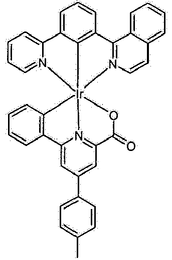 | |
| | (T-50) | |
| 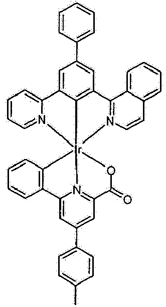 | | |
| (T-52) | | |
| 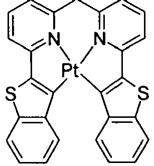 | 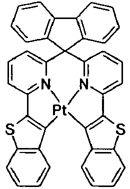 | 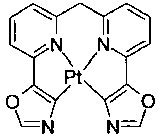 |
| (T-55) | (T-56) | (T-57) |
| 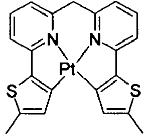 | 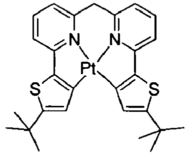 | 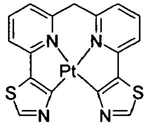 |
| (T-58) | (T-59) | (T-60) |
| 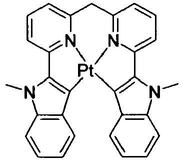 | 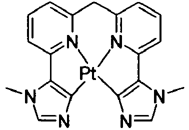 | 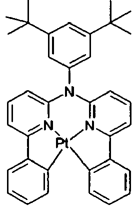 |
| (T-61) | (T-62) | (T-63) |
| 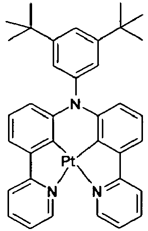 | 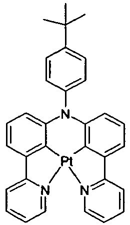 | 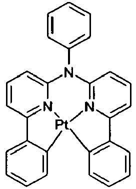 |
| (T-64) | (T-65) | (T-66) |
| 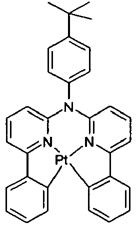 | 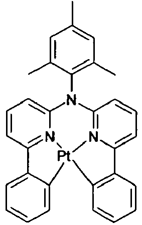 | 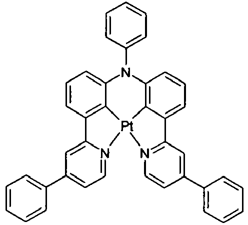 |
| (T-67) | (T-68) | (T-69) |
| 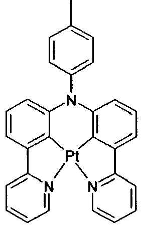 | 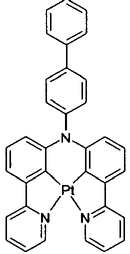 | 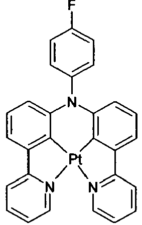 |
| (T-70) | (T-71) | (T-72) |
| 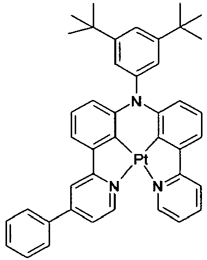 | 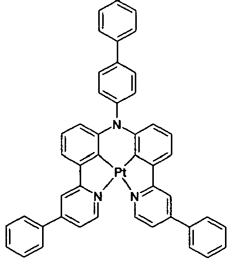 | 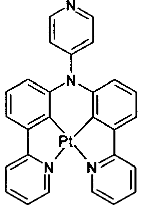 |
| (T-73) | (T-74) | (T-75) |
| 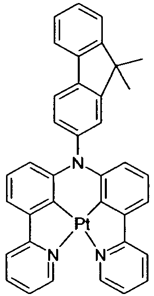 | 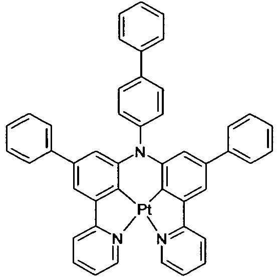 | 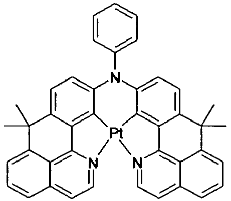 |
| (T-76) | (T-77) | (T-78) |
| 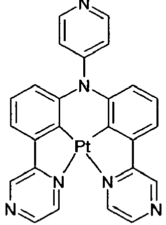 | 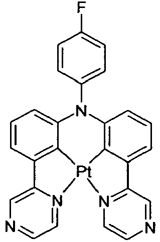 | 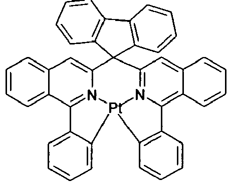 |
| (T-79) | (T-80) | (T-81) |
| 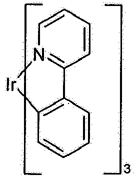 | 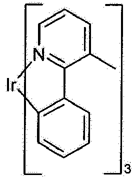 | 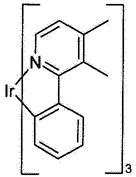 |
| (T-91) | (T-92) | (T-93) |
| 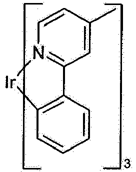 | 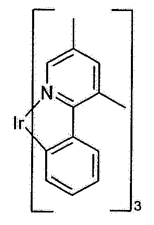 | 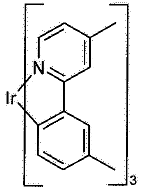 |
| (T-94) | (T-95) | (T-96) |
| 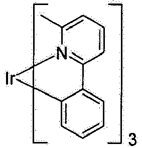 | | |
| (T-97) | | |
| | | 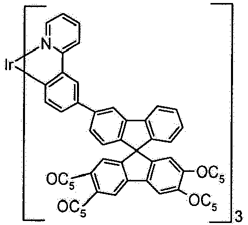 |
| | | (T-102) |
| 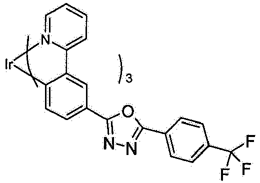 | 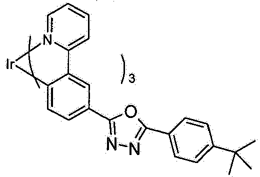 | 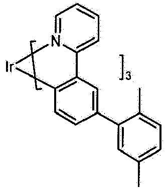 |
| (T-103) | (T-104) | (T-105) |
| 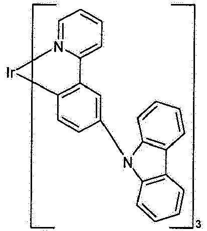 | 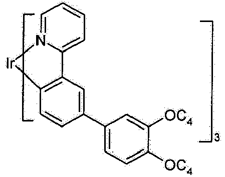 | |
| (T-106) | (T-107) | |
| | | 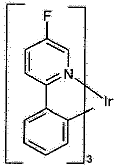 |
| | | (T-111) |
| | 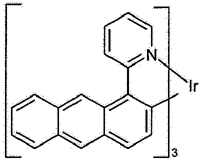 | |
| | (T-113) | |
| | | |
| | | |
| | | |
| | | |
| | | 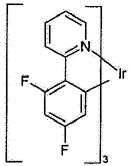 |
| | | (T-123) |
| 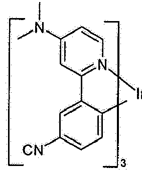 | 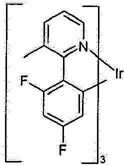 | 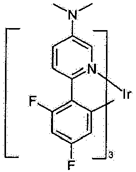 |
| (T-124) | (T-125) | (T-126) |
| 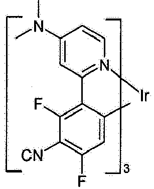 | 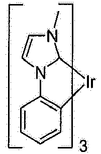 | 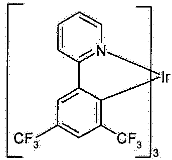 |
| (T-127) | (T-128) | (T-129) |
| 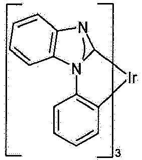 | | 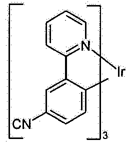 |
| (T-130) | | (T-132) |
| 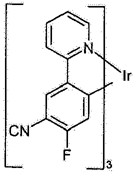 | 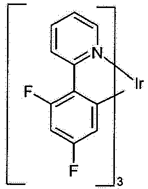 | 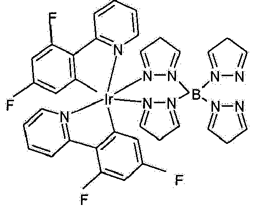 |
| (T-133) | (T-134) | (T-135) |
| | | 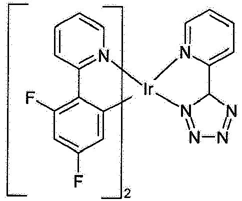 |
| | | (T-138) |
| 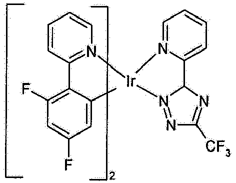 | 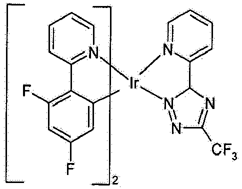 | |
| (T-139) | (T-140) | |

Die erfindungsgemäße Mischung enthält vorzugsweise:
a) 1 bis 70 Gew.-%, besonders bevorzugt 5 bis 60 Gew.-% und ganz besonders bevorzugt 10 bis 50 Gew.-% des Polymers mit mindestens einer L=X Struktureinheit,
b) 0,1 bis 40 Gew.-%, besonders bevorzugt 0,5 bis 30 Gew.-% und ganz besonders bevorzugt 1 bis 25 Gew.-% Triplett-Emitter,
c) 1 bis 70 Gew.-%, besonders bevorzugt 5 bis 60 Gew.-% und ganz besonders bevorzugt 10 bis 50 Gew.-% Carbazolverbindung.

In einer weiteren Ausführungsform der vorliegenden Erfindung enthält die Mischung ferner ein oder mehrere Lösungsmittel. Die Mischung liegt damit als Formulierung vor. Die Formulierung eignet sich hervorragend zum Erzeugen von Schichten aus Lösung.

Geeignete und bevorzugte Lösungsmittel sind beispielsweise Toluol, Anisol, Xylole, Methylbenzoat, Dimethylanisole, Trimethylbenzole, Tetralin, Veratrole, Tetrahydrofuran, Chlorbenzol oder Dichlorbenzol sowie Gemische derselben.

Die erfindungsgemäße Mischung eignet sich für den Einsatz in organischen Elektrolumineszenzvorrichtungen (OLEDs, PLEDs), insbesondere in einer Lumineszenzschicht solcher Vorrichtungen.

Ein weiterer Gegenstand der vorliegenden Erfindung ist daher die Verwendung der erfindungsgemäßen Mischung in organischen elektronischen Vorrichtungen.

Die elektronische Vorrichtung ist dabei ausgewählt aus der Gruppe bestehend aus organischen Elektrolumineszenzvorrichtungen (OLEDs, PLEDs), organischen Feld-Effekt-Transistoren (O-FETs), organischen Dünnfilmtransistoren (O-TFTs), organischen lichtemittierenden Transistoren (O-LETs), organischen integrierten Schaltungen (O-ICs), organischen Solarzellen (O-SCs), organischen Feld-Quench-Devices (O-FQDs), lichtemittierenden elektrochemischen Zellen (LECs), organischen Photorezeptoren, organischen Laserdioden (O-Laser) oder optisch gepumpten organischen Lasern.

Besonders bevorzugt ist dabei die Verwnedung der erfindungsgemäßen Mischung in organischen Elektrolumineszenzvorrichtungen.

Nochmals ein weiterer Gegenstand der vorliegenden Erfindung sind organische elektronische Vorrichtungen, enthaltend die erfindungsgemäße Mischung, insbesondere organische Elektrolumineszenzvorrichtungen, enthaltend Anode, Kathode und mindestens eine emittierende Schicht, die dadurch gekennzeichnet ist, dass mindestens eine Schicht eine erfindungsgemäße Mischung enthält.

Außer Kathode, Anode und der mindestens einen emittierenden Schicht, die oben beschrieben wurde, kann die organische Elektrolumineszenzvorrichtung noch weitere Schichten enthalten. Diese sind beispielsweise ausgewählt aus jeweils einer oder mehreren Lochinjektionsschichten, Lochtransportschichten, Lochblockierschichten, Elektronentransportschichten, Elektroneninjektionsschichten, Elektronenblockierschichten, Excitonenblockierschichten, Ladungserzeugungsschichten (Charge-Generation Layers) und/oder organischen oder anorganischen p/n-Übergängen. Außerdem können Interlayers vorhanden sein, welche beispielsweise die Ladungsbalance im Device steuern. Insbesondere können solche Interlayers als Zwischenschicht zwischen zwei emittierenden Schichten sinnvoll sein, insbesondere als Zwischenschicht zwischen einer fluoreszierenden und einer phosphoreszierenden Schicht. Weiterhin können die Schichten, insbesondere die Ladungstransportschichten, auch dotiert sein. Die Dotierung der Schichten kann für einen verbesserten Ladungstransport vorteilhaft sein. Es sei aber darauf hingewiesen, dass nicht notwendigerweise jede der oben genannten Schichten vorhanden sein muss und die Wahl der Schichten immer von den verwendeten Verbindungen abhängt. Die Verwendung derartiger Schichten ist dem Fachmann bekannt, und er kann hierfür ohne erfinderisches Zutun alle für derartige Schichten bekannten Materialien gemäß dem Stand der Technik verwenden.

Weiterhin ist es möglich, mehr als eine emittierende Schicht zu verwenden, beispielsweise zwei oder drei emittierende Schichten, wobei diese vorzugsweise unterschiedliche Emissionsfarben aufweisen. In einer besonders bevorzugten Auführungsform der vorliegenden Erfindung handelt es sich um eine weiß emittierende organische Elektrolumineszenzvorrichtung. Diese ist dadurch gekennzeichnet, dass sie Licht mit CIE-Farbkoordinaten im Bereich von 0,28/0,29 bis 0,45/0,41 emittiert. Der allgemeine Aufbau einer derartigen weiß emittierenden Elektrolumineszenzvorrichtung wird beispielsweise in der WO 05/011013 offenbart.

Als Kathode der erfindungsgemäßen Elektrolumineszenzvorrichtung sind Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lanthanoide (z.B. Ca, Ba, Mg, AI, In, Mg, Yb und Sm). Bei mehrlagigen Strukturen können auch zusätzlich zu den genannten Metallen weitere Metalle verwendet werden, die eine relativ hohe Austrittsarbeit aufweisen, wie z.B. Ag, wobei dann in der Regel Kombinationen der Metalle, wie beispielsweise Ca/Ag oder Ba/Ag verwendet werden. Ebenso bevorzugt sind Metalllegierungen, insbesondere Legierungen aus einem Alkalimetall oder Erdalkalimetall und Silber, besonders bevorzugt eine Legierung aus Mg und Ag. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide oder Carbonate in Frage (z.B. LiF, Li₂O, CsF, CS₂CO₃, BaF₂, MgO und NaF). Die Schichtdicke dieser Schicht liegt vorzugsweise zwischen 0,5 und 5 nm.

Als Anode der erfindungsgemäßen Elektrolumineszenzvorrichtung sind Materialien mit hoher Austrittsarbeit bevorzugt. Bevorzugt weist die Anode eine Austrittsarbeit größer 4,5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektroden (z.B. Al/Ni/NiOₓ, Al/PtOₓ) bevorzugt sein. Dabei muss mindestens eine der Elektroden transparent sein, um die Auskopplung von Licht zu ermöglichen. Ein bevorzugter Aufbau verwendet eine transparente Anode. Bevorzugte Anodenmaterialien sind hier leitfähige gemischte Metalloxide.

Besonders bevorzugt sind Indium-Zinn-Oxid (ITO) oder Indium-Zink Oxid (IZO). Bevorzugt sind weiterhin leitfähige, dotierte organische Materialien, insbesondere leitfähige dotierte Polymere.

Die Vorrichtung wird entsprechend (je nach Anwendung) strukturiert, kontaktiert und schließlich hermetisch versiegelt, da sich die Lebensdauer derartiger Vorrichtungen bei Anwesenheit von Wasser und/oder Luft drastisch verkürzt.

Es können generell alle weiteren Materialien, wie sie gemäß dem Stand der Technik in organischen Elektrolumineszenzvorrichtungen eingesetzt werden, in Kombination mit der erfindungsgemäßen Mischung in der emittierenden Schicht eingesetzt werden.

Ganz besonders bevorzugt ist eine organische Elektrolumineszenzvorrichtung, die dadurch gekennzeichnet ist, dass eine oder mehrere Schichten aus Lösung, wie z.B. durch Spincoating, oder mit einem beliebigen Druckverfahren, wie z.B. Siebdruck, Flexodruck oder Offsetdruck, besonders bevorzugt aber LITI (Light Induced Thermal Imaging, Thermotransferdruck) oder Ink-Jet Druck (Tintenstrahldruck), hergestellt werden. Hierfür sind lösliche Systeme nötig, wie sie durch die erfindungsgemäße Mischung bereitgestellt werden.

Die organische Elektrolumineszenzvorrichtung kann auch als Hybridsystem hergestellt werden, indem eine oder mehrere Schichten aus Lösung aufgebracht werden und eine oder mehrere weitere Schichten aufgedampft werden.

Weiterhin bevorzugt ist somit eine organische Elektrolumineszenzvorrichtung, die dadurch gekennzeichnet ist, dass eine oder mehrere Schichten mit einem Sublimationsverfahren beschichtet werden. Dabei werden die Materialien in Vakuum-Sublimationsanlagen bei einem Anfangsdruck kleiner 10⁻⁵ mbar, vorzugsweise kleiner 10⁻⁶ mbar aufgedampft. Es sei jedoch angemerkt, dass der Anfangsdruck auch noch geringer sein kann, beispielsweise kleiner 10⁻⁷ mbar.

Bevorzugt ist ebenfalls eine organische Elektrolumineszenzvorrichtung, die dadurch gekennzeichnet ist, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen 10⁻⁵ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z.B. M. S. Arnold et al., Appl. Phys. Lett. 2008, 92, 053301).

Diese Verfahren sind dem Fachmann generell bekannt und können von ihm ohne erfinderisches Zutun auf die erfindungsgemäßen organischen Elektrolumineszenzvorrichtungen angewandt werden.

Die erfindungsgemäßen organischen Elektrolumineszenzvorrichtungen weisen folgende überraschende Vorteile gegenüber dem Stand der Technik auf:
1. Die erfindungsgemäße organische Elektrolumineszenzvorrichtung weist eine sehr hohe Effizienz auf.
2. Die erfindungsgemäße organische Elektrolumineszenzvorrichtung weist gleichzeitig eine verbesserte Lebensdauer auf.

Die Erfindung wird durch die nachfolgenden Beispiele genauer beschrieben, ohne sie dadurch einschränken zu wollen. Der Fachmann kann, ohne erfinderisch tätig zu werden, weitere erfindungsgemäße organische Elektrolumineszenzvorrichtungen herstellen.

### Ausführungsbeispiele

### Beispiele 1 bis 7: Herstellung der Monomere

Die nachfolgenden Synthesen werden, sofern nicht anders angegeben, unter einer Schutzgasatmosphäre in getrockneten Lösungsmitteln durchgeführt. Edukte, Monomer **M6** und Lösungsmittel können kommerziell (z.B von Merck) bezogen werden. Verbindung **1** kann analog zu der WO 2004/041091 hergestellt werden. Monomer **M4** kann nach Org. Lett., 10, 23, 5429-5432, 2008 hergestellt werden und Monomer **M5** kann nach Org. Lett., 7, 24, 5361-5364, 2005 hergestellt werden.

### Beispiel 1

### Herstellung von Verbindung 4 (M1)

Die Verbindung **4** wird wie folgt hergestellt:

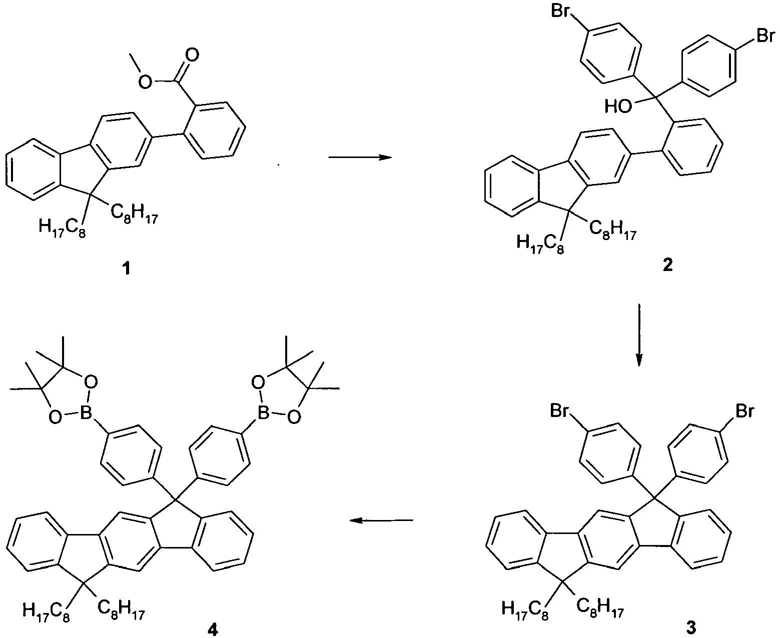

### 1.1 Verbindung 2

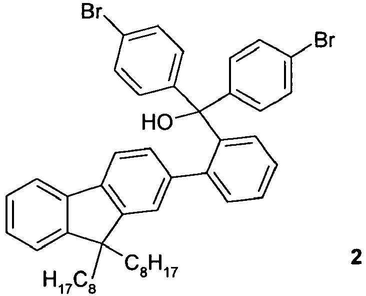

104,3 g (2 molare Äquivalente, 0,442 mol) 1,4-Dibrombenzol werden in 300 ml THF vorgelegt und im Aceton/Trockeneisbad auf -75°C abgekühlt. 117 ml (2 molare Äquivalente, 0,442 mol) n-Butyllithium (2,5 M in Hexan) werden so zugetropft, dass die Innentemperatur -69°C nicht übersteigt, anschließend wird 1 Stunde bei -72°C weiter gerührt. Danach werden 116 g (1 molares Äquivalent, 0,221 mol) Verbindung **1** in 220 ml THF gelöst und bei -72°C langsam zugetropft, dass die Innentemperatur -69°C nicht übersteigt. Die Reaktionslösung wird für eine weitere Stunde bei -70°C und über Nacht bei Raumtemperatur gerührt.

Der Ansatz wird mit 120 ml Essigsäure (50%ig) versetzt. Die Phasen werden getrennt. Die wässrige Phase wird mit Heptan extrahiert. Die vereinigten organischen Phasen werden mit Wasser extrahiert, über Na₂SO₄ getrocknet, filtriert und unter vermindertem Druck eingeengt.
¹H NMR (CDCl₂, δ (ppm), J (Hz)): 0.51 (s breit, 4H), 0.81 (t, 6H, J = 7,25), 0.94 - 1.25 (m, 20H), 1.55 - 1.85 (m, 4H), 6.73 (d, 1H, J = 8.0), 6.87 - 6.90 (m, 2H), 6.95 - 7.05 (m breit, 4H), 7.21 (d, 1H, J = 7.55), 7.24 (d, 1H, J = 7.75), 7.28 - 7.36 (m, 4H), 7.42 (d, 4H, J = 8.6), 7.56 (d, 1H, 7.75), 7.66 - 7.68 (m, 1H)

### 1.2 Verbindung 3

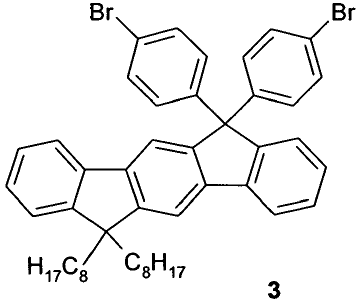

177,4 g (1 molares Äquivalent, 0,22 mol) Verbindung **2** werden in 353,2 ml (2,8 molare Äquivalente, 6,1 mol) Essigsäure gelöst und auf Rückfluss erwärmt. Unter Rückfluss werden 19,6 ml (1,1 molare Äquivalente, 0,24 mol) konzentrierte Salzsäure zugegeben und 1,5 Stunden unter Rückfluss erhitzt. Nach DC-Kontrolle (Heptan/Essigester) erfolgt eine Nachdosierung von 2 x 2 ml konzentrierter Salzsäure, Reaktionszeit 3 Stunden. Nach beendeter Reaktion wird vorsichtig 25 ml Wasser zugegeben. Anschließend wird zur Phasentrennung nochmals 50 ml Wasser zugegeben. Es wird mit Dichlormethan (DCM) extrahiert, danach werden die vereinigten organischen Phasen mit Wasser und NaHCO₃ extrahiert, über Natriumsulfat getrocknet, filtriert und unter vermindertem Druck eingeengt.

Die Reinigung erfolgt durch Umkristallisation (Acetonitril/Toluol) und liefert einen weißen Feststoff (99%).
¹H NMR (CDCl₂, δ (ppm), J (Hz)): 0.65 - 0.75 (m, 4H), 0.79 (t, 6H, J = 7,25), 0.99 - 1.25 (m, 20H), 1.98 - 2.01 (m, 4H), 7,10 (d, 4H, J = 8,75), 7.26 - 7.29 (m, 3H), 7.33 - 7.41 (m, 7H), 7.57 (s, 1H), 7.60 - 7.62 (m, 1H), 7.71 (s, 1H), 7.84 (d, 1H, 7.55)

### 1.3 Verbindung 4

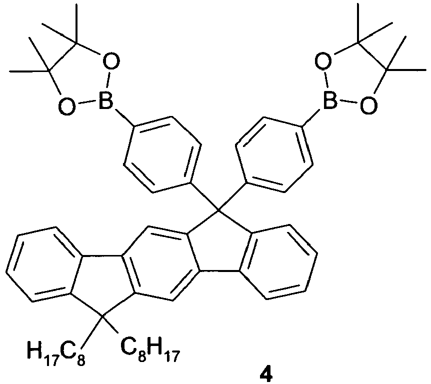

30 g (1 molares Äquivalent, 0,038 mol) Verbindung **3** werden mit 250 ml Dioxan, 19,33 g (2 molare Äquivalente, 0,076 mol) Bis(pinacolato)diboran und 10,83 g (2,9 molare Äquivalente, 0,11 mol) Kaliumacetat versetzt. Anschließend werden 1,11 g (1,4 mmol) 1,1-Bis(diphenylphosphin)-ferrocen-palladium(II)chlorid (Komplex mit Dichlormethan (1:1), Pd: 13%) zugegeben. Der Ansatz wird auf 110°C erhitzt. Nach DC-Kontrolle wird der Ansatz auf Raumtemperatur abgekühlt und 200 ml Wasser zugegeben. Anschließend wird zur Phasentrennung nochmals 50 ml Wasser zugegeben. Es wird mit Essigester extrahiert, danach werden die vereinigten organischen Phasen über Natriumsulfat getrocknet, filtriert und unter vermindertem Druck eingeengt.

Die Reinigung erfolgt über eine Säule (Heptan/Essigester) und durch Umkristallisation (Heptan) und liefert einen weißen Feststoff (100%).
¹H NMR (CDCl₂, δ (ppm), *J* (Hz)): 0.65 - 0.75 (m, 4H), 0.80 (t, 6H, J = 7,25), 0.99 - 1.23 (m, 20H), 1.28 (s, 24H), 1.98 - 2.01 (m, 4H), 7,23 (d, 4H, J = 8,2), 7.26 - 7.28 (m, 3H), 7.32 - 7.34 (m, 1H), 7.37 - 7.40 (m, 2H), 7.57 - 7.59 (m, 1H), 7.62 (s, 1H), 7.68 (d, 4H, J = 8.25), 7.71 (s, 1H), 7.84 (d, 1H, 7.40)

### Beispiel 2

### Herstellung von Verbindung 8 (M2)

Die Verbindung 8 wird wie folgt hergestellt:

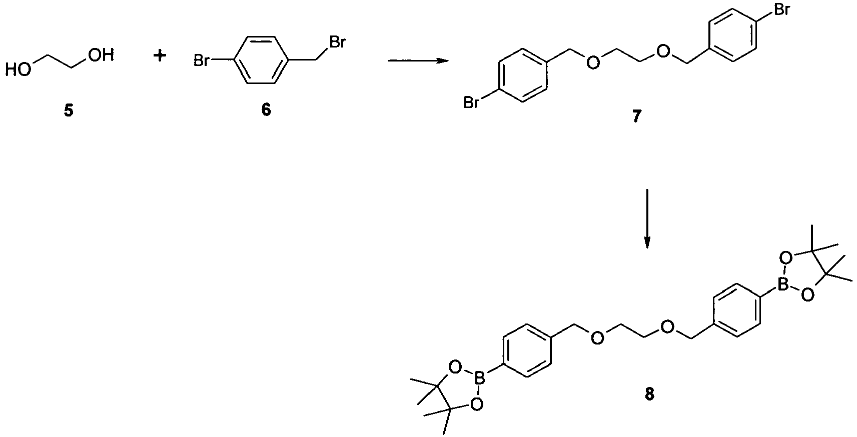

### 2.1 Verbindung 7

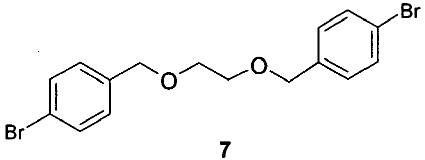

80,02 g NaH (10 molare Äquivalente, 2,0 mol) werden in 600 ml THF vorgelegt, unter Schutzgas bei ca. 0°C mit 11,3 ml Ethylenglykol (1 molares Äquivalent, 0,2 mol) in 200 ml THF versetzt, und nach 1 Stunde Rührzeit bei 0°C wird eine Lösung von 100 g 4-Brombenzylbromid (2 molare Äquivalente, 0,4 mmol) in 300 ml THF langsam bei 0°C zugetropft. Der Ansatz wird 36 Stunden unter Rückfluss gerührt, bei 0°C nachgekühlt und 200 ml Wasser bei 0°C langsam zugetropft. Die wässrige Phase wird dreimal mit DCM ausgeschüttelt. Die vereinigten organischen Phasen werden über Na₂SO₄ getrocknet, filtriert und einrotiert. Nach Umkristallisation aus Ethanol erhält man das Produkt **7** (30,6 g, 38 %).
¹H NMR (CDCl₃, δ (ppm), *J* (Hz)): 3.64 (s, 4H), 4.52 (s, 4H), 7.21 (d, 4H, J = 8.4), 7.46 (d, 4H, J = 8.4)

### 2.2 Verbindung 8

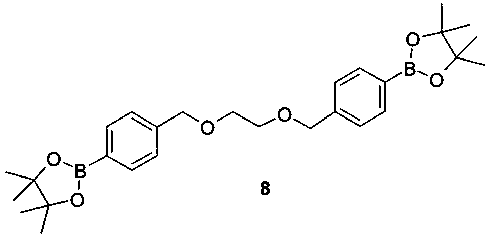

37,29 g (1 molares Äquivalent, 93,2 mmol) Verbindung **7** werden mit 200 ml THF, 52,53 g (2,2 molare Äquivalente, 206,9 mmol) Bis(pinacolato)-diboran in 100 ml THF, 60,78 g (6,6 molare Äquivalente, 619,3 mmol) Kaliumacetat in 200 ml THF und 2,71 g (0,04 molare Äquivalente, 3,7 mmol) 1,1-Bis(diphenylphosphin)ferrocen-palladium(II)chlorid (Komplex mit Dichlormethan (1:1), Pd: 13%) versetzt. Der Ansatz wird 5 Stunden bei 80°C gerührt, und 200 ml Eiswasser langsam zugetropft. Die wässrige Phase wird dreimal mit DCM ausgeschüttelt. Die vereinigten organischen Phasen werden über Na₂SO₄ getrocknet, filtriert und einrotiert. Nach Umkristallisation aus Heptan erhält man das Produkt **8** (9,1 g, 20 %).
¹H NMR (CDCl₂, δ (ppm), *J* (Hz)): 1.32 (s, 24H), 3.65 (s, 4H), 4.57 (s, 4H), 7.35 (d, 4H, J = 7.9), 7.79 (d, 4H, J = 7.9)

### Beispiel 3

### Herstellung von Verbindung 13 (M3)

Die Verbindung **13** wird wie folgt hergestellt:

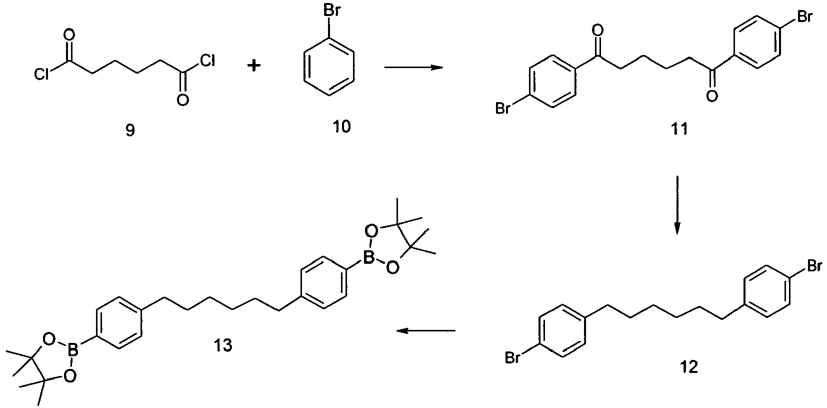

### 3.1 Verbindung 11

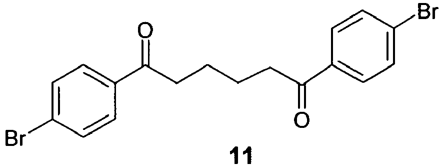

218,55 g Aluminiumchlorid (2,4 molare Äquivalente, 1,64 mol) werden in 288 ml (4,0 molare Äquivalente, 2,73 mol) Brombenzol vorgelegt. Unter Schutzgas bei Raumtemperatur wird 100 ml Adipoylchlorid (1 molares Äquivalent, 0,68 mmol) zugetropft. Der Ansatz wird 1 Stunde bei 50°C gerührt und 200 ml Wasser bei 0°C langsam zugetropft. Die wässrige Phase wird dreimal mit DCM ausgeschüttelt. Die vereinigten organischen Phasen werden über Na₂SO₄ getrocknet, filtriert und einrotiert. Nach Umkristallisation aus Ethanol erhält man das Produkt **11** (74,0 g, 26 %).
¹H NMR (CDCl₃, δ (ppm), J (Hz)): 1.81 - 1.85 (m, 4H), 2.97 - 3.02 (m, 4H), 7.60 (d, 4H, J = 8.6), 7.81 (d, 4H, J = 8.6)

### 3.2 Verbindung 12

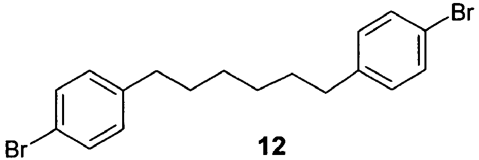

68,20 g (1 molares Äquivalent, 0,16 mol) Verbindung **11** und 72,38 g (8 molare Äquivalente, 1,29 mol) KOH werden in 11 Triethylenglykol vorgelegt. Unter Schutzgas bei Raumtemperatur wird 39,57 g Hydrazinhydrat (7,5 molare Äquivalente, 1,21 mol) langsam zugetropft. Der Ansatz wird 28 Stunden bei 160°C gerührt und 400 ml Wasser bei 0°C langsam zugetropft. Die wässrige Phase wird dreimal mit DCM ausgeschüttelt. Die vereinigten organischen Phasen werden über Na₂SO₄ getrocknet, filtriert und einrotiert. Nach Filtrierung auf Kieselgel erhält man das Produkt **12** (10,3 g, 16 %).
¹H NMR (CDCl₃, δ (ppm), J (Hz)): 1.29 - 1.35 (m, 4H), 1.56 - 1.60 (m, 4H), 2.52 - 2.55 (m, 4H), 7.02 (d, 4H, J = 8.4), 7.38 (d, 4H, J = 8.4)

### Verbindung 13

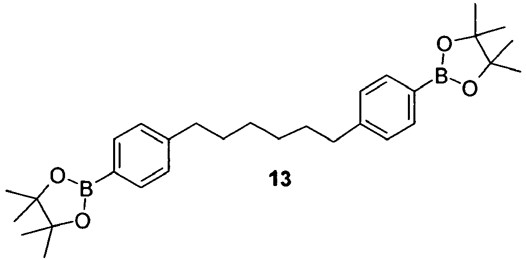

10,10 g (1 molares Äquivalent, 25 mmol) Verbindung **12** werden mit 55 ml THF, 14,22 g (2,2 molare Äquivalente, 56 mmol) Bis(pinacolato)diboran in 30 ml THF, 16,19 g (6,6 molare Äquivalente, 165 mmol) Kaliumacetat in 50 ml THF und 0,73 g (0,04 molare Äquivalente, 1 mmol) 1,1-Bis(diphenyl-phosphin)ferrocen-palladium(II)chlorid (Komplex mit Dichlormethan (1:1), Pd: 13%) versetzt. Der Ansatz wird 3 Stunden bei 80°C gerührt und 200 ml Eiswasser langsam zugetropft. Die wässrige Phase wird dreimal mit DCM ausgeschüttelt. Die vereinigten organischen Phasen werden über Na₂SO₄ getrocknet, filtriert und einrotiert. Nach Umkristallisation aus Heptan erhält man das Produkt **13** (5,10 g, 19 %).
¹H NMR (CDCl₃, δ (ppm), J (Hz)): 1.33 (s, 24H), 1.57 - 1.61 (m, 4H), 2,58 - 2.61 (m, 4H), 7.17 (d, 4H, J = 7.9), 7.72 (d, 4H, J = 7.9)

### Beispiel 4

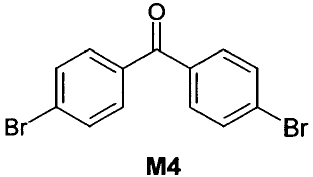

### Beispiel 5

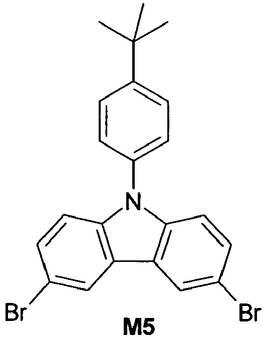

### Beispiel 6

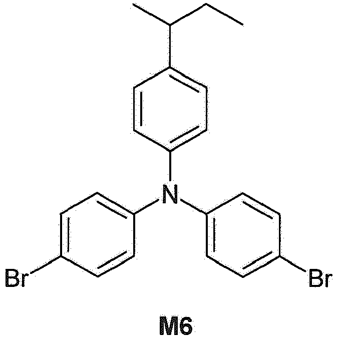

### Beispiele 7 bis 13: Herstellung der Polymere

Die erfindungsgemäßen Polymere P1 bis P7 werden unter Verwendung der folgenden Monomeren (Prozentangaben = mol%) durch SUZUKI-Kupplung gemäß der WO 03/048225 A2 synthetisiert.

### Beispiel 7 (Polymer P1)

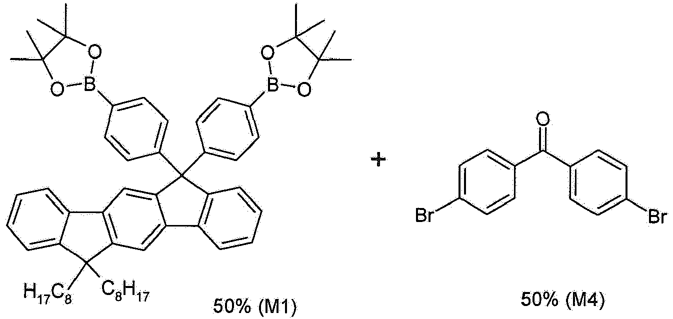

### Beispiel 8 (Polymer P2)

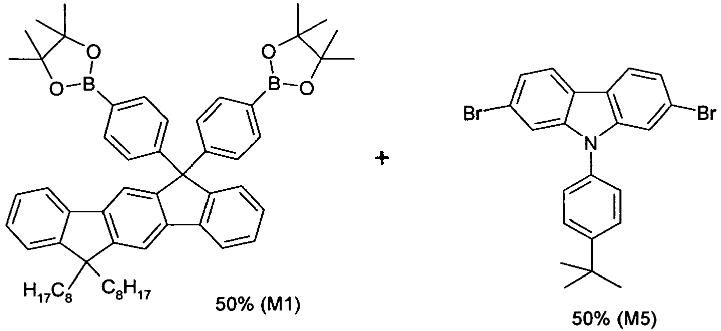

### Beispiel 9 (Polymer P3)

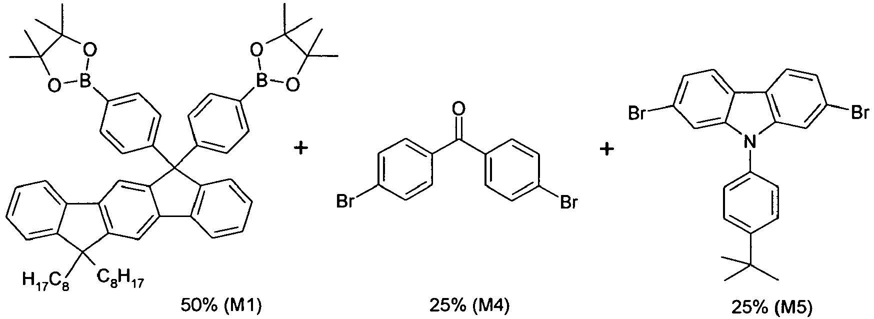

### Beispiel 10 (Polymer P4)

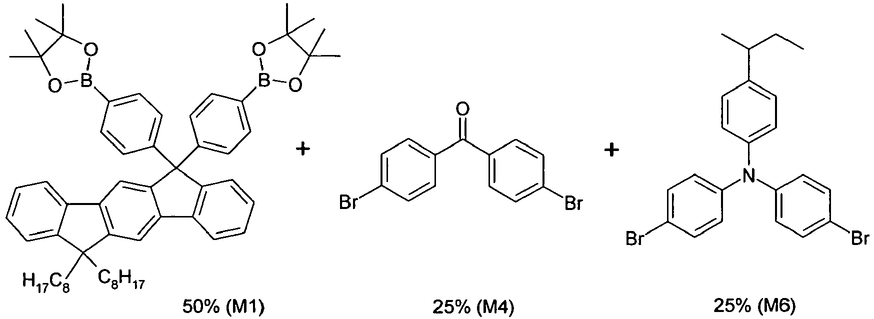

### Beispiel 11 (Polymer P5)

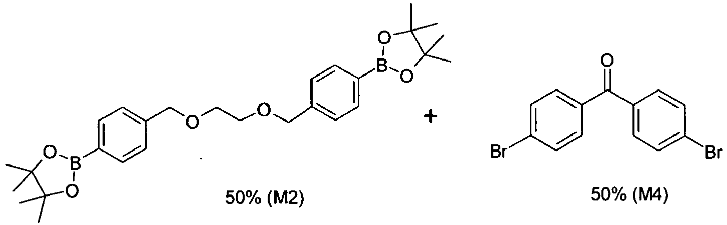

### Beispiel 12 (Polymer P6)

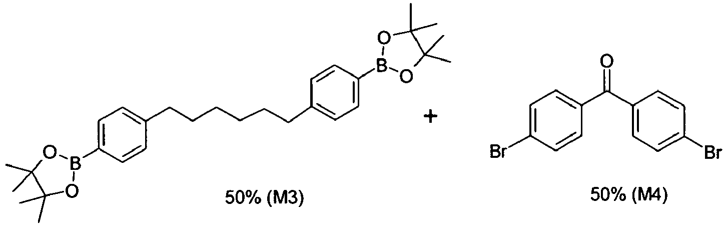

### Beispiel 13 (Polymer P7)

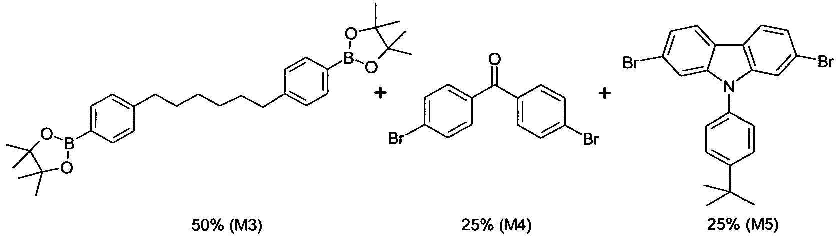

### Beispiele 14 bis 45: Herstellung von PLEDs

Die Strukturen des Emitters T1, der erfindungsgemäßen Carbazole C-1 bis C-6 und der neutralen Referenzverbindungen N-1 bis N-3 sind der Übersichtlichkeit halber im Folgenden abgebildet.

### Struktur des Emitters T1

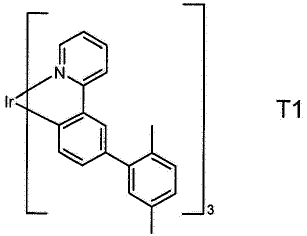

### Strukturen der Carbazol Verbindungen

| | |
|---|---|
| 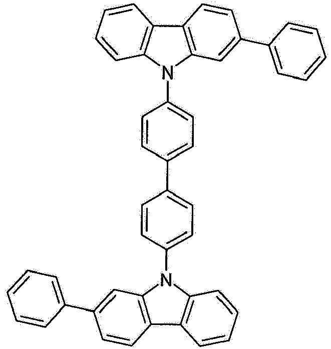 | 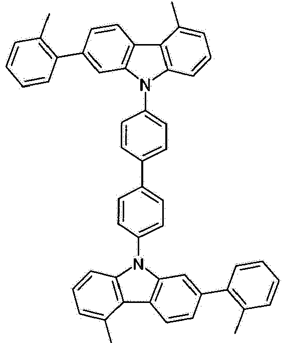 |
| C-1 | C-2 |
| 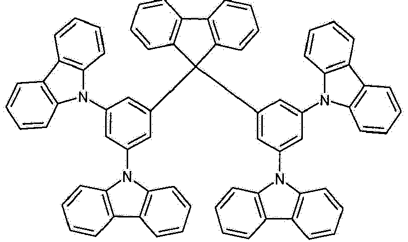 | 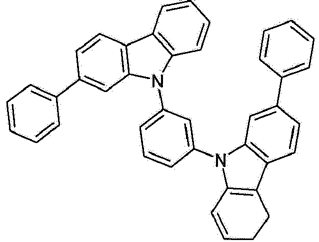 |
| C-3 | C-4 |
| 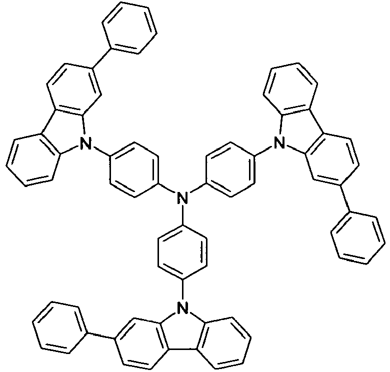 | 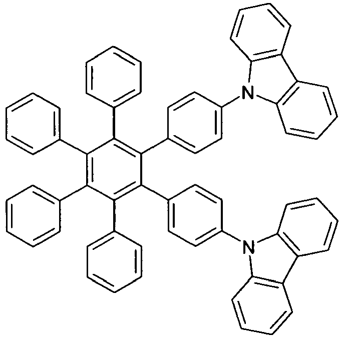 |
| C-5 | C-6 |

### Strukturen der neutralen Verbindungen

| | |
|---|---|
| 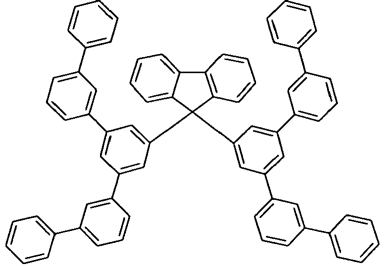 | 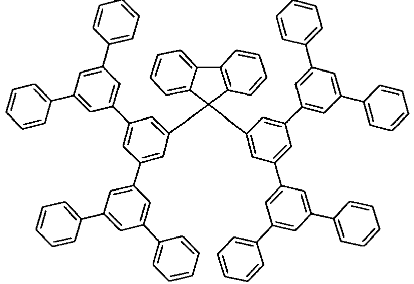 |
| N-1 | N-2 |
| 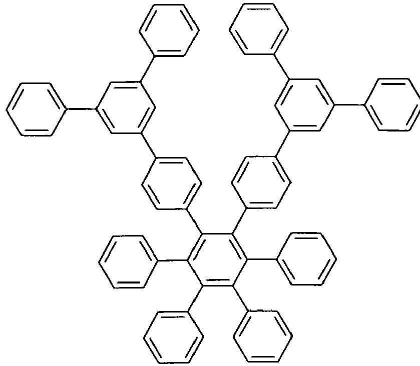 | |
| N-3 | |

Die erfindungsgemäßen Materialien werden aus Lösung verwendet und führen zu wesentlich einfacheren Devices mit dennoch guten Eigenschaften. Im vorliegenden Fall werden die erfindungsgemäßen Verbindungen in Toluol bzw. Chlorbenzol gelöst. Die in den hier genannten Beispielen eingesetzte Konzentration beträgt 20 Gew.-% des Emitters, 40 Gew.-% des Polymers P1 bis P7 und 40 Gew.-% der Verbindungen C-1 bis C-6 oder N-1 bis N-3. Der typische Feststoffgehalt solcher Lösungen liegt zwischen 16 und 25 g/l, wenn, wie hier, die für eine Device typische Schichtdicke von 80 nm mittels Spincoating erzielt werden soll.

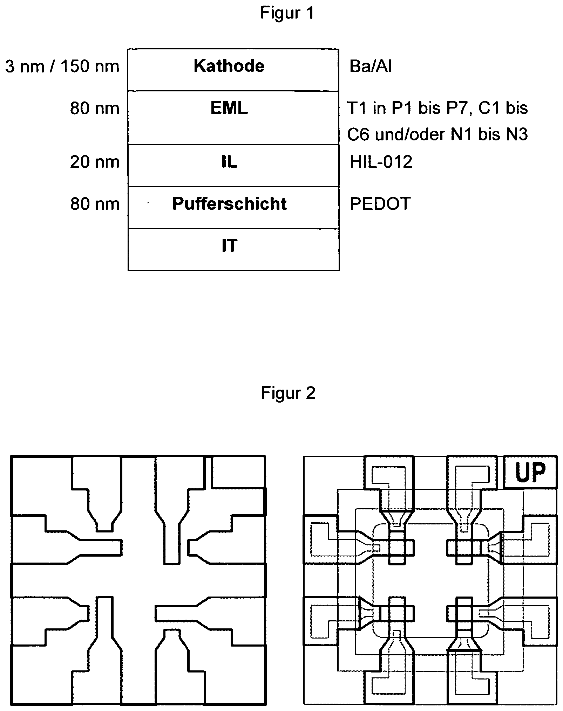

Fig. 1 zeigt den typischen Aufbau einer solchen Device. In der EML liegen die gemeinsam gelösten Matrixmaterialien sowie der Emitter in Form einer amorphen Schicht vor.

Die Herstellung einer polymeren organischen Leuchtdiode (PLED) ist in der Literatur bereits vielfach beschrieben (z.B. in der WO 2004/037887 A2). Um die vorliegende Erfindung beispielhaft zu erläutern, werden PLEDs mit den Polymeren P1 bis P7 durch Spincoating hergestellt. Eine typische Device hat den in Figur 1 dargestellten Aufbau.

Dazu werden speziell angefertigte Substrate der Firma Technoprint in einem eigens zu diesem Zweck designten Layout verwendet (Figur 2, Abbildung links: Auf den Glasträger aufgebrachte ITO-Struktur, Abbildung rechts: Vollständige elektronische Struktur mit ITO, aufgedampter Kathode und optionaler Metallisierung der Zuleitungen). Die ITO-Struktur (Indium-Zinn-Oxid, eine transparente, leitfähige Anode) wurde durch Sputtern in einem solchen Muster auf Sodalimeglas aufgebracht, dass sich mit der am Ende des Herstellungsprozesses aufgedampften Kathode 4 Pixel à 2 x 2 mm ergeben.

Die Substrate werden im Reinraum mit DI Wasser und einem Detergens (Deconex 15 PF) gereinigt und dann durch eine UV/Ozon-Plasmabehandlung aktiviert. Danach wird ebenfalls im Reinraum eine 80 nm Schicht PEDOT (PEDOT ist ein Polythiophen-Derivat (Baytron P VAI 4083sp.) von H. C. Starck, Goslar, das als wässrige Dispersion geliefert wird) durch Spin-Coating aufgebracht. Die benötigte Spinrate hängt vom Verdünnungsgrad und der spezifischen Spincoater-Geometrie ab (typisch für 80 nm: 4500 rpm). Um Restwasser aus der Schicht zu entfernen, werden die Substrate für 10 Minuten bei 180°C auf einer Heizplatte ausgeheizt. Danach werden unter Inertgasatmosphäre (im vorliegenden Fall: Argon) zunächst 20 nm einer Interlayer (typischerweise ein lochdominiertes Polymer, hier HIL-012 von Merck) und dann 80 nm der Emitterschicht aus Toluol- bzw. Chlorbenzollösung (Konzentration Interlayer 5 g/l, für die Emitterschicht jeweils 16 bis 25 g/l) aufgebracht. Beide Schichten werden bei 180°C mindestens 10 Minuten ausgeheizt. Danach wird die Ba/AI-Kathode im angegebenen Muster durch eine Aufdampfmaske aufgedampft (hochreine Metalle von Aldrich, besonders Barium 99,99 % (Best-Nr. 474711); Aufdampfanlagen von Lesker o.a., typischer Vakuumlevel 5 x 10⁻⁶ mbar). Um vor allem die Kathode vor Luft und Luftfeuchtigkeit zu schützen, wird die Device abschließend verkapselt.

Zwischen EML und Kathode können weitere Schichten (z.B. HBL und ETL) per Bedampfung aufgebracht werden, auch kann die Interlayer durch eine oder mehrere Schichten ersetzt werden, die lediglich die Bedingung erfüllen müssen, durch den nachgelagerten Prozessierungsschritt der EML-Abscheidung aus Lösung nicht wieder abgelöst zu werden.

Die lösungsprozessierten Devices werden standardmäßig charakterisiert, die genannten OLED-Beispiele werden nicht optimiert.

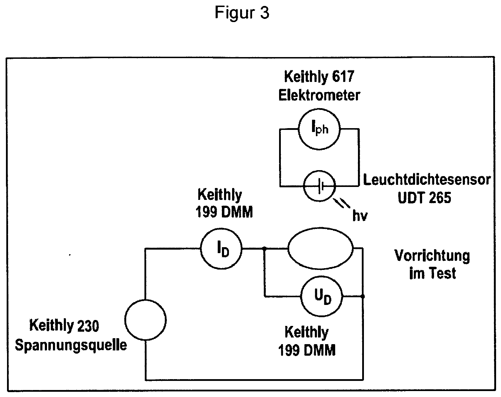

Dazu werden die Devices in für die Substratgröße eigens angefertigte Halter eingespannt und mittels Federkontakten kontaktiert. Eine Photodiode mit Augenverlaufsfilter kann direkt auf den Messhalter aufgesetzt werden, um Einflüsse von Fremdlicht auszuschließen. Der typische Messaufbau ist in Figur 3 dargestellt.

Typischerweise werden die Spannungen von 0 bis max. 20 V in 0,2 V-Schritten erhöht und wieder erniedrigt. Für jeden Messpunkt wird der Strom durch die Device sowie der erhaltene Photostrom von der Photodiode gemessen. Auf diese Art und Weise erhält man die IVL-Daten der Testdevices. Wichtige Kenngrößen sind die gemessene maximale Effizienz ("Max. Eff." in cd/A) und die für 100 cd/m² benötigte Spannung.

Um außerdem die Farbe und das genaue Elektrolumineszenzspektrum der Testdevices zu kennen, wird nach der ersten Messung nochmals die für 100 cd/m² benötigte Spannung angelegt und die Photodiode durch einen Spektrum-Messkopf ersetzt. Dieser ist durch eine Lichtleitfaser mit einem Spektrometer (Ocean Optics) verbunden. Aus dem gemessenen Spektrum können die Farbkoordinaten (CIE: Commission International de l'eclairage, Normalbetrachter von 1931) abgeleitet werden.

Für die Einsatzfähigkeit der Materialien von besonderer Bedeutung ist die Lebensdauer der Devices. Diese wird in einem der Erstevaluierung sehr ähnlichen Messaufbau so gemessen, dass eine Anfangsleuchtdichte eingestellt wird (z.B. 1000 cd/m²). Der für diese Leuchtdichte benötigte Strom wird konstant gehalten, während typischerweise die Spannung ansteigt und die Leuchtdichte abnimmt. Die Lebensdauer ist erreicht, wenn die Anfangsleuchtdichte auf 50% des Ausgangswertes abgesunken ist.

In Tabelle 1 sind die Deviceergebnisse ohne die erfindungsgemäßen Verbindungen C-1 bis C-6 oder die Referenzmaterialien N-1 bis N-3 mit denen, die durch eine gemischte Schicht mit den erfindungsgemäßen Materialien oder den Referenzmaterialien erhalten werden, verglichen.

**Tabelle 1: Ergebnisse in der Devicekonfiquration der Figur 1**

| Beispiele | EML 80 nm | Max. Eff. [cd/A] | Spannung [V] bei 100 cd/m² | CIE (x, y) | Lebensdauer [h], Anfangshelligkeit 1000 cd/m² |
|---|---|---|---|---|---|
| 14 (Vergl. | P1 : T1 | 28,4 | 5,30 | 0,35/0,61 | 970 |
| 15 | P1 : C-1 : T1 | 33,6 | 4,22 | 0,34/0,62 | 5000 |
| 16 | P1 : C-2 : T1 | 31,3 | 4,25 | 0,34/0,62 | 3200 |
| 17 | P1 : C-3 : T1 | 32,8 | 4,37 | 0,35/0,61 | 3370 |
| 18 | P1 : C-4 : T1 | 31,9 | 4,23 | 0,34/0,62 | 6140 |
| 19 | P1 : C-5 : T1 | 28,0 | 4,31 | 0,35/0,61 | 2410 |
| 20 (Ref.) | P1 : N-1 : T1 | 32,7 | 4,31 | 0,34/0,62 | 4870 |
| 21 (Ref.) | P1 : N-3 : T1 | 31,2 | 4,31 | 0,34/0,62 | 3270 |
| 22 (Vergl.) | P1 : P2 : T1 | 36,1 | 4,84 | 0,34/0,62 | 890 |
| 23 | P1 : P2 : C-1 : T1 | 37,4 | 4,24 | 0,34/0,62 | 3100 |
| 24 (Vergl.) | P3 : T1 | 31,2 | 5,84 | 0,34/0,62 | 3290 |
| 25 | P3 : C-1 : T1 | 34,2 | 5,47 | 0,33/0,62 | 5470 |
| 26 (Ref.) | P3 : N-3 : T1 | 26,7 | 5,37 | 0,34/0,62 | 6870 |
| 27 (Vergl.) | P4 : T1 | 25,8 | 5,60 | 0,33 /0,62 | 486 |
| 28 | P4 : C-6 : T1 | 29,2 | 4,47 | 0,33/0,62 | 2470 |
| 29 (Ref.) | P4 : N-3 : T1 | 33,7 | 4,51 | 0,34/0,62 | 3530 |
| 30 (Vergl.) | P5 : T1 | 17,4 | 5,70 | 0,34 /0,62 | 360 |
| 31 | P5 : C-1 : T1 | 25,4 | 4,22 | 0,33/0,62 | 2710 |
| 32 (Ref.) | P5 : N-3 : T1 | 26,6 | 4,31 | 0,34/0,62 | 1870 |
| 33 (Vergl.) | P6 : T1 | 22,8 | 5,58 | 0,34/0,61 | 835 |
| 34 | P6 : C-1 : T1 | 27,6 | 4,66 | 0,34/0,62 | 3780 |
| 35 | P6 : C-2 : T1 | 29,9 | 4,62 | 0,34/0,62 | 3200 |
| 36 | P6 : C-3 : T1 | 30,0 | 4,67 | 0,34/0,62 | 3460 |
| 37 | P6 : C-6 : T1 | 31,5 | 4,65 | 0,34/0,62 | 2710 |
| 38 (Ref.) | P6 : N-2 : T1 | 30,3 | 4,63 | 0,34/0,62 | 3590 |
| 39 (Ref.) | P6 : N-3 : T1 | 31,5 | 4,66 | 0,34/0,62 | 3020 |
| 40 (Vergl.) | P7 : T1 | 27,4 | 5,20 | 0,33 /0,62 | 890 |
| 41 | P7 : C-2 : T1 | 29,7 | 4,52 | 0,34/0,62 | 5080 |
| 42 | P7 : C-3 : T1 | 30,1 | 4,57 | 0,34/0,62 | 3030 |
| 43 | P7 : C-4 : T1 | 33,7 | 4,45 | 0,34/0,62 | 4070 |
| 44 (Ref.) | P7 : N-1 : T1 | 32,2 | 4,53 | 0,34/0,62 | 2050 |
| 45 (Ref.) | P7 : N-3 : T1 | 32,4 | 4,56 | 0,34/0,62 | 3150 |

## Patentansprüche

1. Mischung umfassend
a) ein Polymer, das mindestens eine L=X Struktureinheit enthält,
b) eine Triplett-Emitter-Verbindung und
c) eine Carbazolverbindung,
wobei die Triplett-Emitter-Verbindung eine Verbindung der Formel (22) ist, 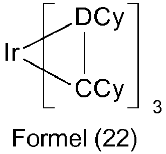 wobei für die verwendeten Symbole und Indices gilt:
L ist bei jedem Auftreten gleich oder verschieden C(R¹)₂, PR¹, AsR¹, SbR¹, BiR¹, P(R¹)₃, As(R¹)₃, Sb(R¹)₃, Bi(R¹)₃, S(R¹)₂, Se(R¹)₂, Te(R¹)₂, (R¹)₂S(=O), (R¹)₂Se(=O) oder (R¹)₂Te(=O);
X ist bei jedem Auftreten gleich oder verschieden O, S, Se oder NR²;
R¹ ist bei jedem Auftreten gleich oder verschieden H, D, F, CN, N(R²)₂, eine geradkettige, verzweigte oder cyclische Alkyl-, Alkoxy- oder Thioalkoxygruppe mit 1 bis 40 C-Atomen, die mit R³ substituiert oder auch unsubstituiert sein kann, wobei eine oder mehrere nicht benachbarte CH₂-Gruppen durch -R⁴C=CR⁴-, -C=C-, Si(R⁴)₂, Ge(R⁴)₂, Sn(R⁴)₂, C=O, C=S, C=Se, C=NR⁴, -O-, -S-, -NR⁴ oder -CONR⁴- ersetzt sein können und wobei ein oder mehrere H-Atome durch F, Cl, Br, I, CN oder NO₂ ersetzt sein können, oder ein aromatisches oder heteroaromatisches Ringsystem mit 1 bis 60 C-Atomen, das mit einem oder mehreren Resten R³ substituiert sein kann, wobei zwei oder mehrere Substituenten R¹ auch zusammen mit den Atomen, an die sie gebunden sind, miteinander ein mono- oder polycyclisches, aliphatisches oder aromatisches Ringsystem bilden können; wobei mindestens eine Gruppe R¹ eine Bindung zu einer weiteren Struktureinheit des Polymers aufweist;
R² ist bei jedem Auftreten gleich oder verschieden eine geradkettige, verzweigte oder cyclische Alkyl- oder Alkoxygruppe mit 1 bis 22 C-Atomen, in der auch ein oder mehrere nicht benachbarte C-Atome durch -R⁴C=CR⁴-, -C≡C-, Si(R⁴)₂, Ge(R⁴)₂, Sn(R⁴)₂, -NR⁴-, -O-, -S-, -CO-O-, -O-CO-O-ersetzt sein können, wobei auch ein oder mehrere H-Atome durch Fluor ersetzt sein können, eine Aryl-, Heteroaryl- oder Aryloxygruppe mit 1 bis 40 C-Atomen, welche auch durch einen oder mehrere Reste R³ substituiert sein kann, oder OH oder N(R³)₂;
R³ ist bei jedem Auftreten gleich oder verschieden R⁴ oder CN, B(R⁴)₂ oder Si(R⁴)₃;
R⁴ ist bei jedem Auftreten gleich oder verschieden H, D oder ein aliphatischer oder aromatischer Kohlenwasserstoffrest mit 1 bis 20 C-Atomen;
DCy ist gleich oder verschieden bei jedem Auftreten eine cyclische Gruppe, die mindestens ein Donoratom, vorzugsweise Stickstoff, Kohlenstoff in Form eines Carbens oder Phosphor, enthält, über welches die cyclische Gruppe an das Metall gebunden ist, und die wiederum einen oder mehrere Substituenten R³ tragen kann; die Gruppen DCy und CCy sind über eine kovalente Bindung miteinander verbunden; und
CCy ist gleich oder verschieden bei jedem Auftreten eine cyclische Gruppe, die ein Kohlenstoffatom enthält, über welches die cyclische Gruppe an das Metall gebunden ist und die wiederum einen oder mehrere Substituenten R¹ tragen kann.

2. Mischung nach Anspruch 1, **dadurch gekennzeichnet, dass** die Struktureinheit L=X des Polymers eine Struktureinheit der Formel (1) 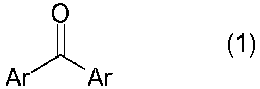 ist, wobei für die verwendeten Symbole gilt:
Ar ist bei jedem Auftreten gleich oder verschieden ein aromatisches oder heteroaromatisches Ringsystem mit 5 bis 60 aromatischen Ringatomen, welches jeweils mit einer oder mehreren Gruppen R⁵ substituiert sein kann;
R⁵ ist bei jedem Auftreten gleich oder verschieden H, D, F, Cl, Br, I, CHO, C(=O)Ar¹, P(=O)(Ar¹)₂, S(=O)Ar¹, S(=O)₂Ar¹, CR⁶=CR⁶Ar¹, CN, NO₂, Si(R⁶)₃, B(OR⁶)₂, B(R⁶)₂, B(N(R⁶)₂)₂, OSO₂R⁶, eine geradkettige Alkyl-, Alkoxy- oder Thioalkoxygruppe mit 1 bis 40 C-Atomen oder eine geradkettige Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R⁶ substituiert sein kann, wobei eine oder mehrere nicht benachbarte CH₂-Gruppen durch R⁶C=CR⁶, C≡C, Si(R⁶)₂, Ge(R⁶)₂, Sn(R⁶)₂, C=O, C=S, C=Se, C=NR⁶, P(=O)(R⁶), SO, SO₂, NR⁶, O, S oder CONR⁶ ersetzt sein können und wobei ein oder mehrere H-Atome durch F, Cl, Br, I, CN oder NO₂ ersetzt sein können, oder ein aromatisches oder heteroaromatisches Ringsystem mit 5 bis 60 aromatischen Ringatomen, das jeweils durch einen oder mehrere Reste R⁶ substituiert sein kann, oder eine Aryloxy- oder Heteroaryloxygruppe mit 5 bis 60 aromatischen Ringatomen, die durch einen oder mehrere Reste R⁶ substituiert sein kann, oder eine Kombination dieser Systeme; dabei können zwei oder mehrere benachbarte Substituenten R⁵ auch miteinander ein mono- oder polycyclisches, aliphatisches oder aromatisches Ringsystem bilden;
Ar¹ ist bei jedem Auftreten gleich oder verschieden ein aromatisches oder heteroaromatisches Ringsystem mit 5 bis 40 aromatischen Ringatomen, das mit einem oder mehreren Resten R⁵ substituiert sein kann;
R⁶ ist bei jedem Auftreten gleich oder verschieden H, D, CN oder ein aliphatischer, aromatischer oder heteroaromatischer Kohlenwasserstoffrest mit 1 bis 20 C-Atomen, in dem auch H-Atome durch F ersetzt sein können; dabei können zwei oder mehrere benachbarte Substituenten R⁶ auch miteinander ein mono- oder polycyclisches, aliphatisches oder aromatisches Ringsystem bilden;
wobei mindestens ein Rest R⁵ eine kovalente Bindung zu einer weiteren Struktureinheit des Polymers ist.

3. Mischung nach Anspruch 1 oder 2, **dadurch gekennzeichnet, dass** das Polymer mindestens eine weitere Struktureinheit umfasst, welche von der Struktureinheit L=X verschieden ist, vorzugsweise ausgewählt aus einer substituierten oder unsubstituierten cis- oder trans-Indenofluoren-Struktureinheit oder einer Struktureinheit umfassend zwei aromatische Gruppen, die über eine lineare C₁-C₁₀-Alkylgruppe miteinander verbunden sind.

4. Mischung nach einem oder mehreren der Ansprüche 1 bis 3, **dadurch gekennzeichnet, dass** die Carbazolverbindung eine Verbindung der Formel (2) ist 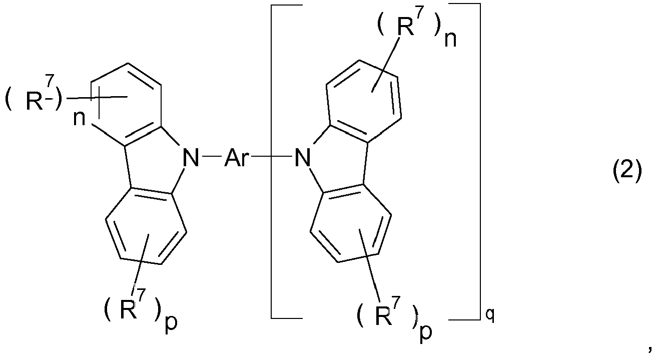 wobei für die verwendeten Symbole und Indices gilt:
Ar ist bei jedem Auftreten ein aromatisches oder heteroaromatisches Ringsystem mit 5 bis 60 aromatischen Ringatomen, welches mit einem oder mehreren Resten R⁷ substituiert sein kann;
R⁷ ist bei jedem Auftreten gleich oder verschieden H, D, F, Cl, Br, I, N(Ar²)₂, CN, NO₂, Si(R')₃, B(OR⁸)₂, C(=O)Ar², P(=O)(Ar²)₂, S(=O)Ar², S(=O)2Ar², -CR⁸=CR⁸(Ar²), OSO₂R⁸, eine geradkettige Alkyl-, Alkoxy- oder Thioalkoxygruppe mit 1 bis 40 C-Atomen oder eine verzweigte oder cyclische Alkyl-, Alkoxy- oder Thioalkoxygruppe mit 3 bis 40 C-Atomen, die jeweils mit einem oder mehreren Resten R⁸ substituiert sein kann, wobei eine oder mehrere nicht benachbarte CH₂-Gruppen durch R⁸C=CR⁸, C≡C, Si(R⁸)₂, Ge(R⁸)₂, Sn(R⁸)₂, C=O, C=S, C=Se, C=NR⁸, P(=O)(R⁸), SO, SO₂, NR⁸, O, S oder CONR⁸ ersetzt sein können und wobei ein oder mehrere H-Atome durch F, Cl, Br, I, CN oder NO₂ ersetzt sein können, oder ein aromatisches oder heteroaromatisches Ringsystem mit 5 bis 60 aromatischen Ringatomen, das jeweils mit einem oder mehreren Resten R⁸ substituiert sein kann, oder eine Aryloxy- oder Heteroaryloxy-gruppe mit 5 bis 60 aromatischen Ringatomen, die mit einem oder mehreren Resten R⁸ substituiert sein kann, oder eine Kombination dieser Systeme; dabei können zwei oder mehrere Substituenten R auch miteinander ein mono- oder polycyclisches, aliphatisches oder aromatisches Ringsystem bilden;
Ar² ist bei jedem Auftreten gleich oder verschieden ein aromatisches oder heteroaromatisches Ringsystem mit 5 bis 60 aromatischen Ringatomen, welches mit einem oder mehreren Resten R⁸ substituiert sein kann;
R⁸ ist bei jedem Auftreten gleich oder verschieden H, D oder ein aliphatischer, aromatischer und/oder heteroaromatischer Kohlenwasserstoffrest mit 1 bis 20 C-Atomen; oder ein aromatisches oder heteroaromatisches Ringsystem mit 5 bis 60 aromatischen Ringatomen, welches mit einem oder mehreren Resten R substituiert sein kann; dabei können zwei oder mehrere Substituenten R⁸ auch miteinander ein mono- oder polycyclisches, aliphatisches, aromatisches oder heteroaromatisches Ringsystem bilden;
n ist bei jedem Auftreten gleich oder verschieden 0, 1, 2, 3 oder 4;
p ist bei jedem Auftreten gleich oder verschieden 0, 1, 2, 3 oder 4; und
q ist 1, 2, 3, 4 oder 5.

5. Mischung nach einem oder mehreren der Ansprüche 1 bis 4, **dadurch gekennzeichnet, dass** der Anteil der Triplett-Emitter-Verbindung in der Mischung 0,1 bis 40 Gew.-% beträgt.

6. Mischung nach einem oder mehreren der Ansprüche 1 bis 5, **dadurch gekennzeichnet, dass** sie ein oder mehrere Lösungsmittel enthält.

7. Verwendung einer Mischung nach einem oder mehreren der Ansprüche 1 bis 5 in einer organischen Elektrolumineszenzvorrichtung.

8. Organische Elektrolumineszenzvorrichtung umfassend Kathode, Anode und mindestens eine elektrolumineszierende Schicht, **dadurch gekennzeichnet, dass** die elektrolumineszierende Schicht eine Mischung nach einem oder mehreren der Ansprüche 1 bis 5 enthält.

9. Organische Elektrolumineszenzvorrichtung nach Anspruch 8, **dadurch gekennzeichnet, dass** die elektrolumineszierende Schicht aus Lösung aufgebracht ist.

## Claims

1. Mixture comprising
a) a polymer which contains at least one L=X structural unit,
b) a triplet emitter compound and
c) a carbazole compound,
where the triplet emitter compound is a compound of the formula (22), 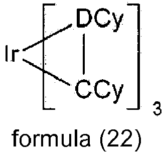 where the following applies to the symbols and indices used:
L is on each occurrence, identically or differently, C(R¹)₂, PR¹, AsR¹, SbR¹, BiR¹, P(R¹)₃, As(R¹)₃, Sb(R¹)₃, Bi(R¹)₃, S(R¹)₂, Se(R¹)₂, Te(R¹)₂, (R¹)₂S(=O), (R¹)₂Se(=O) or (R¹)₂Te(=O);
X is on each occurrence, identically or differently, O, S, Se or NR²;
R¹ is on each occurrence, identically or differently, H, D, F, CN, N(R²)₂, a straight-chain, branched or cyclic alkyl, alkoxy or thioalkoxy group having 1 to 40 C atoms, which may be substituted by R³ or also unsubstituted, where one or more non-adjacent CH2 groups may be replaced by -R⁴C=CR⁴-, -C=C-, Si(R⁴)₂, Ge(R⁴)₂, Sn(R⁴)₂, C=O, C=S, C=Se, C=NR⁴, -O-, -S-, -NR⁴ or -CONR⁴⁻ and where one or more H atoms may be replaced by F, Cl, Br, I, CN or NO₂, or an aromatic or heteroaromatic ring system having 1 to 60 C atoms, which may be substituted by one or more radicals R³, where two or more substituents R¹, together with the atoms to which they are bonded, may also form a mono- or polycyclic, aliphatic or aromatic ring system with one another; where at least one group R¹ has a bond to a further structural unit of the polymer;
R² is on each occurrence, identically or differently, a straight-chain, branched or cyclic alkyl or alkoxy group having 1 to 22 C atoms, in which, in addition, one or more non-adjacent C atoms may be replaced by -R⁴C=CR⁴-, -C≡C-, Si(R⁴)₂, Ge(R⁴)₂, Sn(R⁴)₂, -NR⁴-, -O-, -S-, -CO-O-, -O-CO-O-, where, in addition, one or more H atoms may be replaced by fluorine, or is an aryl, heteroaryl or aryloxy group having 1 to 40 C atoms, which may also be substituted by one or more radicals R³, or OH or N(R³)₂;
R³ is on each occurrence, identically or differently, R⁴ or CN, B(R⁴)₂ or Si(R⁴)₃;
R⁴ is on each occurrence, identically or differently, H, D or an aliphatic or aromatic hydrocarbon radical having 1 to 20 C atoms;
DCy is, identically or differently on each occurrence, a cyclic group which contains at least one donor atom, preferably nitrogen, carbon in the form of a carbene or phosphorus, via which the cyclic group is bonded to the metal, and which may in turn carry one or more substituents R³; the groups DCy and CCy are connected to one another via a covalent bond;
CCy is, identically or differently on each occurrence, a cyclic group which contains a carbon atom via which the cyclic group is bonded to the metal and which may in turn carry one or more substituents R¹.

2. Mixture according to Claim 1, **characterised in that** the structural unit L=X of the polymer is a structural unit of the formula (1) 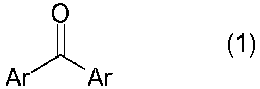 where the following applies to the symbols used:
Ar is on each occurrence, identically or differently, an aromatic or heteroaromatic ring system having 5 to 60 aromatic ring atoms, which may in each case be substituted by one or more groups R⁵;
R⁵ is on each occurrence, identically or differently, H, D, F, Cl, Br, I, CHO, C(=O)Ar¹, P(=O)(Ar¹)₂, S(=O)Ar¹, S(=O)₂Ar¹, CR⁶=CR⁶Ar¹, CN, NO₂, Si(R⁶)₃, B(OR⁶)₂, B(R⁶)₂, B(N(R⁶)₂)₂, OSO₂R⁶, a straight-chain alkyl, alkoxy or thioalkoxy group having 1 to 40 C atoms or a straight-chain alkenyl or alkynyl group having 2 to 40 C atoms or a branched or cyclic alkyl, alkenyl, alkynyl, alkoxy or thioalkoxy group having 3 to 40 C atoms, which may in each case be substituted by one or more radicals R⁶, where one or more non-adjacent CH₂ groups may be replaced by R⁶C=CR⁶, C≡C, Si(R⁶)₂, Ge(R⁶)₂, Sn(R⁶)₂, C=O, C=S, C=Se, C=NR⁶, P(=O)(R⁶), SO, SO₂, NR⁶, O, S or CONR⁶ and where one or more H atoms may be replaced by F, Cl, Br, I, CN or NO₂, or an aromatic or heteroaromatic ring system having 5 to 60 aromatic ring atoms, which may in each case be substituted by one or more radicals R⁶, or an aryloxy or heteroaryloxy group having 5 to 60 aromatic ring atoms, which may be substituted by one or more radicals R⁶, or a combination of these systems; two or more adjacent substituents R⁵ may also form a mono- or polycyclic, aliphatic or aromatic ring system with one another;
Ar¹ is on each occurrence, identically or differently, an aromatic or heteroaromatic ring system having 5 to 40 aromatic ring atoms, which may be substituted by one or more radicals R⁵;
R⁶ is on each occurrence, identically or differently, H, D, CN or an aliphatic, aromatic or heteroaromatic hydrocarbon radical having 1 to 20 C atoms, in which, in addition, H atoms may be replaced by F; two or more adjacent substituents R⁶ may also form a mono- or polycyclic, aliphatic or aromatic ring system with one another;
where at least one radical R⁵ is a covalent bond to a further structural unit of the polymer.

3. Mixture according to Claim 1 or 2, **characterised in that** the polymer contains at least one further structural unit which is different from the structural unit L=X, preferably selected from a substituted or unsubstituted cis- or trans-indenofluorene structural unit or a structural unit comprising two aromatic groups which are connected to one another via a linear C₁-C₁₀-alkyl group.

4. Mixture according to one or more of Claims 1 to 3, **characterised in that** the carbazole compound is a compound of the formula (2) 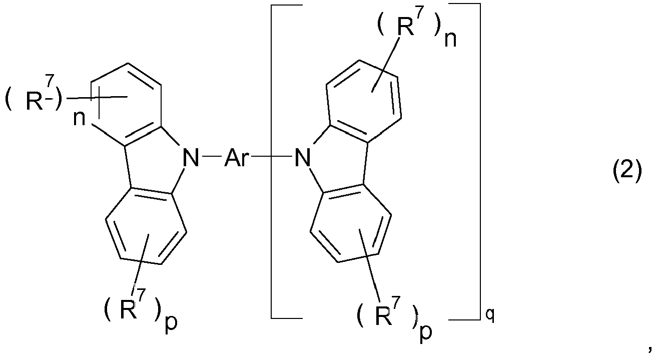 where the following applies to the symbols and indices used:
Ar is on each occurrence an aromatic or heteroaromatic ring system having 5 to 60 aromatic ring atoms, which may be substituted by one or more radicals R⁷;
R⁷ is on each occurrence, identically or differently, H, D, F, Cl, Br, I, N(Ar²)₂, CN, NO₂, Si(R')₃, B(OR⁸)₂, C(=O)Ar², P(=O)(Ar²)₂, S(=O)Ar², S(=O)₂Ar², -CR⁸=CR⁸(Ar²), OSO₂R⁸, a straight-chain alkyl, alkoxy or thioalkoxy group having 1 to 40 C atoms or a branched or cyclic alkyl, alkoxy or thioalkoxy group having 3 to 40 C atoms, which may in each case be substituted by one or more radicals R⁸, where one or more non-adjacent CH₂ groups may be replaced by R⁸C=CR⁸, C≡C, Si(R⁸)₂, Ge(R⁸)₂, Sn(R⁸)₂, C=O, C=S, C=Se, C=NR⁸, P(=O)(R⁸), SO, SO₂, NR⁸, O, S or CONR⁸ and where one or more H atoms may be replaced by F, Cl, Br, I, CN or NO₂, or an aromatic or heteroaromatic ring system having 5 to 60 aromatic ring atoms, which may in each case be substituted by one or more radicals R⁸, or an aryloxy or heteroaryloxy group having 5 to 60 aromatic ring atoms, which may be substituted by one or more radicals R⁸, or a combination of these systems; two or more substituents R may also form a mono- or polycyclic, aliphatic or aromatic ring system with one another;
Ar² is on each occurrence, identically or differently, an aromatic or heteroaromatic ring system having 5 to 60 aromatic ring atoms, which may be substituted by one or more radicals R⁸;
R⁸ is on each occurrence, identically or differently, H, D or an aliphatic, aromatic and/or heteroaromatic hydrocarbon radical having 1 to 20 C atoms; or an aromatic or heteroaromatic ring system having 5 to 60 aromatic ring atoms, which may be substituted by one or more radicals R; two or more substituents R⁸ may also form a mono- or polycyclic, aliphatic, aromatic or heteroaromatic ring system with one another;
n is on each occurrence, identically or differently, 0, 1, 2, 3 or 4;
p is on each occurrence, identically or differently, 0, 1, 2, 3 or 4; and
q is 1, 2, 3, 4 or 5.

5. Mixture according to one or more of Claims 1 to 4, **characterised in that** the proportion of the triplet emitter compound in the mixture is 0.1 to 40% by weight.

6. Mixture according to one or more of Claims 1 to 5, **characterised in that** it comprises one or more solvents.

7. Use of a mixture according to one or more of Claims 1 to 5 in an organic electroluminescent device.

8. Organic electroluminescent device comprising cathode, anode and at least one electroluminescent layer, **characterised in that** the electroluminescent layer comprises a mixture according to one or more of Claims 1 to 5.

9. Organic electroluminescent device according to Claim 8, **characterised in that** the electroluminescent layer has been applied from solution.

## Revendications

1. Mélange comprenant :
a) un polymère qui contient au moins une unité structurelle L=X ;
b) un composé émetteur de triplets ; et
c) un composé de carbazole ;
dans lequel le composé émetteur de triplets est un composé de la formule (22) : 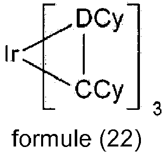 où ce qui suit s'applique aux symboles et indices qui sont utilisés :
L est pour chaque occurrence, de manière identique ou différente, C(R¹)₂, PR¹, AsR¹, SbR¹, BiR¹, P(R¹)₃, As(R¹)₃, Sb(R¹)₃, Bi(R¹)₃, S(R¹)₂, Se(R¹)₂, Te(R¹)₂, (R¹)₂S(=O), (R¹)₂Se(=O) ou (R¹)₂Te(=O) ;
X est pour chaque occurrence, de manière identique ou différente, O, S, Se ou NR²;
R¹ est pour chaque occurrence, de manière identique ou différente, H, D, F, CN, N(R²)₂, un groupe alkyle, alcoxy ou thioalcoxy en chaîne droite, ramifié ou cyclique qui comporte de 1 à 40 atome(s) de C, lequel peut être substitué par R³ ou également non substitué, où un ou plusieurs groupe(s) CH₂ non adjacents peut/peuvent être remplacé(s) par -R⁴C=CR⁴-, -C=C-, Si(R⁴)₂, Ge(R⁴)₂, Sn(R⁴)₂, C=O, C=S, C=Se, C=NR⁴, -O-, -S-, -NR⁴ ou -CONR⁴- et où un ou plusieurs atome(s) de H peut/peuvent être remplacé(s) par F, Cl, Br, I, CN ou NO₂, ou un système de cycle aromatique ou hétéroaromatique qui comporte de 1 à 60 atome(s) de C, lequel peut être substitué par un radical ou par plusieurs radicaux R³, où deux substituants R¹ ou plus, en association avec les atomes auxquels ils sont liés, peuvent également former un système de cycle aliphatique ou aromatique mono- ou polycyclique l'un avec l'autre ou les uns avec les autres ; où au moins un groupe R¹ comporte une liaison sur une autre unité structurelle du polymère ;
R² est pour chaque occurrence, de manière identique ou différente, un groupe alkyle ou alcoxy en chaîne droite, ramifié ou cyclique qui comporte de 1 à 22 atome(s) de C, où, en outre, un ou plusieurs atome(s) de C non adjacents peut/peuvent être remplacé(s) par -R⁴C=CR⁴-, -C≡C-, Si(R⁴)₂, Ge(R⁴)₂, Sn(R⁴)₂,-NR⁴-, -O-, -S-, -CO-O-, -O-CO-O-, où, en outre, un ou plusieurs atome(s) de H peut/peuvent être remplacé(s) par fluor, ou est un groupe aryle, hétéroaryle ou aryloxy qui comporte de 1 à 40 atome(s) de C, lequel peut également être substitué par un radical ou par plusieurs radicaux R³, ou OH ou N(R³)₂;
R³ est pour chaque occurrence, de manière identique ou différente, R⁴ ou CN, B(R⁴)₂ ou Si(R⁴)₃ ;
R⁴ est pour chaque occurrence, de manière identique ou différente, H, D ou un radical hydrocarbone aliphatique ou aromatique qui comporte de 1 à 20 atome(s) de C ;
DCy est, de manière identique ou différente pour chaque occurrence, un groupe cyclique qui contient au moins un atome donneur, de préférence azote, carbone sous la forme d'un carbène ou phosphore, via lequel le groupe cyclique est lié au métal, et qui peut à son tour être porteur d'un ou de plusieurs substituant(s) R³ ; les groupes DCy et CCy sont connectés l'un à l'autre via une liaison covalente ;
CCy est, de manière identique ou différente pour chaque occurrence, un groupe cyclique qui contient un atome de carbone via lequel le groupe cyclique est lié au métal et qui peut à son tour être porteur d'un ou de plusieurs substituant(s) R¹.

2. Mélange selon la revendication 1, **caractérisé en ce que** l'unité structurelle L=X du polymère est une unité structurelle de la formule (1) : 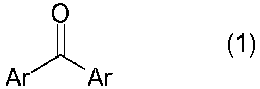 où ce qui suit s'applique aux symboles qui sont utilisés :
Ar est pour chaque occurrence, de manière identique ou différente, un système de cycle aromatique ou hétéroaromatique qui comporte de 5 à 60 atomes de cycle aromatique, lequel peut dans chaque cas être substitué par un ou plusieurs groupe(s) R⁵;
R⁵ est pour chaque occurrence, de manière identique ou différente, H, D, F, Cl, Br, I, CHO, C(=O)Ar¹, P(=O)(Ar¹)₂, S(=O)Ar¹, S(=O)₂Ar¹, CR⁶=CR⁶Ar¹, CN, NO₂, Si(R⁶)₃, B(OR⁶)₂, B(R⁶)₂, B(N(R⁶)₂)₂, OSO₂R⁶, un groupe alkyle, alcoxy ou thioalcoxy en chaîne droite qui comporte de 1 à 40 atome(s) de C ou un groupe alkényle ou alkynyle en chaîne droite qui comporte de 2 à 40 atomes de C ou un groupe alkyle, alkényle, alkynyle, alcoxy ou thioalcoxy ramifié ou cyclique qui comporte de 3 à 40 atomes de C, lequel peut dans chaque cas être substitué par un radical ou par plusieurs radicaux R⁶, où un ou plusieurs groupe(s) CH₂ non adjacents peut/peuvent être remplacé(s) par R⁶C=CR⁶, C≡C, Si(R⁶)₂, Ge(R⁶)₂, Sn(R⁶)₂, C=O, C=S, C=Se, C=NR⁶, P(=O)(R⁶), SO, SO₂, NR⁶, O, S ou CONR⁶ et où un ou plusieurs atome(s) de H peut/peuvent être remplacé(s) par F, Cl, Br, I, CN ou NO₂, ou un système de cycle aromatique ou hétéroaromatique qui comporte de 5 à 60 atomes de cycle aromatique, lequel peut dans chaque cas être substitué par un radical ou par plusieurs radicaux R⁶, ou un groupe aryloxy ou hétéroaryloxy qui comporte de 5 à 60 atomes de cycle aromatique, lequel peut être substitué par un radical ou par plusieurs radicaux R⁶, ou une combinaison de ces systèmes ; deux substituants R⁵ adjacents ou plus peuvent également former un système de cycle aliphatique ou aromatique mono- ou polycyclique l'un avec l'autre ou les uns avec les autres ;
Ar¹ est pour chaque occurrence, de manière identique ou différente, un système de cycle aromatique ou hétéroaromatique qui comporte de 5 à 40 atomes de cycle aromatique, lequel peut être substitué par un radical ou par plusieurs radicaux R⁵;
R⁶ est pour chaque occurrence, de manière identique ou différente, H, D, CN ou un radical hydrocarbone aliphatique, aromatique ou hétéroaromatique qui comporte de 1 à 20 atome(s) de C, où, en outre, des atomes de H peuvent être remplacés par F; deux substituants R⁶ adjacents ou plus peuvent également former un système de cycle aliphatique ou aromatique mono- ou polycyclique l'un avec l'autre ou les uns avec les autres ;
où au moins un radical R⁵ est une liaison covalente sur une autre unité structurelle du polymère.

3. Mélange selon la revendication 1 ou 2, **caractérisé en ce que** le polymère contient au moins une autre unité structurelle qui est différente de l'unité structurelle L=X, laquelle est de préférence sélectionnée parmi une unité structurelle cis- ou trans-indénofluorène substituée ou non substituée ou une unité structurelle qui comprend deux groupes aromatiques qui sont connectés l'un à l'autre via un groupe Ci-Cio-alkyle linéaire.

4. Mélange selon une ou plusieurs des revendications 1 à 3, **caractérisé en ce que** le composé de carbazole est un composé de la formule (2) : 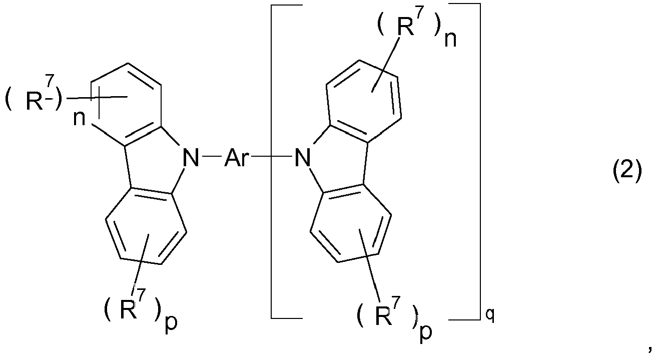 où ce qui suit s'applique aux symboles et indices qui sont utilisés :
Ar est pour chaque occurrence un système de cycle aromatique ou hétéroaromatique qui comporte de 5 à 60 atomes de cycle aromatique, lequel peut être substitué par un radical ou par plusieurs radicaux R⁷ ;
R⁷ est pour chaque occurrence, de manière identique ou différente, H, D, F, Cl, Br, I, N(Ar²)₂, CN, NO₂, Si(R')₃, B(OR⁸)₂, C(=O)Ar², P(=O)(Ar²)₂, S(=O)Ar², S(=O)₂Ar², -CR⁸=CR⁸(Ar²), OSO₂R⁸, un groupe alkyle, alcoxy ou thioalcoxy en chaîne droite qui comporte de 1 à 40 atome(s) de C ou un groupe alkyle, alcoxy ou thioalcoxy ramifié ou cyclique qui comporte de 3 à 40 atomes de C, lequel peut dans chaque cas être substitué par un radical ou par plusieurs radicaux R⁸, où un ou plusieurs groupe(s) CH₂ non adjacents peut/peuvent être remplacé(s) par R⁸C=CR⁸, C≡C, Si(R⁸)₂, Ge(R⁸)₂, Sn(R⁸)₂, C=O, C=S, C=Se, C=NR⁸, P(=O)(R⁸), SO, SO₂, NR⁸, O, S ou CONR⁸ et où un ou plusieurs atome(s) de H peut/peuvent être remplacé(s) par F, Cl, Br, I, CN ou NO₂, ou un système de cycle aromatique ou hétéroaromatique qui comporte de 5 à 60 atomes de cycle aromatique, lequel peut dans chaque cas être substitué par un radical ou par plusieurs radicaux R⁸, ou un groupe aryloxy ou hétéroaryloxy qui comporte de 5 à 60 atomes de cycle aromatique, lequel peut être substitué par un radical ou par plusieurs radicaux R⁸, ou une combinaison de ces systèmes ; deux substituants R ou plus peuvent également former un système de cycle aliphatique ou aromatique mono- ou polycyclique l'un avec l'autre ou les uns avec les autres ;
Ar² est pour chaque occurrence, de manière identique ou différente, un système de cycle aromatique ou hétéroaromatique qui comporte de 5 à 60 atomes de cycle aromatique, lequel peut être substitué par un radical ou par plusieurs radicaux R⁸;
R⁸ est pour chaque occurrence, de manière identique ou différente, H, D ou un radical hydrocarbone aliphatique, aromatique et/ou hétéroaromatique qui comporte de 1 à 20 atome(s) de C ; ou un système de cycle aromatique ou hétéroaromatique qui comporte de 5 à 60 atomes de cycle aromatique, lequel peut être substitué par un radical ou par plusieurs radicaux R ; deux substituants R⁸ ou plus peuvent également former un système de cycle aliphatique, aromatique ou hétéroaromatique mono-ou polycyclique l'un avec l'autre ou les uns avec les autres ;
n est pour chaque occurrence, de manière identique ou différente, 0, 1, 2, 3 ou 4 ;
p est pour chaque occurrence, de manière identique ou différente, 0, 1, 2, 3 ou 4 ; et
q est 1, 2, 3, 4 ou 5.

5. Mélange selon une ou plusieurs des revendications 1 à 4, **caractérisé en ce que** la proportion du composé émetteur de triplets dans le mélange est de 0,1 à 40% en poids.

6. Mélange selon une ou plusieurs des revendications 1 à 5, **caractérisé en ce qu'**il comprend un ou plusieurs solvant(s).

7. Utilisation d'un mélange selon une ou plusieurs des revendications 1 à 5 dans un dispositif électroluminescent organique.

8. Dispositif électroluminescent organique comprenant une cathode, une anode et au moins une couche électroluminescente, **caractérisé en ce que** la couche électroluminescente comprend un mélange selon une ou plusieurs des revendications 1 à 5.

9. Dispositif électroluminescent organique selon la revendication 8, **caractérisé en ce que** la couche électroluminescente a été appliquée à partir d'une solution.
